# EUROPEAN PATENT APPLICATION

(11) **EP 2 034 001 A2**
(43) Date of publication of application: **11.03.2009**
(21) Application number: 08163819.9
(22) Date of filing: 05.09.2008
(51) Int. Cl.: C09K 11/06, H05B 33/14, C07F 3/00

(54) **Organometallic compounds for electroluminescence and organic electroluminescent device using the same**

(30) Priority: 07.09.2007 KR 20070091104; 31.12.2007 KR 20070142004; 21.03.2008 KR 20080026187
(71) Applicant: Gracel Display Inc., Seoul 133-833 (KR)
(72) Inventor: Kim, Hyun, Seoul 139-736 (KR); Cho, Young Jun, 136-060 Seoul (KR); Kwon, Hyuck Joo, 130-100 Seoul (KR); Kim, Bong Ok, 135-090 Seoul (KR); Kim, Sung Min, 157-886 Seoul (KR); Yoon, Seung Soo, 135-884 Seoul (KR)
(74) Representative: Buckley, Guy Julian

(57) **Abstract**

The present invention relates to electroluminescent compounds represented by Chemical Formula (1) L⁻L¹M(Q)ₘ and electroluminescent devices comprising the same as host material.
The electroluminescent compound according to the invention, when used as host material of an OLED, noticeably lowers the operation voltage and enhance the power efficiency.

## Description

The present invention relates to electroluminescent compounds comprised of metal complex exhibiting excellent electric conductivity and luminescent properties with high efficiency, and electroluminescent devices comprising the same as host material.

The most important factor to determine luminous efficiency in an OLED is the type of electroluminescent material. Though fluorescent materials have been widely used as electroluminescent material up to the present, development of phosphorescent materials is one of the best methods to improve the luminous efficiency theoretically up to four (4) times, in view of electroluminescent mechanism.

Up to now, iridium (III) complexes are widely known as phosphorescent material, including (acac)Ir(btp)₂, Ir(ppy)₃ and Firpic, as the red, green and blue one, respectively. In particular, a lot of phosphorescent materials have been recently investigated in Japan and Europe and America.

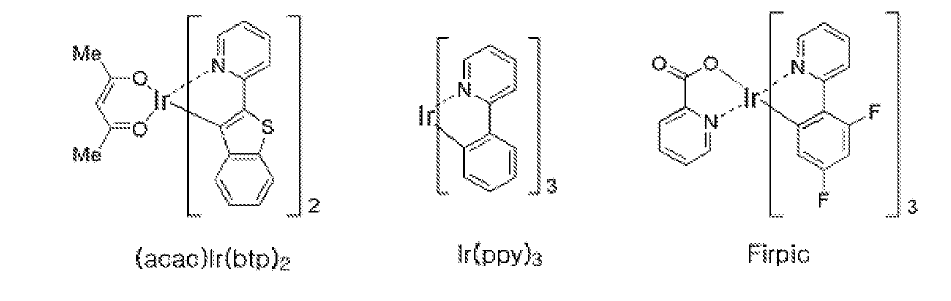

As a host material for phosphorescent light emitting material, CBP is most widely known up to the present, and OLEDs having high efficiency to which a hole blocking layer (such as BCP and BAlq) has been applied have been known. Pioneer (Japan) or the like reported OLEDs having high efficiency using a BAlq derivative as the host.

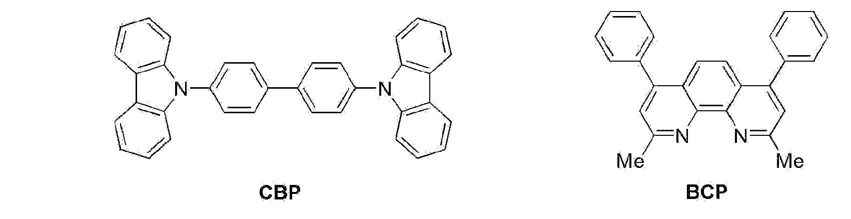

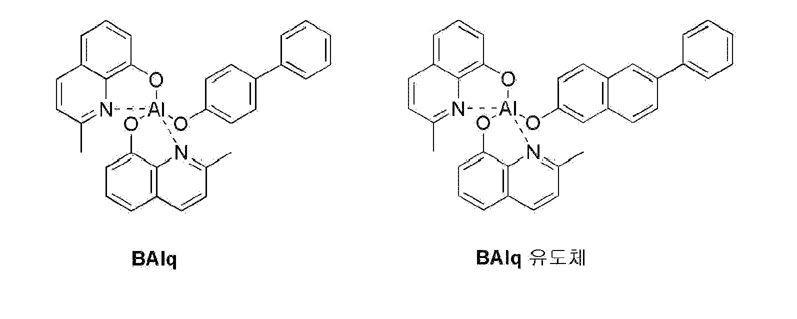

Though the materials in prior art are advantageous in view of light emitting property, they have low glass transition temperature and very poor thermal stability, so that the materials tend to be changed during high temperature vapor-deposition in vacuo. In an organic electroluminescent device (OLED), it is defined that power efficiency = (n/voltage) x current efficiency. Thus, the power efficiency is inversely proportional to the voltage, and the power efficiency should be higher in order to obtain lower power consumption of an OLED. In practice, an OLED employing phosphorescent electroluminescent (EL) material shows significantly higher current efficiency (cd/A) than an OLED employing fluorescent EL material. However, in case that a conventional material such as BAlq and CBP as host material of the phosphorescent EL material is employed, no significant advantage can be obtained in terms of power efficiency (lm/w) because of higher operating voltage as compared to an OLED employing a fluorescent material.

The present inventors invented EL compounds of the structures represented below, including the skeletal of a mixed-type ligand metal complex, which has far better EL properties and physical properties than those of conventional organic host materials or aluminum complexes; and filed as Korean Patent Application No. 2006-7467.

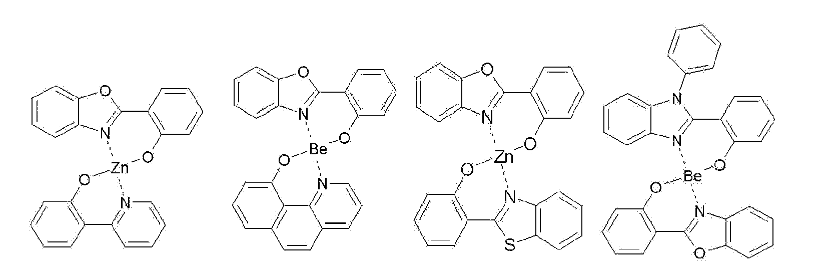

Conventional complexes of this type have been already investigated extensively since the middle of 1990's, as an EL material such as blue EL material. However, those materials have been simply applied as an EL material, with rare examples known to be applied as a host material for a phosphorescent EL material.

In the meanwhile, Japanese Patent Laid-Open No. 2002-305083 measures the device efficiencies with regard to the compounds shown below, wherein the thiazole, benzothiazole and benzene rings are not substituted with any substituent other than hydrogen. There is no disclosure about the compounds having different substituent(s). It is known that Compound B provides power efficiency of 2.6 lm/W at 100 cd/m², luminous efficiency of 5.3 cd/A and operation voltage of 6.5 V, but any case having other substituent(s) on the ligand is not described.

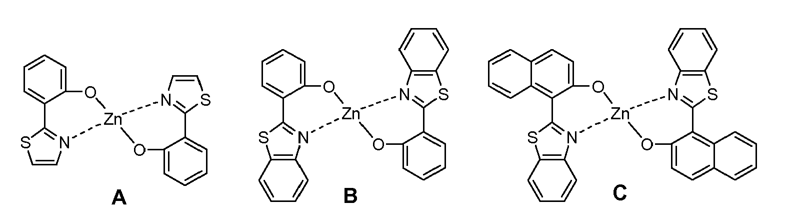

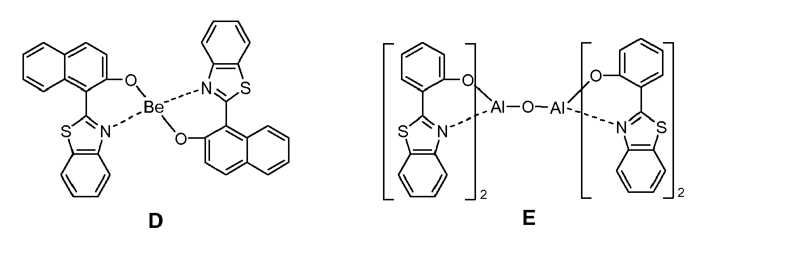

According to the present invention, developed was a metal complex material exhibiting excellent material stability, better electric conductivity and highly efficient EL properties as compared to conventional materials. A heteroatom having unpaired electron pair, included in an aromatic ring or in a side chain substituent, has a high tendency of being coordinated with metal. Such a coordinate bond with very stable electrochemical property is a widely known property of the complex. By means of such a property, the present invention have developed various ligands, and prepared metal complexes, which were then applied as host material. Brief Description of Drawings

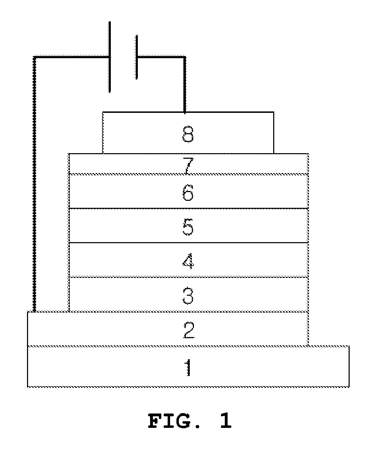

Fig. 1 is a cross-sectional view of an OLED.

The object of the invention is to overcome the problems of conventional techniques as described above and to provide electroluminescent compounds having the skeletal of ligand metal complexes which show highly excellent electroluminescent properties and physical properties as compared to those of conventional organic host materials. Another object of the invention is to provide electroluminescent devices comprising the electroluminescent compound thus prepared as host material.

Thus, the present invention relates to electroluminescent compounds represented by Chemical Formula (1) and electroluminescent devices comprising the same as host material.

Chemical Formula 1 L¹L¹M(Q)ₘ

wherein, ligand L¹ has the structure shown below: 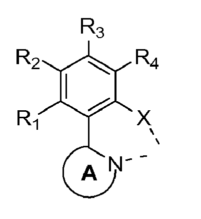
M represents a bivalent or trivalent metal;
m is 0 when M is a bivalent metal, while m is 1 when M is a trivalent metal;
Q represents (C6-C60)aryloxy or tri(C6-C30)arylsilyl, and the aryloxy or triarylsilyl of Q may be further substituted by a linear or branched (C1-C60)alkyl or (C6-C60)aryl;
when X represents O, ring A is selected from the following structures: 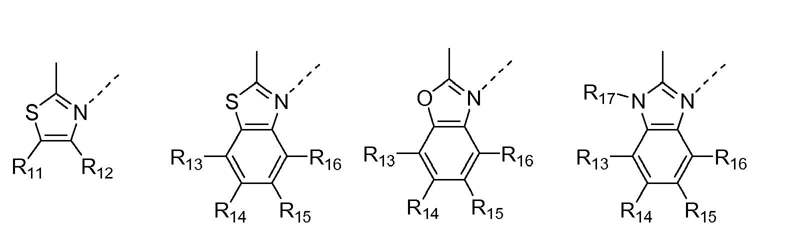
when X represents S, ring A is selected from the following structures: 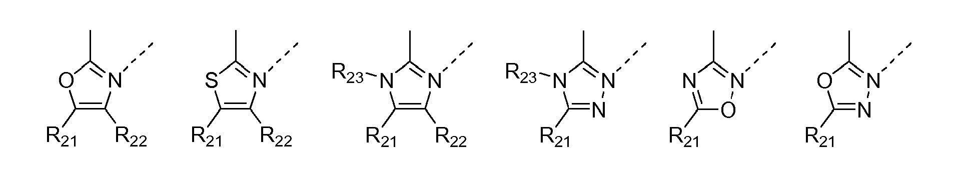 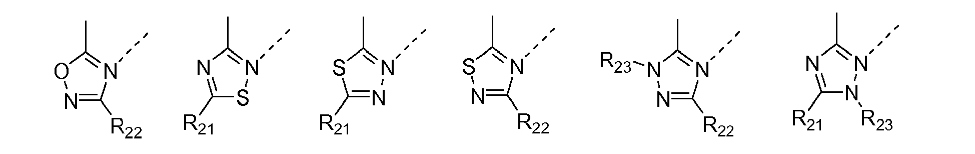 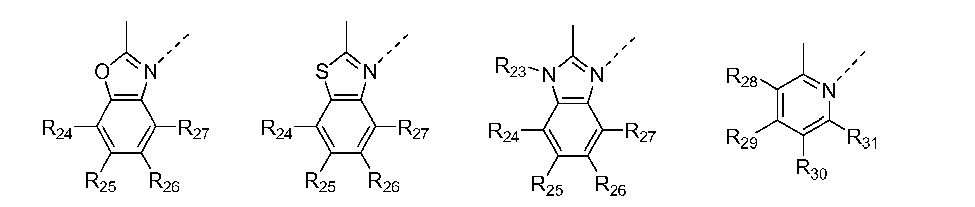 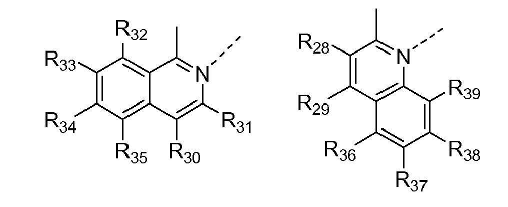
R₁ through R₄ independently represent hydrogen, (C1-C60)alkyl, halogen, cyano, (C3-C60)cycloalkyl, (C6-C60)aryl, (C4-C60)heteroaryl, mono or di(C1-C30)alkylamino, mono or di(C6-C30)arylamino, tri(C1-C30)alkylsilyl, di(C1-C30)alkyl(C6-C30)arylsilyl or tri(C6-C30)arylsilyl, or may be linked to an adjacent substituent via (C3-C12)alkylene or (C3-C12)alkenylene to form a fused ring;
R₁₁ through R₁₇ independently represent hydrogen, (C1-C60)alkyl, (C6-C60)aryl, (C4-C60)heteroaryl, tri(C1-C30)alkylsilyl, di(C1-C30)alkyl(C6-C30)arylsilyl, tri(C6-C30)arylsilyl, mono or di(C1-C30)alkylamino, mono or di(C6-C30)arylamino, cyano or halogen, or R₁₃ through R₁₆ may be linked to an adjacent substituent via (C3-C12)alkylene or (C3-C12)alkenylene to form a fused ring;
R₂₁ through R₃₉ independently represent hydrogen, (C1-C60)alkyl, (C6-C60)aryl, (C4-C60)heteroaryl, tri(C1-C30)alkylsilyl, di(C1-C30)alkyl(C6-C30)arylsilyl, tri(C6-C30)arylsilyl, mono or di(C1-C30)alkylamino, mono or di(C6-C30)arylamino, cyano or halogen;
the alkyl, aryl or heteroaryl of R₁ through R₄, or the fused ring formed therefrom by linkage to an adjacent substituent via (C3-C12)alkylene or (C3-C12)alkenylene may be further substituted by one or more substituent(s) selected from (C1-C60)alkyl, (C1-C60)alkyl substituted by halogen, (C6-C60)aryl, tri(C1-C30)alkylsilyl, di(C1-C30)alkyl(C6-C30)arylsilyl, tri(C6-C30)arylsilyl, mono or di(C1-C30)alkylamino, mono or di(C6-C30)arylamino, cyano and halogen;
the alkyl, aryl or heteroaryl of R₁₁ through R₁₆ and R₂₁ through R₃₉ may be further substituted by one or more substituent(s) selected from (C1-C60)alkyl, (C1-C60)alkyl substituted by halogen, halogen, (C6-C60)aryl, mono or di(C1-C30)alkylamino, mono or di(C6-C30)arylamino, tri(C1-C30)alkylsilyl, di(C1-C30)alkyl(C6-C30)arylsilyl, tri(C6-C30)arylsilyl and cyano.
Ligand L¹ may be selected from the following structures: 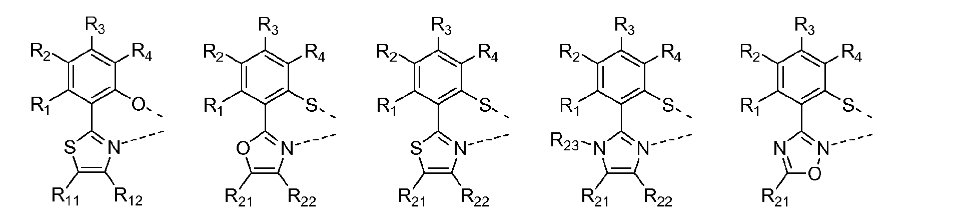 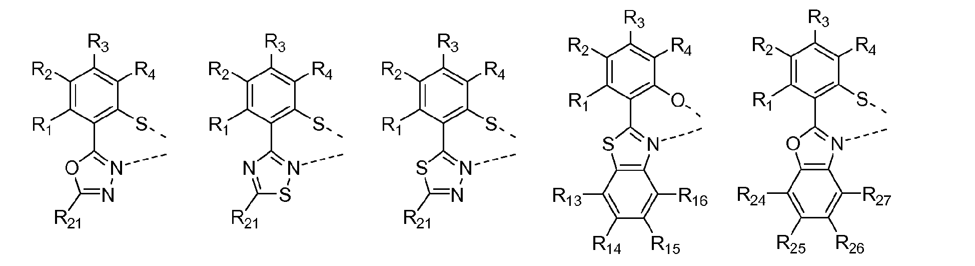 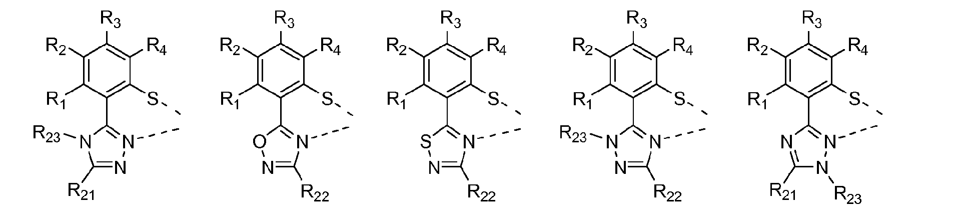 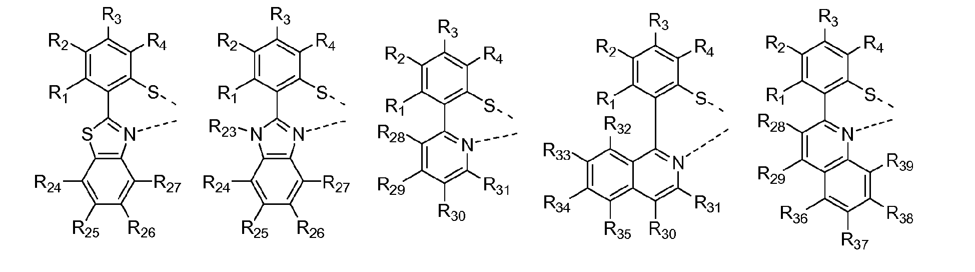 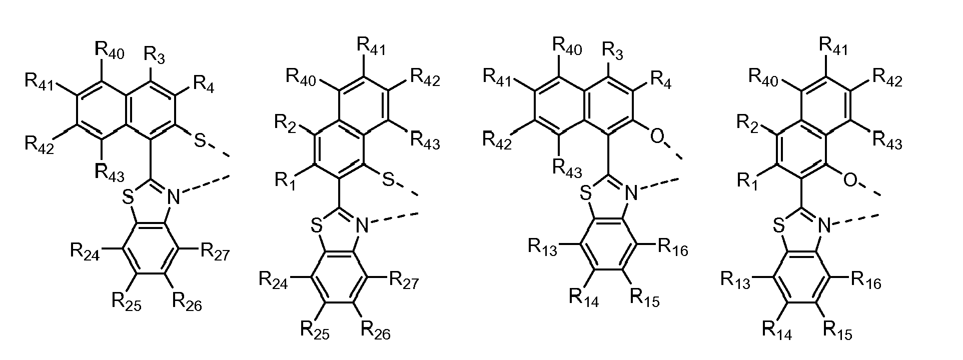 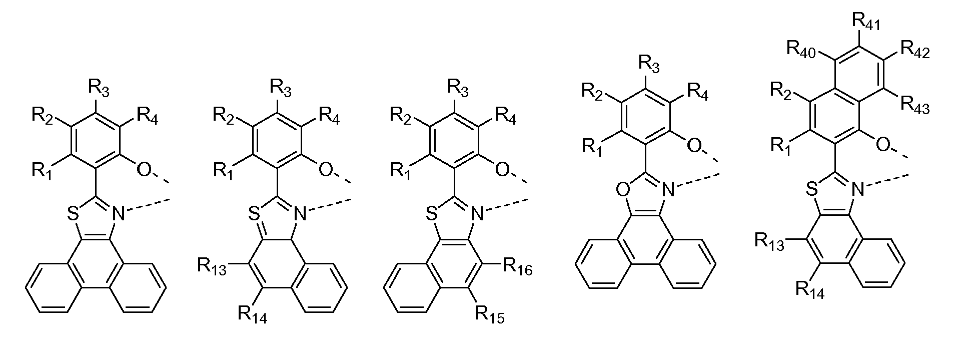 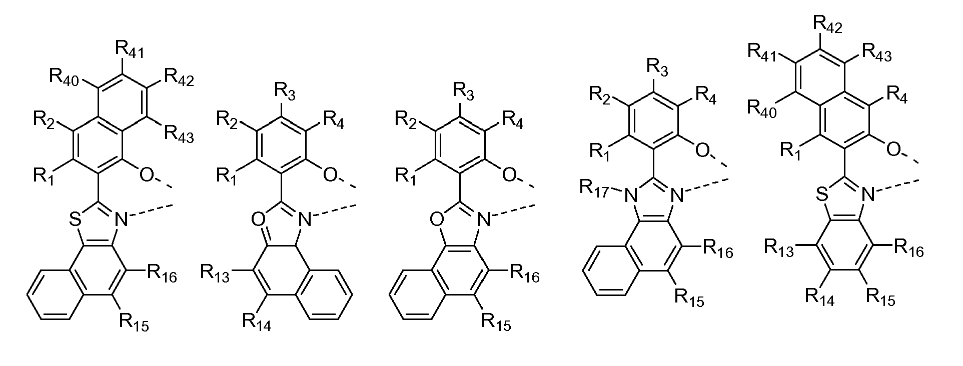 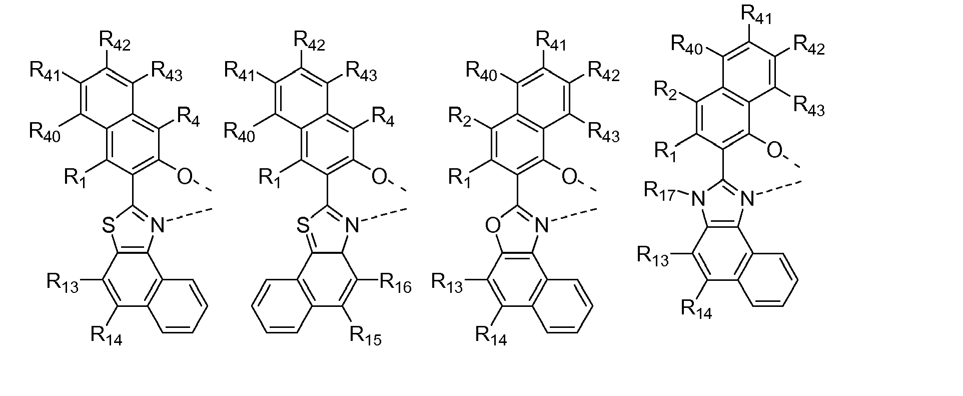
wherein R₁, R₂, R₃ and R₄ are defined as in Chemical Formula 1;
R₁₁ through R₁₆ independently represents hydrogen, (C1-C60)alkyl, halogen, (C1-C60)alkyl substituted by halogen, phenyl, naphthyl, biphenyl, fluorenyl, tri(C1-C30)alkylsilyl, di(C1-C30)alkyl(C6-C30)arylsilyl, tri(C6-C30)arylsilyl, di(C1-C30)alkylamino, di(C6-C30)arylamino, thiophenyl or furanyl;
R₁₇ represents (C1-C60)alkyl, phenyl or naphthyl;
R₂₁ and R₂₂ independently represent hydrogen, (C1-C60)alkyl, halogen, (C1-C60)alkyl substituted by halogen, phenyl, naphthyl, biphenyl, fluorenyl, tri(C1-C30)alkylsilyl, di(C1-C30)alkyl(C6-C30)arylsilyl, tri(C6-C30)arylsilyl, di(C1-C30)alkylamino, di(C6-C30)arylamino, thiophenyl or furanyl;
R₂₃ represents (C1-C60)alkyl, phenyl or naphthyl;
R₂₄ through R₃₉ independently represent hydrogen, (C1-C60)alkyl, halogen, (C1-C60)alkyl substituted by halogen, phenyl, naphthyl, biphenyl, fluorenyl, tri(C1-C30)alkylsilyl, di(C1-C30)alkyl(C6-C30)arylsilyl, tri(C6-C30)arylsilyl, di(C1-C30)alkylamino, di(C6-C30)arylamino, thiophenyl or furanyl;
R₄₀ through R₄₃ independently represent hydrogen, (C1-C60)alkyl, (C1-C60)alkyl substituted by halogen, phenyl, naphthyl, biphenyl, fluorenyl, tri(C1-C30)alkylsilyl, di(C1-C30)alkyl(C6-C30)arylsilyl, tri(C6-C30)arylsilyl, di(C1-C30)alkylamino, di(C6-C30)arylamino or halogen; and
the phenyl, naphthyl, biphenyl, fluorenyl, thiophenyl or furanyl of R₁₁ through R₁₇, R₂₁ through R₃₉ and R₄₀ through R₄₃ may be further substituted by one or more substituent(s) selected from (C1-C60)alkyl, halogen, phenyl, naphthyl, fluorenyl, tri(C1-C30)alkylsilyl, di(C1-C30)alkyl(C6-C30)arylsilyl, tri(C6-C30)arylsilyl, di(C1-C30)alkylamino or di(C6-C30)arylamino.
Ligand L¹ is preferably selected from the following structures: 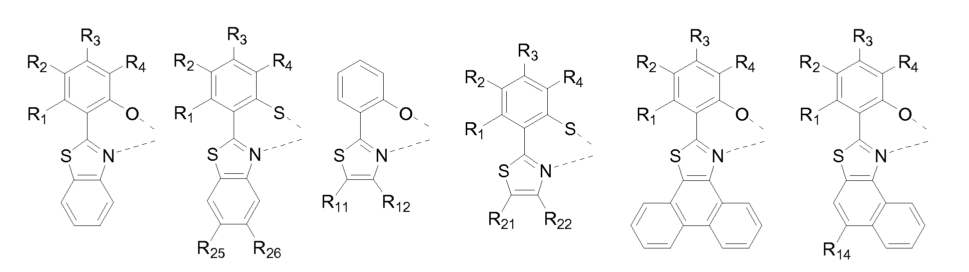 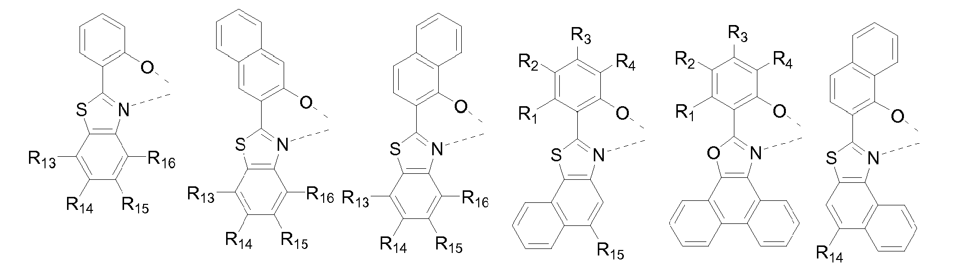 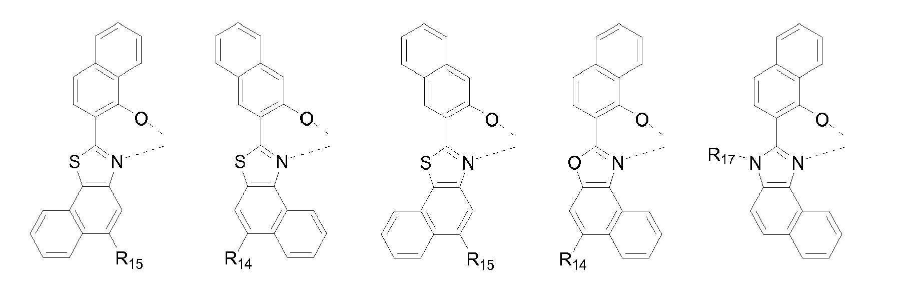
wherein, R₁ through R₄ independently represent hydrogen, methyl, ethyl, n-propyl, i-propyl, n-butyl, i-butyl, t-butyl, chloro, fluoro, phenyl, biphenyl, naphthyl, fluorenyl, thiophenyl, trimethylsilyl, triphenylsilyl, t-butyldimethylsilyl, dimethylamino, diethylamino or diphenylamino, excluding the case wherein R₁, R₂, R₃ and R₄ represent hydrogen all at the same time;
R₁₁ and R₁₂ independently represent methyl, ethyl, n-propyl, i-propyl, n-butyl, i-butyl, t-butyl, trimethylsilyl, triphenylsilyl, phenyl, biphenyl, naphthyl or fluorenyl;
R₁₃ through R₁₆ independently represent methyl, ethyl, n-propyl, i-propyl, n-butyl, i-butyl, t-butyl, trimethylsilyl, triphenylsilyl, phenyl, biphenyl, naphthyl or fluorenyl;
R₁₇ represents methyl, ethyl, n-propyl, i-propyl, n-butyl, i-butyl, t-butyl, phenyl or naphthyl;
R₂₁ and R₂₂ independently represent hydrogen, methyl, ethyl, n-propyl, i-propyl, n-butyl, i-butyl, t-butyl, fluoro, trifluoromethyl, phenyl, naphthyl, biphenyl, trimethylsilyl, triphenylsilyl, dimethylamino, diphenylamino, thiophenyl or furanyl;
R₂₅ and R₂₆ independently represent hydrogen, methyl, ethyl, n-propyl, i-propyl, n-butyl, i-butyl, t-butyl, fluoro, trifluoromethyl, phenyl, naphthyl, biphenyl, trimethylsilyl, triphenylsilyl, dimethylamino, diphenylamino, thiophenyl or furanyl; and
The phenyl, biphenyl, naphthyl, fluorenyl and thiophenyl of R₁, R₂, R₃, R₄, R₁₁, R₁₂, R₁₃, R₁₄, R₁₅, R₁₆, R₁₇, R₂₁, R₂₂, R₂₅ and R₂₆ may be further substituted by one or more substituent(s) selected from fluoro, methyl, ethyl, n-propyl, i-propyl, n-butyl, i-butyl, t-butyl, trimethylsilyl, t-butyldimethylsilyl, phenyl, naphthyl, fluorenyl, dimethylamino, diethylamino and diphenylamino.

In Chemical Formula (1), M is a bivalent metal selected from a group consisting of Be, Zn, Mg, Cu and Ni, or a trivalent metal selected from a group consisting of Al, Ga, In and B, and Q is selected from the following structures:

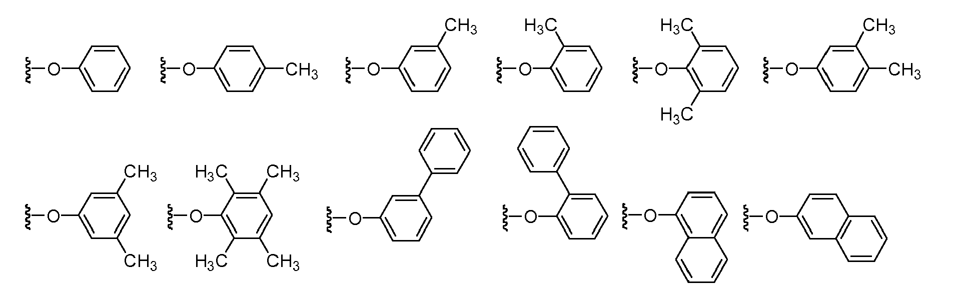

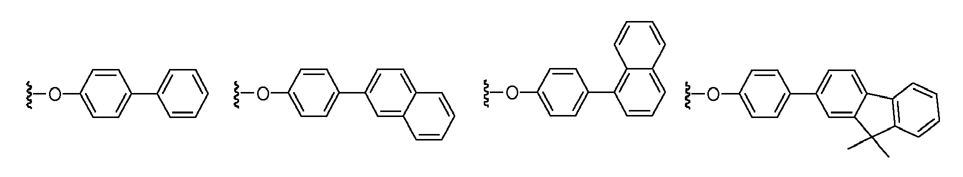

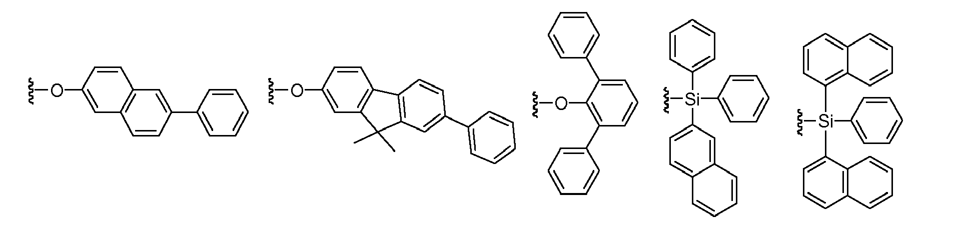

The compounds represented by Chemical Formula (1) are specifically exemplified by the following compounds, but not restricted thereto: 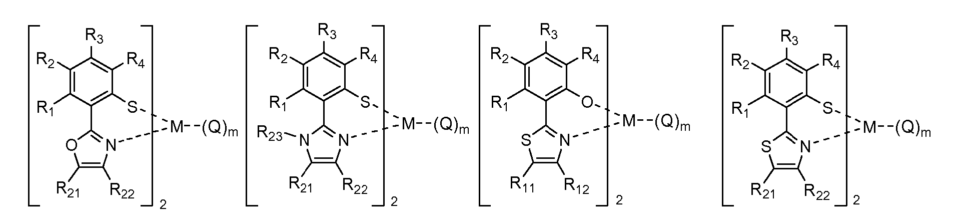 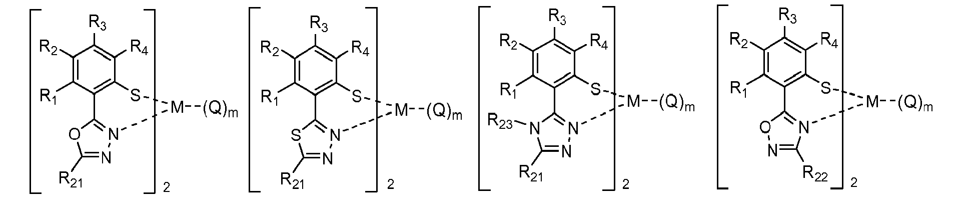 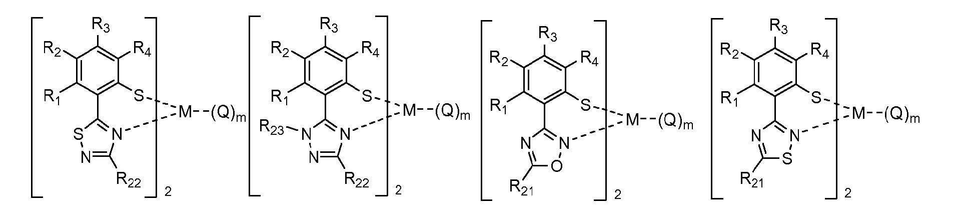 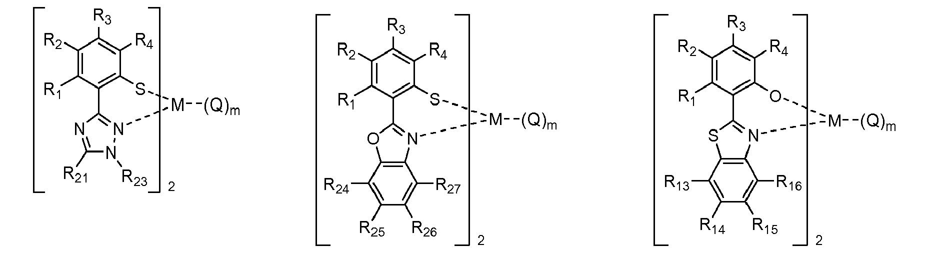 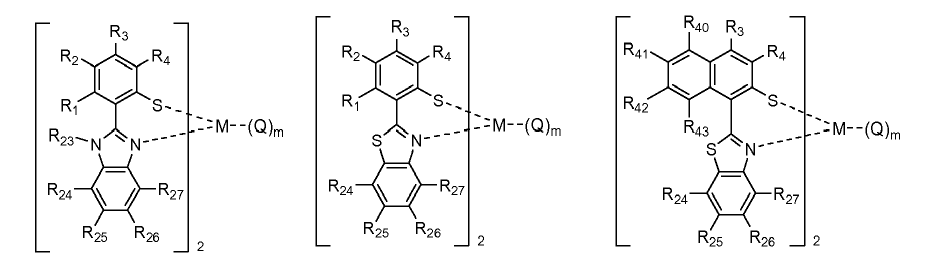 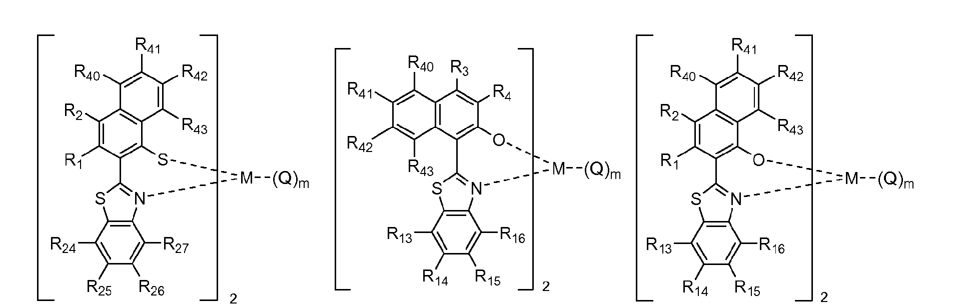 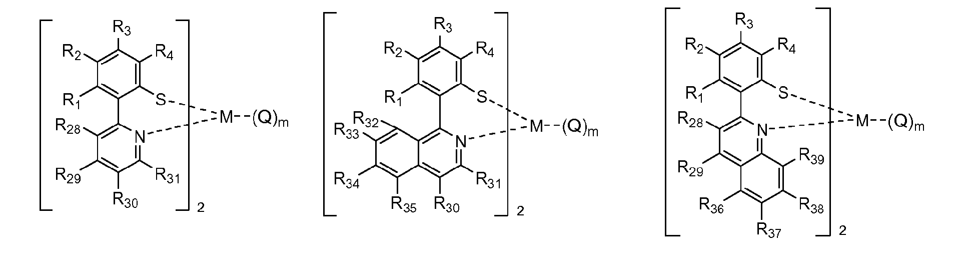 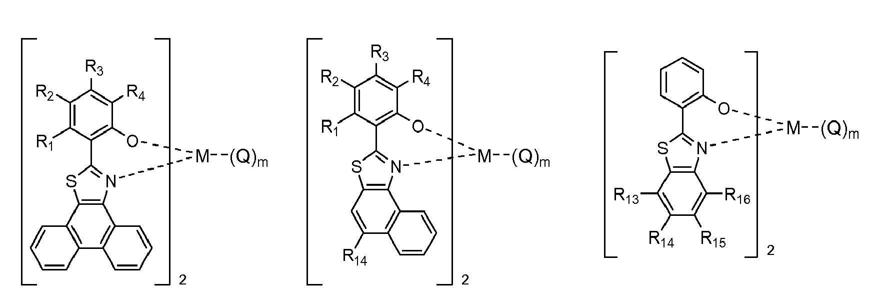 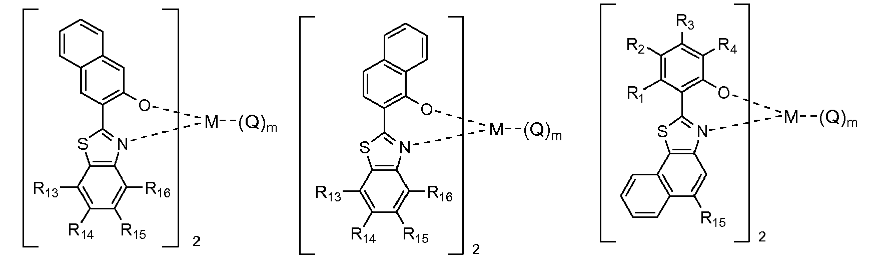 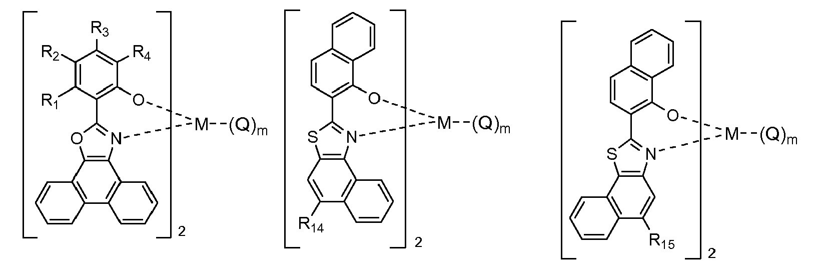 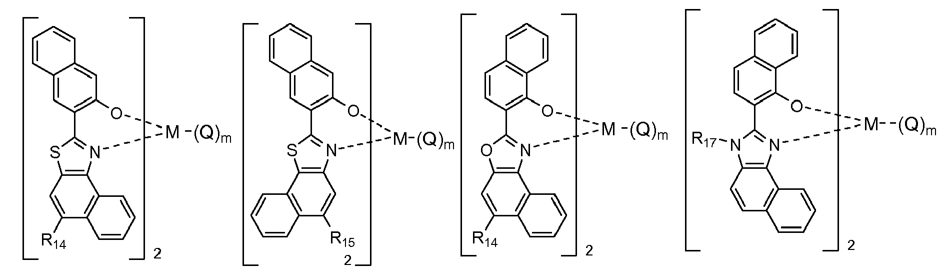
wherein, M represents a bivalent metal selected from Be, Zn, Mg, Cu and Ni, or a trivalent metal selected from Al, Ga, In and B; Q is defined as in Chemical Formula (1); m is 0 when M is a bivalent metal, while m is 1 when M is a trivalent metal;
R₁ through R₄ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, trifluoromethyl, perfluoroethyl, trifluoroethyl, perfluoropropyl, perfluorobutyl, trimethylsilyl, triethylsilyl, tripropylsilyl, tri(t-butyl)silyl, t-butyldimethylsilyl, dimethylphenylsilyl, triphenylsilyl, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, dimethylamino, diethylamino or diphenylamino;
R₁₁ through R₁₇ and R₂₁ through R₃₉ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, trifluoromethyl, perfluoroethyl, trifluoroethyl, perfluoropropyl, perfluorobutyl, trimethylsilyl, triethylsilyl, tripropylsilyl, tri(t-butyl)silyl, t-butyldimethylsilyl, dimethylphenylsilyl, triphenylsilyl, phenyl, biphenyl, naphthyl, fluorenyl, thiophenyl, furanyl, dimethylamino, diethylamino or diphenylamino;
R₄₀ through R₄₃ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, trifluoromethyl, perfluoroethyl, trifluoroethyl, perfluoropropyl, perfluorobutyl, trimethylsilyl, triethylsilyl, tripropylsilyl, tri(t-butyl)silyl, t-butyldimethylsilyl, dimethylphenylsilyl, triphenylsilyl, phenyl, biphenyl, naphthyl, fluorenyl, dimethylamino, diethylamino or diphenylamino; and
the phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl or benzoxazolyl of R₁ through R₄, R₁₁ through R₁₇, R₂₁ through R₃₉ and R₄₀ through R₄₃ may be further substituted by one or more substituent(s) selected from methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, cyano, trifluoromethyl, perfluoroethyl, trifluoroethyl, perfluoropropyl, perfluorobutyl, phenyl, biphenyl, naphthyl, fluorenyl, trimethylsilyl, triethylsilyl, tripropylsilyl, tri(t-butyl)silyl, t-butyldimethylsilyl, dimethylphenylsilyl, triphenylsilyl, dimethylamino, diethylamino and diphenylamino.

The electroluminescent compounds according to the present invention can be specifically exemplified by the compounds listed in Tables 1 to 3, but they are not critically restricted thereto. The compounds listed in Tables 1 and 3 are compounds wherein M is a bivalent metal, while those in Table 2 are compounds wherein M is a trivalent metal.

**Table 1**

| L¹L¹M | | | | | | | |
|---|---|---|---|---|---|---|---|
| L₁ = | | | | | | | M |
| Compound No. | R₁ | R₂ | R₃ | R₄ | | X | |
| **1** | H | | H | H | 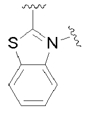 | O | Zn |
| **2** | | H | H | H | 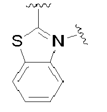 | O | Zn |
| **3** | H | H | | H | 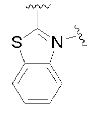 | O | Zn |
| **4** | H | H | H | | 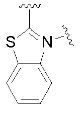 | O | Zn |
| **5** | H | 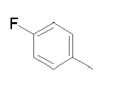 | H | H | 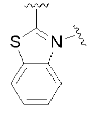 | O | Zn |
| **6** | H | H | 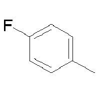 | H | 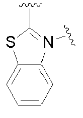 | O | Zn |
| **7** | H | H | H | 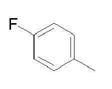 | 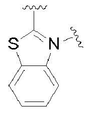 | O | Zn |
| **8** | 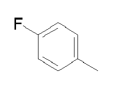 | H | H | H | 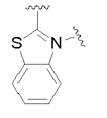 | O | Zn |
| **9** | H | 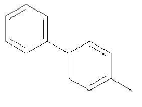 | H | H | 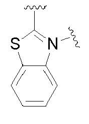 | O | Zn |
| **10** | 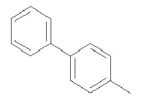 | H | H | H | 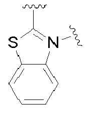 | O | Zn |
| **11** | H | H | 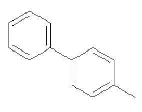 | H | 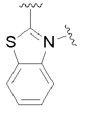 | O | Zn |
| **12** | H | H | H | 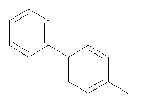 | 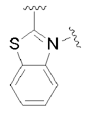 | O | Zn |
| **13** | H | H | 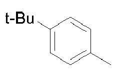 | H | 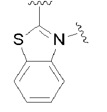 | O | Zn |
| **14** | H | 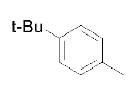 | H | H | 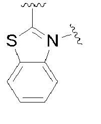 | O | Zn |
| **15** | H | H | 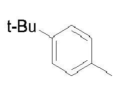 | H | 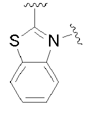 | O | Zn |
| **16** | 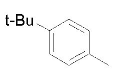 | H | H | H | 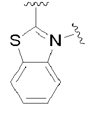 | O | Zn |
| **17** | H | H | 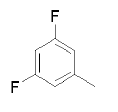 | H | 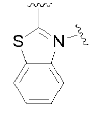 | O | Zn |
| **18** | H | 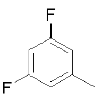 | H | H | 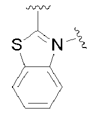 | O | Zn |
| **19** | H | H | H | 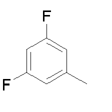 | 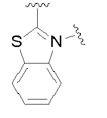 | O | Zn |
| **20** | 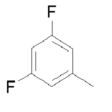 | H | H | H | 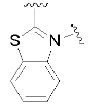 | O | Zn |
| **21** | H | 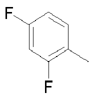 | H | H | 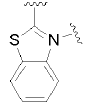 | O | Zn |
| **22** | H | H | H | 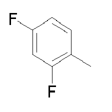 | 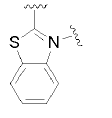 | O | Zn |
| **23** | H | H | 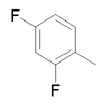 | H | 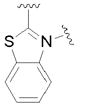 | O | Zn |
| **24** | 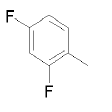 | H | H | H | 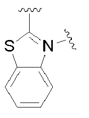 | O | Zn |
| **25** | 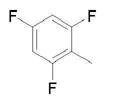 | H | H | H | 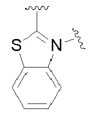 | O | Zn |
| **26** | H | 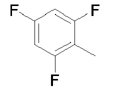 | H | H | 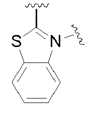 | O | Zn |
| **27** | H | H | H | 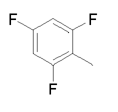 | 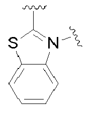 | O | Zn |
| **28** | H | H | 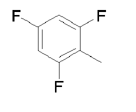 | H | 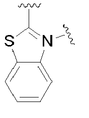 | O | Zn |
| **29** | 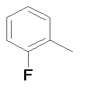 | H | H | H | 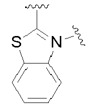 | O | Zn |
| **30** | H | 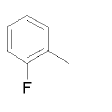 | H | H | 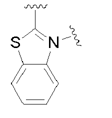 | O | Zn |
| **31** | H | H | 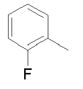 | H | 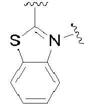 | O | Zn |
| **32** | H | H | H | 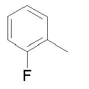 | 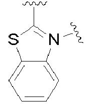 | O | Zn |
| **33** | H | 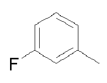 | H | H | 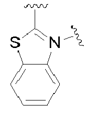 | O | Zn |
| **34** | H | H | 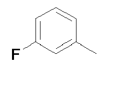 | H | 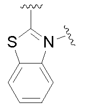 | O | Zn |
| **35** | H | H | H | 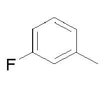 | 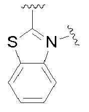 | O | Zn |
| **36** | 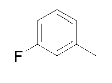 | H | H | H | 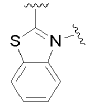 | O | Zn |
| **37** | H | 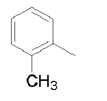 | H | H | 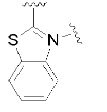 | O | Zn |
| **38** | H | H | 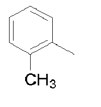 | H | 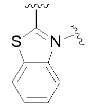 | O | Zn |
| **39** | 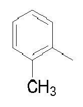 | H | H | H | 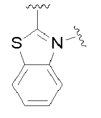 | O | Zn |
| **40** | H | H | H | 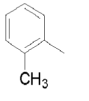 | 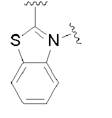 | O | Zn |
| **41** | H | 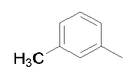 | H | H | 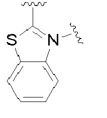 | O | Zn |
| **42** | H | H | 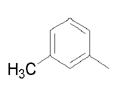 | H | 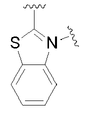 | O | Zn |
| **43** | H | H | H | 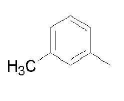 | 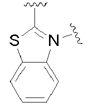 | O | Zn |
| **44** | 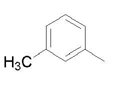 | H | H | H | 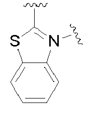 | O | Zn |
| **45** | 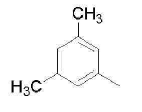 | H | H | H | 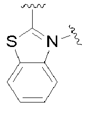 | O | Zn |
| **46** | H | 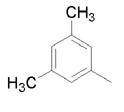 | H | H | 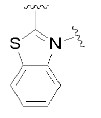 | O | Zn |
| **47** | H | H | 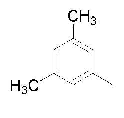 | H | 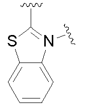 | O | Zn |
| **48** | H | H | H | 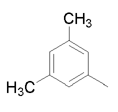 | 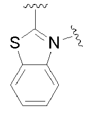 | O | Zn |
| **49** | H | 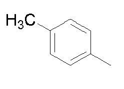 | H | H | 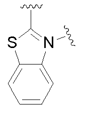 | O | Zn |
| **50** | H | H | 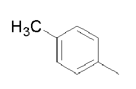 | H | 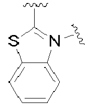 | O | Zn |
| **51** | 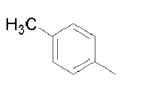 | H | H | H | 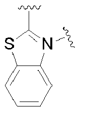 | O | Zn |
| **52** | H | H | H | 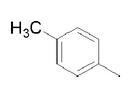 | 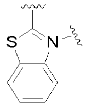 | O | Zn |
| **53** | H | H | 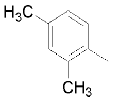 | H | 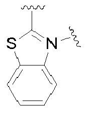 | O | Zn |
| **54** | H | 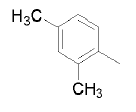 | H | H | 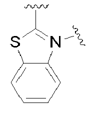 | O | Zn |
| **55** | 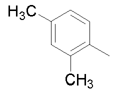 | H | H | H | 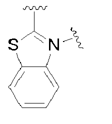 | O | Zn |
| **56** | H | H | H | 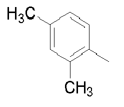 | 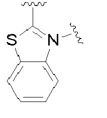 | O | Zn |
| **57** | H | 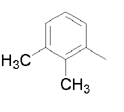 | H | H | 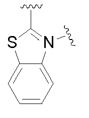 | O | Zn |
| **58** | H | H | 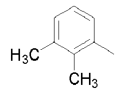 | H | 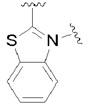 | O | Zn |
| **59** | 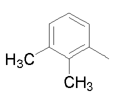 | H | H | H | 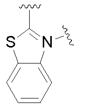 | O | Zn |
| **60** | H | H | H | 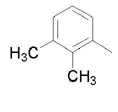 | 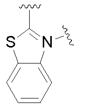 | O | Zn |
| **61** | 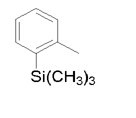 | H | H | H | 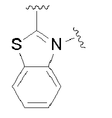 | O | Zn |
| **62** | H | H | 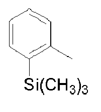 | H | 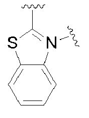 | O | Zn |
| **63** | H | 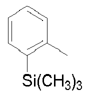 | H | H | 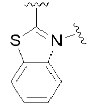 | O | Zn |
| **64** | H | H | H | 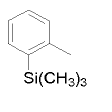 | 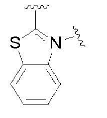 | O | Zn |
| **65** | H | 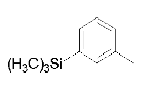 | H | H | 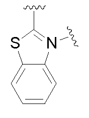 | O | Zn |
| **66** | H | H | 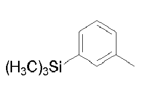 | H | 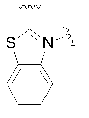 | O | Zn |
| **67** | H | H | H | 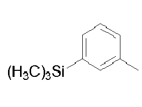 | 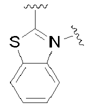 | O | Zn |
| **68** | 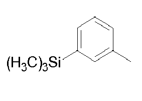 | H | H | H | 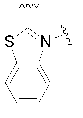 | O | Zn |
| **69** | H | 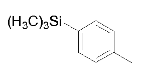 | H | H | 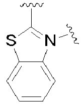 | O | Zn |
| **70** | 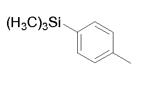 | H | H | H | 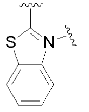 | O | Zn |
| **71** | H | H | 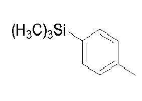 | H | 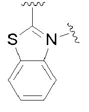 | O | Zn |
| **72** | H | H | H | 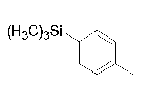 | 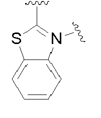 | O | Zn |
| **73** | H | H | 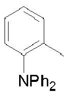 | H | 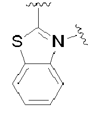 | O | Zn |
| **74** | H | 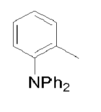 | H | H | 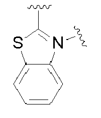 | O | Zn |
| **75** | H | H | H | 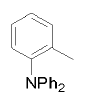 | 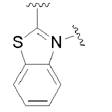 | O | Zn |
| **76** | 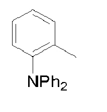 | H | H | H | 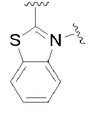 | O | Zn |
| **77** | 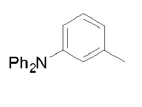 | H | H | H | 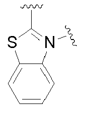 | O | Zn |
| **78** | H | 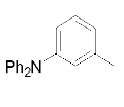 | H | H | 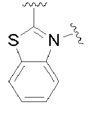 | O | Zn |
| **79** | H | H | 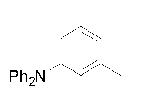 | H | 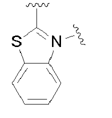 | O | Zn |
| **80** | H | H | H | 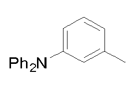 | 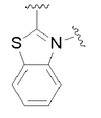 | O | Zn |
| **81** | H | H | 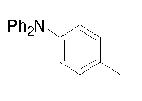 | H | 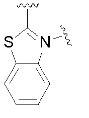 | O | Zn |
| **82** | H | 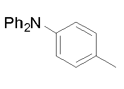 | H | H | 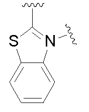 | O | Zn |
| **83** | H | H | H | 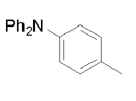 | 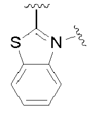 | O | Zn |
| **84** | 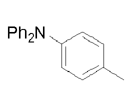 | H | H | H | 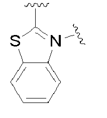 | O | Zn |
| **85** | H | 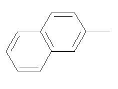 | H | H | 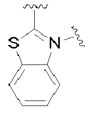 | O | Zn |
| **86** | H | H | 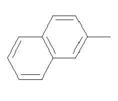 | H | 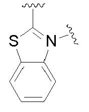 | O | Zn |
| **87** | 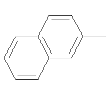 | H | H | H | 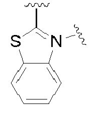 | O | Zn |
| **88** | H | H | H | 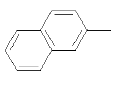 | 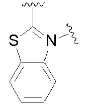 | O | Zn |
| **89** | H | H | 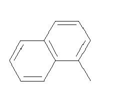 | H | 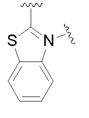 | O | Zn |
| **90** | H | H | H | 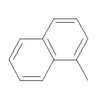 | 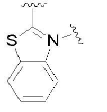 | O | Zn |
| **91** | H | 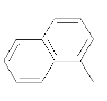 | H | H | 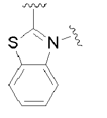 | O | Zn |
| **92** | 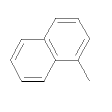 | H | H | H | 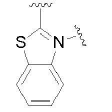 | O | Zn |
| **93** | H | 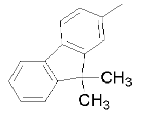 | H | H | 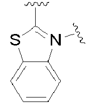 | O | Zn |
| **94** | H | H | 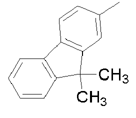 | H | 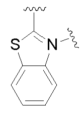 | O | Zn |
| **95** | 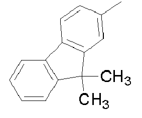 | H | H | H | 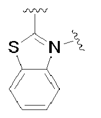 | O | Zn |
| **96** | H | H | H | 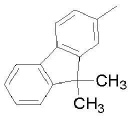 | 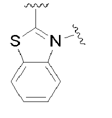 | O | Zn |
| **97** | H | 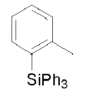 | H | H | 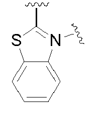 | O | Zn |
| **98** | H | H | 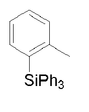 | H | 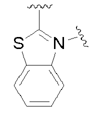 | O | Zn |
| **99** | 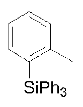 | H | H | H | 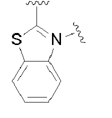 | O | Zn |
| **100** | H | H | H | 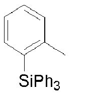 | 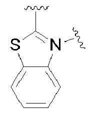 | O | Zn |
| **101** | H | H | 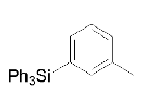 | H | 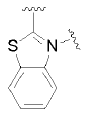 | O | Zn |
| **102** | H | H | H | 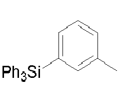 | 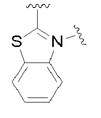 | O | Zn |
| **103** | H | 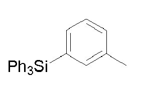 | H | H | 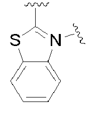 | O | Zn |
| **104** | 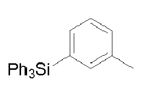 | H | H | H | 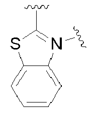 | O | Zn |
| **105** | 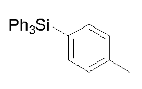 | H | H | H | 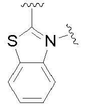 | O | Zn |
| **106** | H | 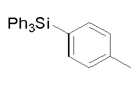 | H | H | 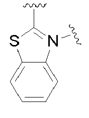 | O | Zn |
| **107** | H | H | 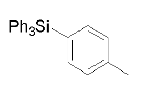 | H | 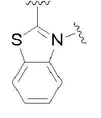 | O | Zn |
| **108** | H | H | H | 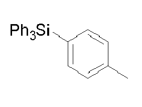 | 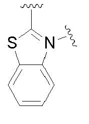 | O | Zn |
| **109** | H | H | -CH₃ | H | 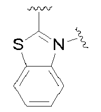 | O | Zn |
| **110** | H | -CH₃ | H | H | 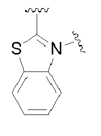 | O | Zn |
| **111** | H | H | H | -CH₃ | 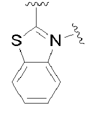 | O | Zn |
| **112** | -CH₃ | H | H | H | 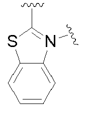 | O | Zn |
| **113** | H | -CH₃ | H | -CH₃ | 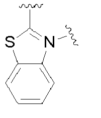 | O | Zn |
| **114** | -CH₃ | H | -CH₃ | H | 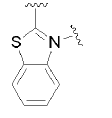 | O | Zn |
| **115** | H | -CH₃ | -CH₃ | H | 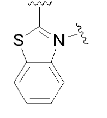 | O | Zn |
| **116** | H | H | -CH₃ | -CH₃ | 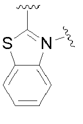 | O | Zn |
| **117** | -CH₃ | -CH₃ | H | H | 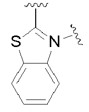 | O | Zn |
| **118** | -CH₃ | H | H | -CH₃ | 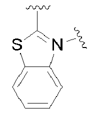 | O | Zn |
| **119** | -C(CH₃)₃ | H | H | H | 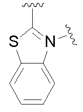 | O | Zn |
| **120** | H | -C(CH₃)₃ | H | H | 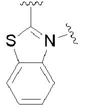 | O | Zn |
| **121** | H | H | -C(CH₃)₃ | H | 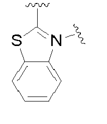 | O | Zn |
| **122** | H | H | H | -C(CH₃)₃ | 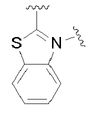 | O | Zn |
| **123** | 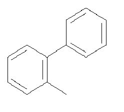 | H | H | H | 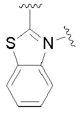 | O | Zn |
| **124** | H | H | 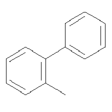 | H | 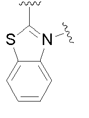 | O | Zn |
| **125** | H | H | H | 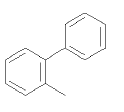 | 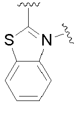 | O | Zn |
| **126** | H | 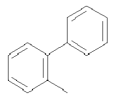 | H | H | 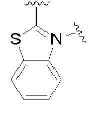 | O | Zn |
| **127** | H | -C(CH₃)₃ | H | -CH₃ | 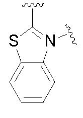 | O | Zn |
| **128** | H | -CH₃ | H | -C(CH₃)₃ | 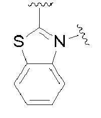 | O | Zn |
| **129** | H | 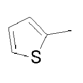 | H | H | 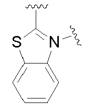 | O | Zn |
| **130** | H | H | 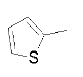 | H | 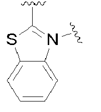 | O | Zn |
| **131** | H | 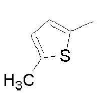 | H | H | 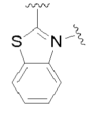 | O | Zn |
| **132** | H | H | 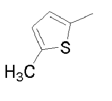 | H | 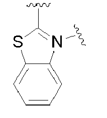 | O | Zn |
| **133** | H | | H | -CH₃ | 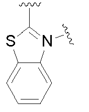 | O | Zn |
| **134** | H | -CH₃ | H | | 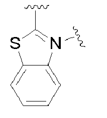 | O | Zn |
| **135** | 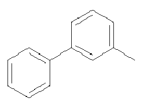 | H | H | H | 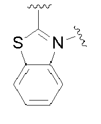 | O | Zn |
| **136** | H | 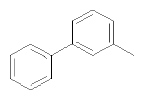 | H | H | 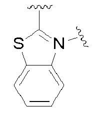 | O | Zn |
| **137** | H | H | 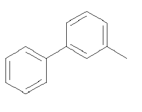 | H | 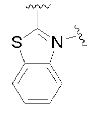 | O | Zn |
| **138** | H | H | H | 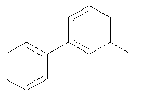 | 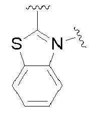 | O | Zn |
| **139** | H | H | 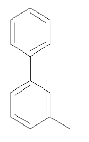 | H | 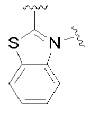 | O | Zn |
| **140** | H | 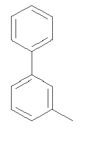 | H | H | 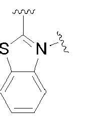 | O | Zn |
| **141** | H | H | H | 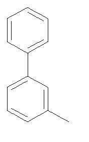 | 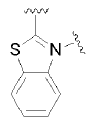 | O | Zn |
| **142** | 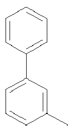 | H | H | H | 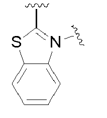 | O | Zn |
| **143** | H | H | H | H | 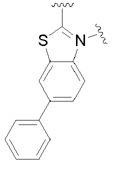 | O | Zn |
| **144** | H | H | H | H | 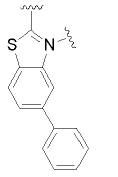 | O | Zn |
| **145** | H | H | H | H | 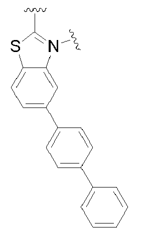 | O | Zn |
| **146** | H | H | H | H | 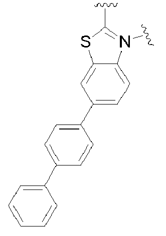 | O | Zn |
| **147** | H | H | H | H | 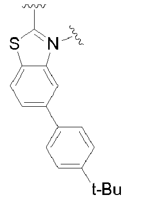 | O | Zn |
| **148** | H | H | H | H | 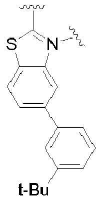 | O | Zn |
| **149** | H | H | H | H | 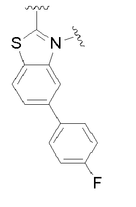 | O | Zn |
| **150** | H | H | H | H | 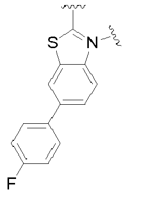 | O | Zn |
| **151** | H | H | H | H | 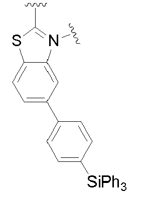 | O | Zn |
| **152** | H | H | H | H | 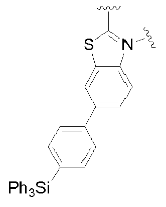 | O | Zn |
| **153** | H | H | H | H | 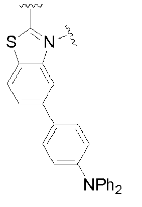 | O | Zn |
| **154** | H | H | H | H | 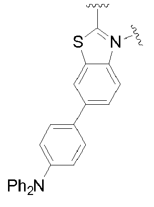 | O | Zn |
| **155** | H | H | H | H | 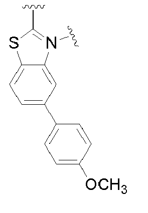 | O | Zn |
| **156** | H | H | H | H | 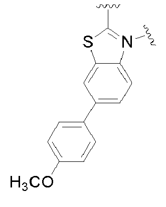 | O | Zn |
| **157** | H | H | H | H | 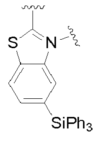 | O | Zn |
| **158** | H | H | H | H | 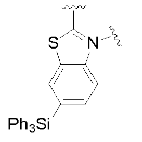 | O | Zn |
| **159** | H | H | H | H | 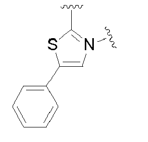 | O | Zn |
| **160** | H | | H | H | 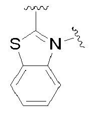 | S | Zn |
| **161** | | H | H | H | 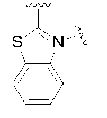 | S | Zn |
| **162** | H | H | | H | 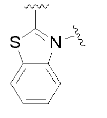 | S | Zn |
| **163** | H | H | H | | 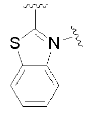 | S | Zn |
| **164** | H | 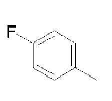 | H | H | 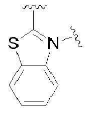 | S | Zn |
| **165** | H | H | 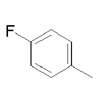 | H | 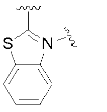 | S | Zn |
| **166** | H | H | H | 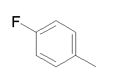 | 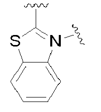 | S | Zn |
| **167** | 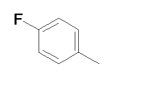 | H | H | H | 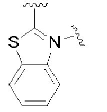 | S | Zn |
| **168** | H | 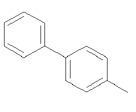 | H | H | 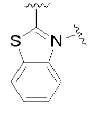 | S | Zn |
| **169** | 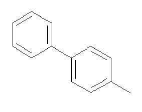 | H | H | H | 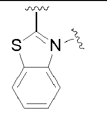 | S | Zn |
| **170** | H | H | 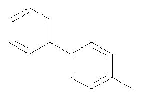 | H | 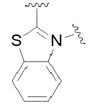 | S | Zn |
| **171** | H | H | H | 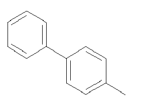 | 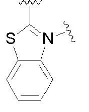 | S | Zn |
| **172** | H | H | 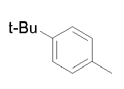 | H | 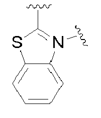 | S | Zn |
| **173** | H | 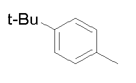 | H | H | 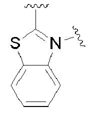 | S | Zn |
| **174** | H | H | 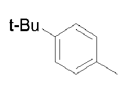 | H | 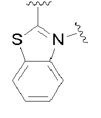 | S | Zn |
| **175** | 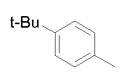 | H | H | H | 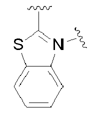 | S | Zn |
| **176** | H | H | 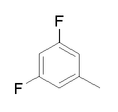 | H | 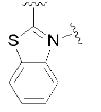 | S | Zn |
| **177** | H | 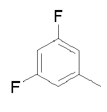 | H | H | 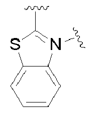 | S | Zn |
| **178** | H | H | H | 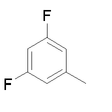 | 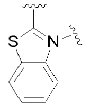 | S | Zn |
| **179** | 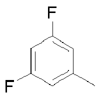 | H | H | H | 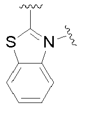 | S | Zn |
| **180** | H | 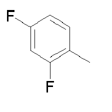 | H | H | 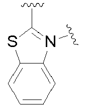 | S | Zn |
| **181** | H | H | H | 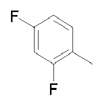 | 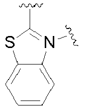 | S | Zn |
| **182** | H | H | 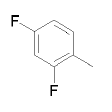 | H | 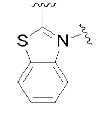 | S | Zn |
| **183** | 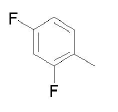 | H | H | H | 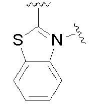 | S | Zn |
| **184** | 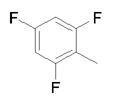 | H | H | H | 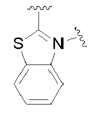 | S | Zn |
| **185** | H | 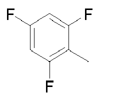 | H | H | 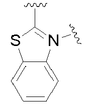 | S | Zn |
| **186** | H | H | H | 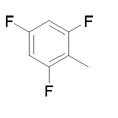 | 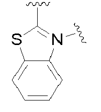 | S | Zn |
| **187** | H | H | 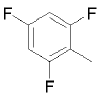 | H | 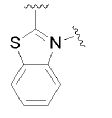 | S | Zn |
| **188** | 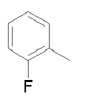 | H | H | H | 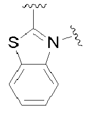 | S | Zn |
| **189** | H | 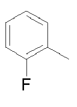 | H | H | 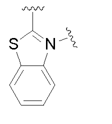 | S | Zn |
| **190** | H | H | 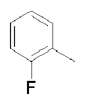 | H | 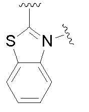 | S | Zn |
| **191** | H | H | H | 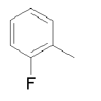 | 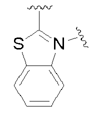 | S | Zn |
| **192** | H | 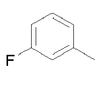 | H | H | 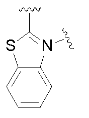 | S | Zn |
| **193** | H | H | 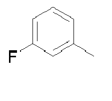 | H | 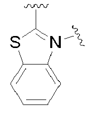 | S | Zn |
| **194** | H | H | H | 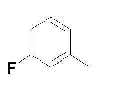 | 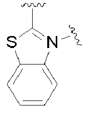 | S | Zn |
| **195** | 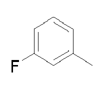 | H | H | H | 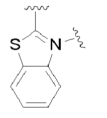 | S | Zn |
| **196** | H | 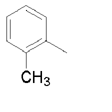 | H | H | 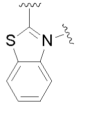 | S | Zn |
| **197** | H | I H | 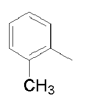 | H | 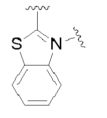 | S | Zn |
| **198** | 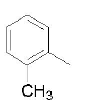 | H | H | H | 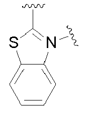 | S | Zn |
| **199** | H | H | H | 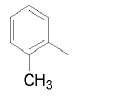 | 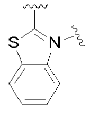 | S | Zn |
| **200** | H | 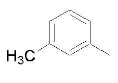 | H | H | 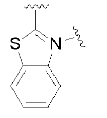 | S | Zn |
| **201** | H | H | 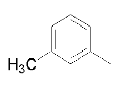 | H | 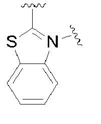 | S | Zn |
| **202** | H | H | H | 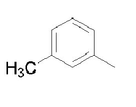 | 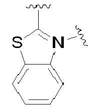 | S | Zn |
| **203** | 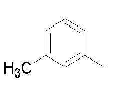 | H | H | H | 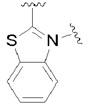 | S | Zn |
| **204** | 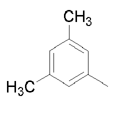 | H | H | H | 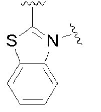 | S | Zn |
| **205** | H | 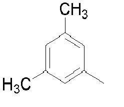 | H | H | 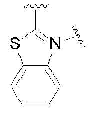 | S | Zn |
| **206** | H | H | 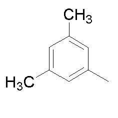 | H | 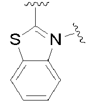 | S | Zn |
| **207** | H | H | H | 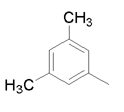 | 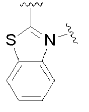 | S | Zn |
| **208** | H | 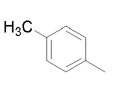 | H | H | 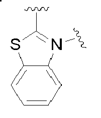 | S | Zn |
| **209** | H | H | 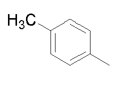 | H | 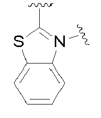 | S | Zn |
| **210** | 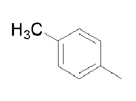 | H | H | H | 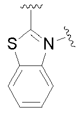 | S | Zn |
| **211** | H | H | H | 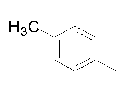 | 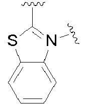 | S | Zn |
| **212** | H | H | 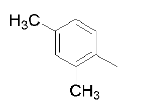 | H | 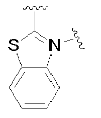 | S | Zn |
| **213** | H | 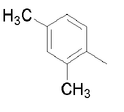 | H | H | 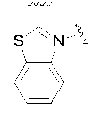 | S | Zn |
| **214** | 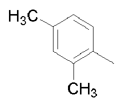 | H | H | H | 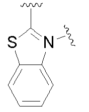 | S | Zn |
| **215** | H | H | H | 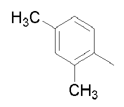 | 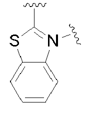 | S | Zn |
| **216** | H | 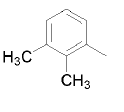 | H | H | 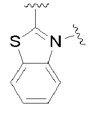 | S | Zn |
| **217** | H | H | 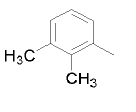 | H | 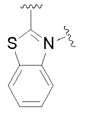 | S | Zn |
| **218** | 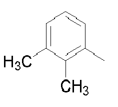 | H | H | H | 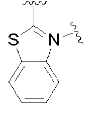 | S | Zn |
| **219** | H | H | H | 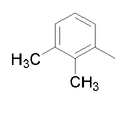 | 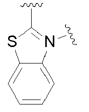 | S | Zn |
| **220** | 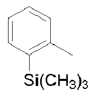 | H | H | H | 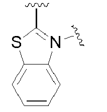 | S | Zn |
| **221** | H | H | 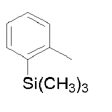 | H | 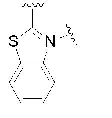 | S | Zn |
| **222** | H | 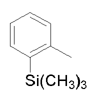 | H | H | 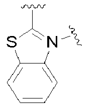 | S | Zn |
| **223** | H | H | H | 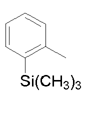 | 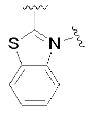 | S | Zn |
| **224** | H | 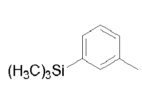 | H | H | 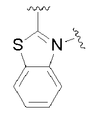 | S | Zn |
| **225** | H | H | 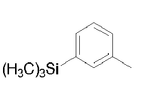 | H | 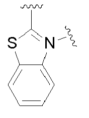 | S | Zn |
| **226** | H | H | H | 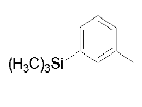 | 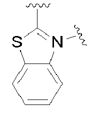 | S | Zn |
| **227** | 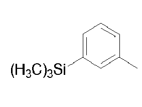 | H | H | H | 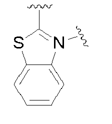 | S | Zn |
| **228** | H | 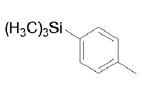 | H | H | 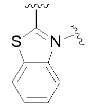 | S | Zn |
| **229** | 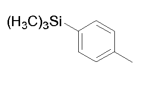 | H | H | H | 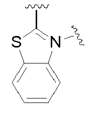 | S | Zn |
| **230** | H | H | 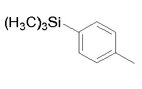 | H | 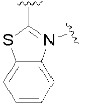 | S | Zn |
| **231** | H | H | H | 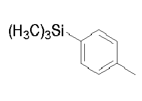 | 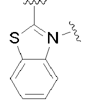 | S | Zn |
| **232** | H | H | 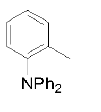 | H | 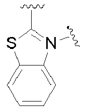 | S | Zn |
| **233** | H | 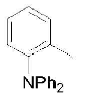 | H | H | 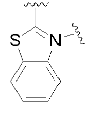 | S | Zn |
| **234** | H | H | H | 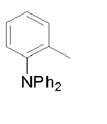 | 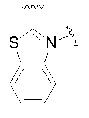 | S | Zn |
| **235** | 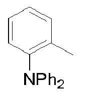 | H | H | H | 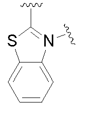 | S | Zn |
| **236** | 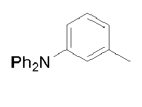 | H | H | H | 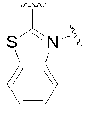 | S | Zn |
| **237** | H | 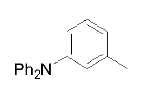 | H | H | 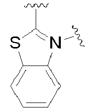 | S | Zn |
| **238** | H | H | 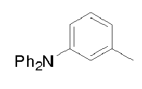 | H | 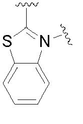 | S | Zn |
| **239** | H | H | H | 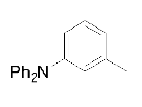 | 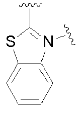 | S | Zn |
| **240** | H | H | 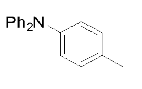 | H | 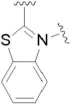 | S | Zn |
| **241** | H | 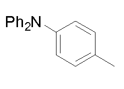 | H | H | 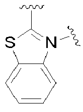 | S | Zn |
| **242** | H | H | H | 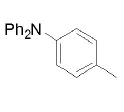 | 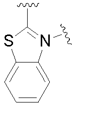 | S | Zn |
| **243** | 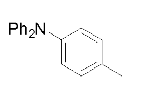 | H | H | H | 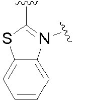 | S | Zn |
| **244** | H | 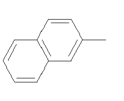 | H | H | 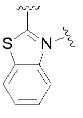 | S | Zn |
| **245** | H | H | 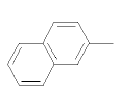 | H | 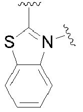 | S | Zn |
| **246** | 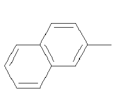 | H | H | H | 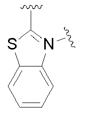 | S | Zn |
| **247** | H | H | H | 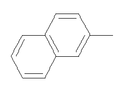 | 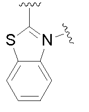 | S | Zn |
| **248** | H | H | 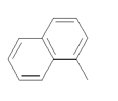 | H | 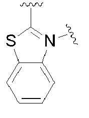 | S | Zn |
| **249** | H | H | H | 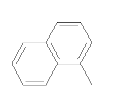 | 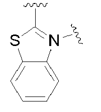 | S | Zn |
| **250** | H | 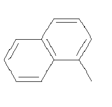 | H | H | 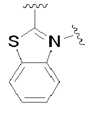 | S | Zn |
| **251** | 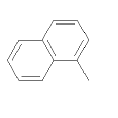 | H | H | H | 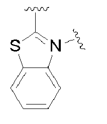 | S | Zn |
| **252** | H | 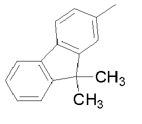 | H | H | 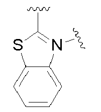 | S | Zn |
| **253** | H | H | 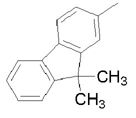 | H | 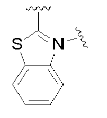 | S | Zn |
| **254** | 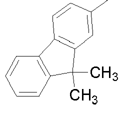 | H | H | H | 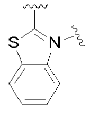 | S | Zn |
| **255** | H | H | H | 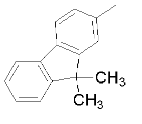 | 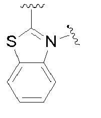 | S | Zn |
| **256** | H | 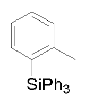 | H | H | 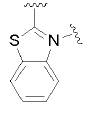 | S | Zn |
| **257** | H | H | 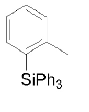 | H | 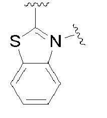 | S | Zn |
| **258** | 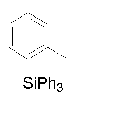 | H | H | H | 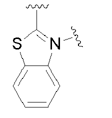 | S | Zn |
| **259** | H | H | H | 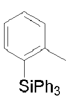 | 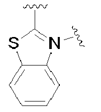 | S | Zn |
| **260** | H | H | 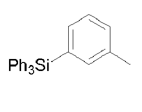 | H | 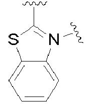 | S | Zn |
| **261** | H | H | H | 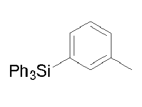 | 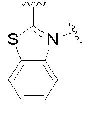 | S | Zn |
| **262** | H | 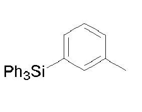 | H | H | 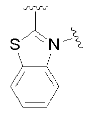 | S | Zn |
| **263** | 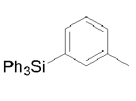 | H | H | H | 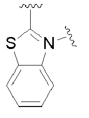 | S | Zn |
| **264** | 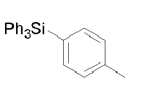 | H | H | H | 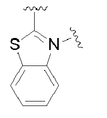 | S | Zn |
| **265** | H | 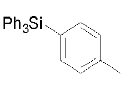 | H | H | 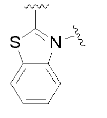 | S | Zn |
| **266** | H | H | 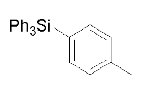 | H | 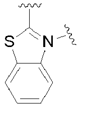 | S | Zn |
| **267** | H | H | H | 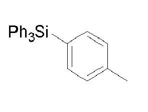 | 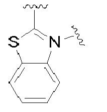 | S | Zn |
| **268** | H | H | -CH₃ | H | 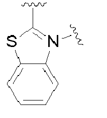 | S | Zn |
| **269** | H | -CH₃ | H | H | 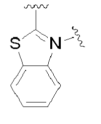 | S | Zn |
| **270** | H | H | H | -CH₃ | 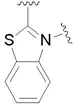 | S | Zn |
| **271** | -CH₃ | H | H | H | 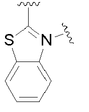 | S | Zn |
| **272** | H | -CH₃ | H | -CH₃ | 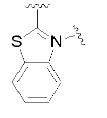 | S | Zn |
| **273** | -CH₃ | H | -CH₃ | H | 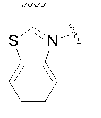 | S | Zn |
| **274** | H | -CH₃ | -CH₃ | H | 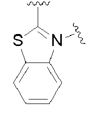 | S | Zn |
| **275** | H | H | -CH₃ | -CH₃ | 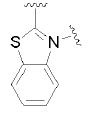 | S | Zn |
| **276** | -CH₃ | -CH₃ | H | H | 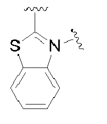 | S | Zn |
| **277** | -CH₃ | H | H | -CH₃ | 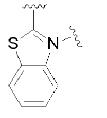 | S | Zn |
| **278** | -C(CH₃)₃ | H | H | H | 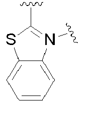 | S | Zn |
| **279** | H | -C(CH₃)₃ | H | H | 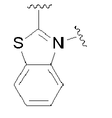 | S | Zn |
| **280** | H | H | -C(CH₃)₃ | H | 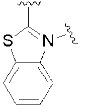 | S | Zn |
| **281** | H | H | H | -C(CH₃)₃ | 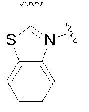 | S | Zn |
| **282** | 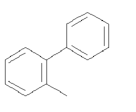 | H | H | H | 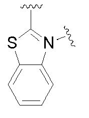 | S | Zn |
| **283** | H | H | 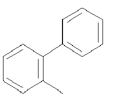 | H | 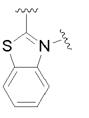 | S | Zn |
| **284** | H | H | H | 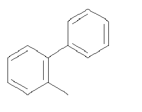 | 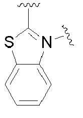 | S | Zn |
| **285** | H | 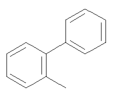 | H | H | 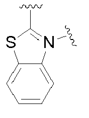 | S | Zn |
| **286** | H | -C(CH₃)₃ | H | -CH₃ | 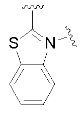 | S | Zn |
| **287** | H | -CH₃ | H | -C(CH₃)₃ | 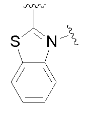 | S | Zn |
| **288** | H | 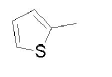 | H | H | 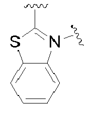 | S | Zn |
| **289** | H | H | 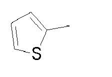 | H | 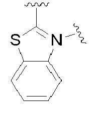 | S | Zn |
| **290** | H | 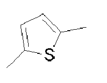 | H | H | 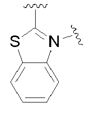 | S | Zn |
| **291** | H | H | 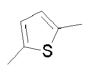 | H | 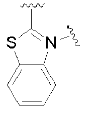 | S | Zn |
| **292** | H | | H | -CH₃ | 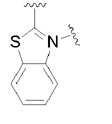 | S | Zn |
| **293** | H | -CH₃ | H | | 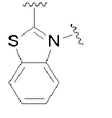 | S | Zn |
| **294** | 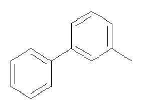 | H | H | H | 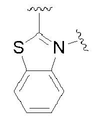 | S | Zn |
| **295** | H | 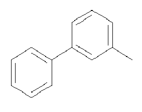 | H | H | 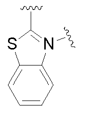 | S | Zn |
| **296** | H | H | 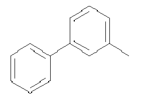 | H | 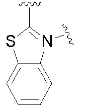 | S | Zn |
| **297** | H | H | H | 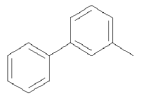 | 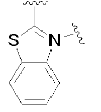 | S | Zn |
| **298** | H | H | 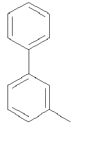 | H | 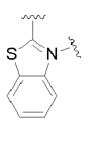 | S | Zn |
| **299** | H | 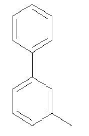 | H | H | 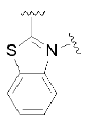 | S | Zn |
| **300** | H | H | H | 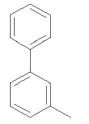 | 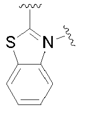 | S | Zn |
| **301** | 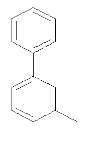 | H | H | H | 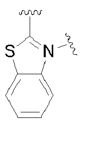 | S | Zn |
| **302** | H | H | H | H | 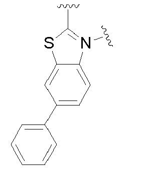 | S | Zn |
| **303** | H | H | H | H | 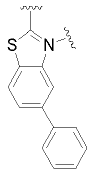 | S | Zn |
| **304** | H | H | H | H | 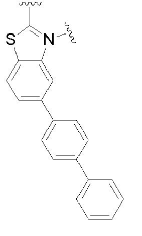 | S | Zn |
| **305** | H | H | H | H | 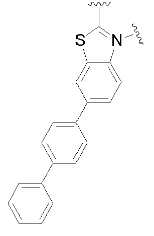 | S | Zn |
| **306** | H | H | H | H | 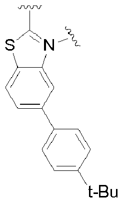 | S | Zn |
| **307** | H | H | H | H | 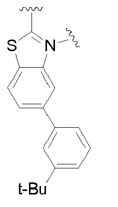 | S | Zn |
| **308** | H | H | H | H | 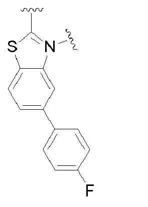 | S | Zn |
| **309** | H | H | H | H | 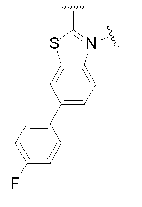 | S | Zn |
| **310** | H | H | H | H | 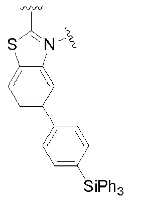 | S | Zn |
| **311** | H | H | H | H | 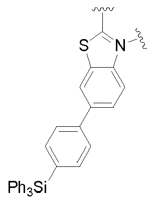 | S | Zn |
| **312** | H | H | H | H | 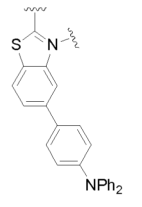 | S | Zn |
| **313** | H | H | H | H | 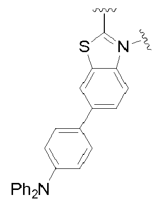 | S | Zn |
| **314** | H | H | H | H | 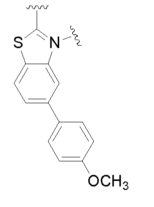 | S | Zn |
| **315** | H | H | H | H | 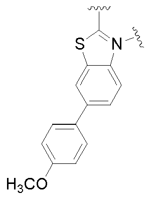 | S | Zn |
| **316** | H | H | H | H | 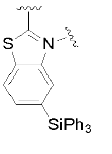 | S | Zn |
| **317** | H | H | H | H | 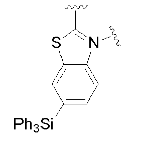 | S | Zn |
| **318** | H | H | H | H | 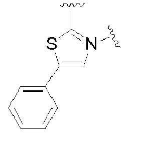 | S | Zn |

**Table 2**

| L¹L¹M(Q)ₘ | | | | | | | | | |
|---|---|---|---|---|---|---|---|---|---|
| L₁ = | | | | | | | M | Q | m |
| Compound No. | R₁ | R₂ | R₃ | R₄ | | X | | | |
| **319** | H | 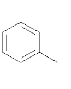 | H | H | 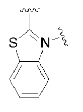 | O | Al | 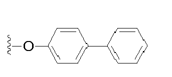 | 1 |
| **320** | 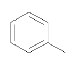 | H | H | H | 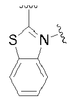 | O | Al | 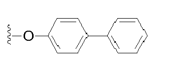 | 1 |
| **321** | H | H | 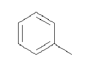 | H | 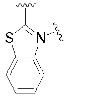 | O | Al | 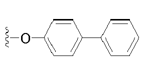 | 1 |
| **322** | H | H | H | 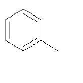 | 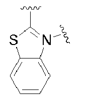 | O | Al | 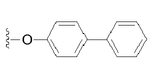 | 1 |
| **323** | H | 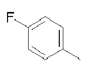 | H | H | 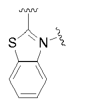 | O | Al | 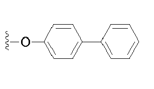 | 1 |
| **324** | H | H | 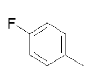 | H | 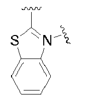 | O | Al | 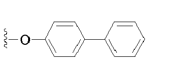 | 1 |
| **325** | H | H | H | 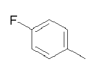 | 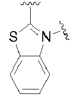 | O | Al | 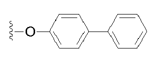 | 1 |
| **326** | | H | H | H | 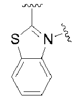 | O | Al | 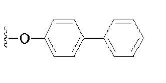 | 1 |
| **327** | H | 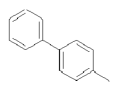 | H | H | 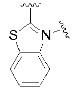 | O | Al | 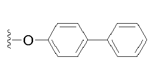 | 1 |
| **328** | 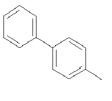 | H | H | H | 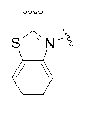 | O | Al | 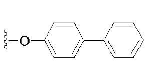 | 1 |
| **329** | H | H | 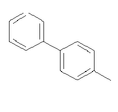 | H | 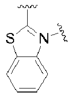 | O | Al | 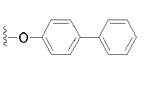 | 1 |
| **330** | H | H | H | 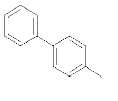 | 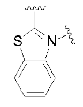 | O | Al | 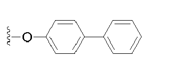 | 1 |
| **331** | H | H | 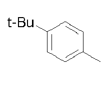 | H | 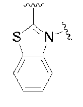 | O | Al | 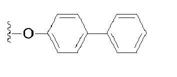 | 1 |
| **332** | H | 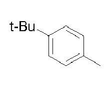 | H | H | 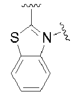 | O | Al | 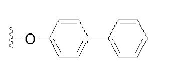 | 1 |
| **333** | H | H | 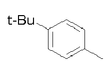 | H | 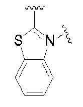 | O | Al | 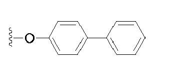 | 1 |
| **334** | 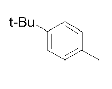 | H | H | H | 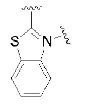 | O | Al | 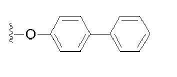 | 1 |
| **335** | H | 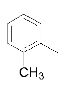 | H | H | 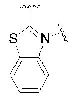 | O | Al | 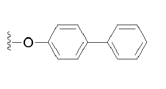 | 1 |
| **336** | H | H | 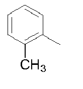 | H | 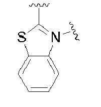 | O | Al | 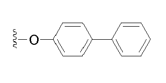 | 1 |
| **337** | 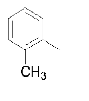 | H | H | H | 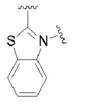 | O | Al | 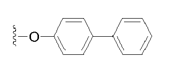 | 1 |
| **338** | H | H | H | 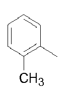 | 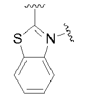 | O | Al | 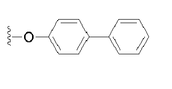 | 1 |
| **339** | H | 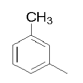 | H | H | 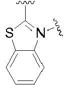 | O | Al | 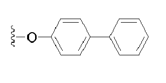 | 1 |
| **340** | H | H | 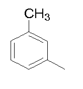 | H | 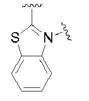 | O | Al | 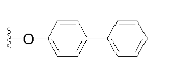 | 1 |
| **341** | H | H | H | 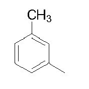 | 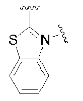 | O | Al | 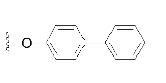 | 1 |
| **342** | 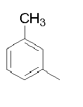 | H | H | H | 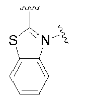 | O | Al | 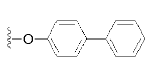 | 1 |
| **343** | 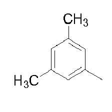 | H | H | H | 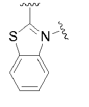 | O | Al | 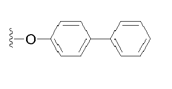 | 1 |
| **344** | H | 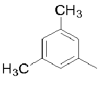 | H | H | 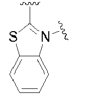 | O | Al | 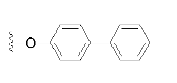 | 1 |
| **345** | H | H | 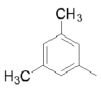 | H | 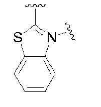 | O | Al | 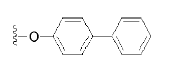 | 1 |
| **346** | H | H | H | 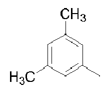 | 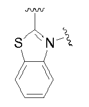 | O | Al | 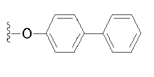 | 1 |
| **347** | H | 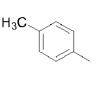 | H | H | 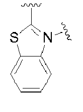 | O | Al | 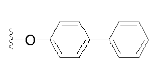 | 1 |
| **348** | H | H | 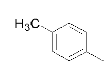 | H | 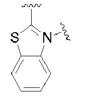 | O | Al | 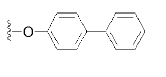 | 1 |
| **349** | 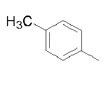 | H | H | H | 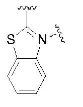 | O | Al | 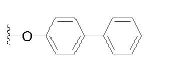 | 1 |
| **350** | H | H | H | 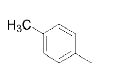 | 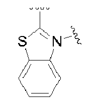 | O | Al | 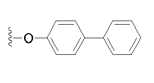 | 1 |
| **351** | H | H | 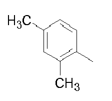 | H | 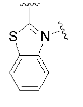 | O | Al | 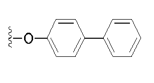 | 1 |
| **352** | H | 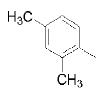 | H | H | 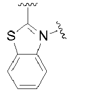 | O | Al | 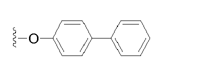 | 1 |
| **353** | 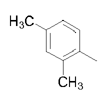 | H | H | H | 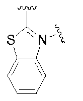 | O | Al | 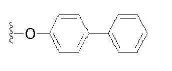 | 1 |
| **354** | H | H | H | 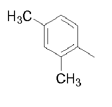 | 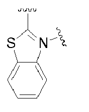 | O | Al | 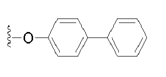 | 1 |
| **355** | H | 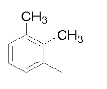 | H | H | 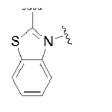 | O | Al | 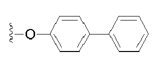 | 1 |
| **356** | H | H | 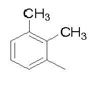 | H | 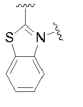 | O | Al | 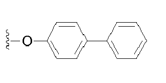 | 1 |
| **357** | 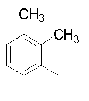 | H | H | H | 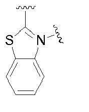 | O | Al | 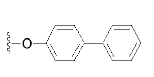 | 1 |
| **358** | H | H | H | 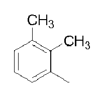 | 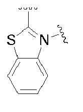 | O | Al | 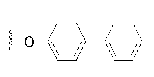 | 1 |
| **359** | H | 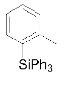 | H | H | 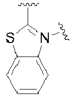 | O | Al | 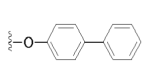 | 1 |
| **360** | H | H | 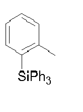 | H | 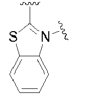 | O | Al | 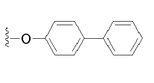 | 1 |
| **361** | 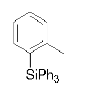 | H | H | H | 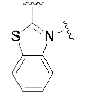 | O | Al | 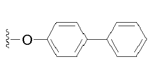 | 1 |
| **362** | H | H | H | 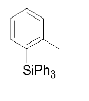 | 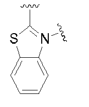 | O | Al | 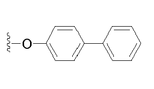 | 1 |
| **363** | H | H | 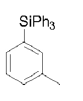 | H | 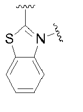 | O | Al | 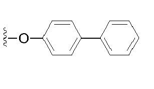 | 1 |
| **364** | H | H | H | 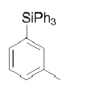 | 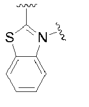 | O | Al | 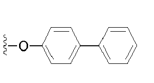 | 1 |
| **365** | H | 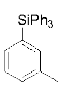 | H | H | 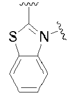 | O | Al | 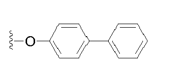 | 1 |
| **366** | 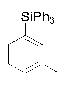 | H | H | H | 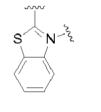 | O | Al | 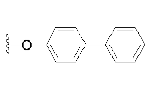 | 1 |
| **367** | 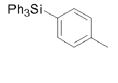 | H | H | H | 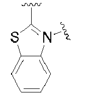 | O | Al | 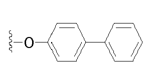 | 1 |
| **368** | H | 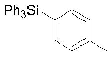 | H | H | 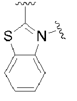 | O | Al | 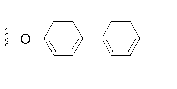 | 1 |
| **369** | H | H | 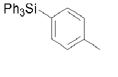 | H | 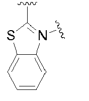 | O | Al | 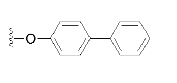 | 1 |
| **370** | H | H | H | 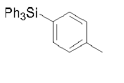 | 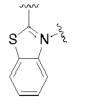 | O | Al | 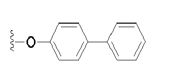 | 1 |
| **371** | H | H | 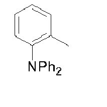 | H | 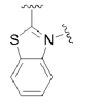 | O | Al | 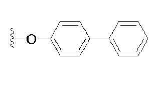 | 1 |
| **372** | H | 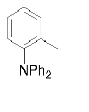 | H | H | 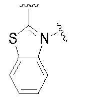 | O | Al | 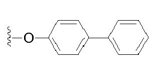 | 1 |
| **373** | H | H | H | 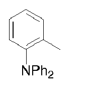 | 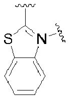 | O | Al | 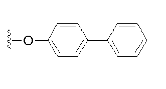 | 1 |
| **374** | 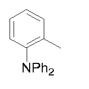 | H | H | H | 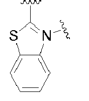 | O | Al | 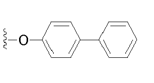 | 1 |
| **375** | 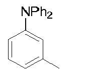 | H | 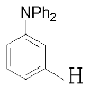 | H | 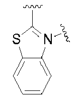 | O | Al | 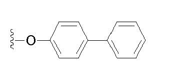 | 1 |
| **376** | H | 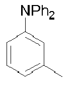 | H | H | 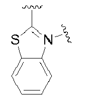 | O | Al | 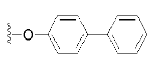 | 1 |
| **377** | H | H | 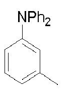 | H | 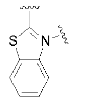 | O | Al | 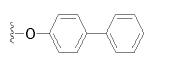 | 1 |
| **378** | H | H | H | 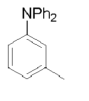 | 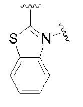 | O | Al | 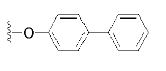 | 1 |
| **379** | H | H | 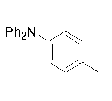 | H | 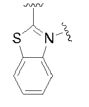 | O | Al | 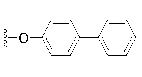 | 1 |
| **380** | H | 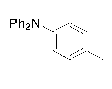 | H | H | 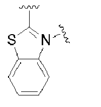 | O | Al | 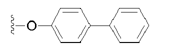 | 1 |
| **381** | H | H | H | 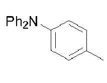 | 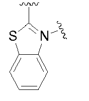 | O | Al | 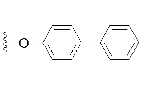 | 1 |
| **382** | 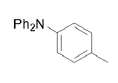 | H | H | H | 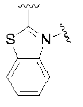 | O | Al | 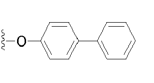 | 1 |
| **383** | H | H | H | H | 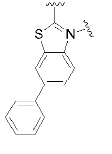 | O | Al | 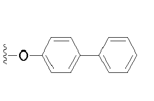 | 1 |
| **384** | H | H | H | H | 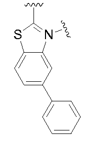 | O | Al | 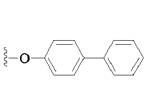 | 1 |
| **385** | H | H | H | H | 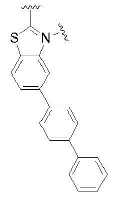 | O | Al | 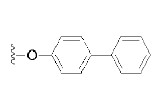 | 1 |
| **386** | H | H | H | H | 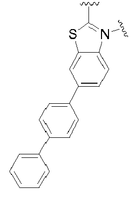 | O | Al | 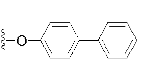 | 1 |
| **387** | H | H | H | H | 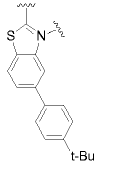 | O | Al | 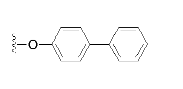 | 1 |
| **388** | H | H | H | H | 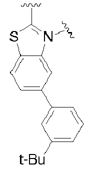 | O | Al | 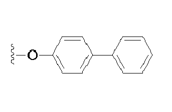 | 1 |
| **389** | H | H | H | H | 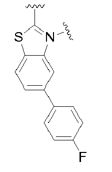 | O | Al | 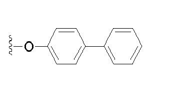 | 1 |
| **390** | H | H | H | H | 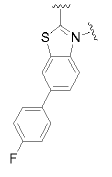 | O | Al | 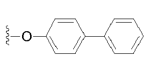 | 1 |
| **391** | H | H | H | H | 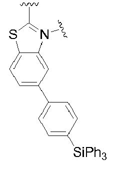 | O | Al | 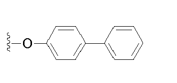 | 1 |
| **392** | H | H | H | H | 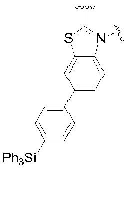 | O | Al | 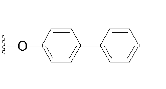 | 1 |
| **393** | H | H | H | H | 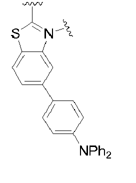 | O | Al | 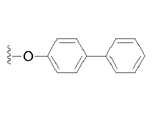 | 1 |
| **394** | H | H | H | H | 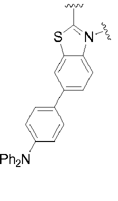 | O | Al | 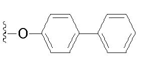 | 1 |
| **395** | H | H | H | H | 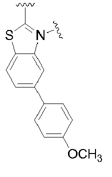 | O | Al | 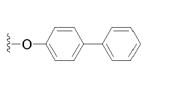 | 1 |
| **396** | H | H | H | H | 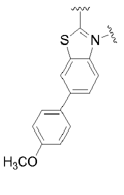 | O | Al | 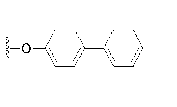 | 1 |
| **397** | H | H | H | H | 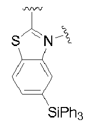 | O | Al | 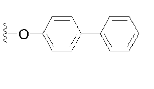 | 1 |
| **398** | H | H | H | H | 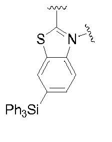 | O | Al | 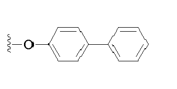 | 1 |
| **399** | H | H | H | H | 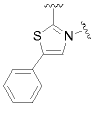 | O | Al | 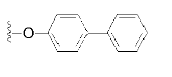 | 1 |
| **400** | H | 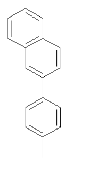 | H | H | 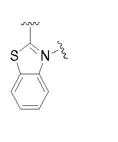 | O | Al | 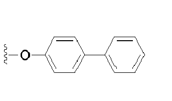 | 1 |
| **401** | H | 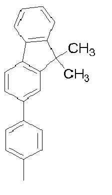 | H | H | 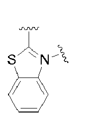 | O | Al | 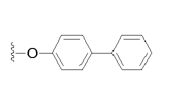 | 1 |
| **402** | H | H | 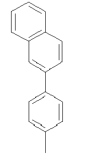 | H | 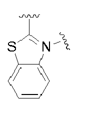 | O | Al | 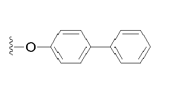 | 1 |
| **403** | H | H | 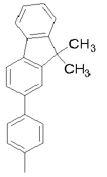 | H | 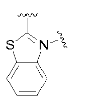 | O | Al | 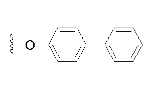 | 1 |
| **404** | H | 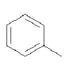 | H | H | 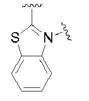 | O | Al | 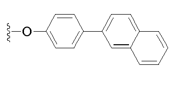 | 1 |
| **405** | H | 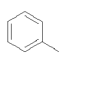 | H | H | 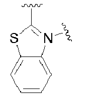 | O | Al | 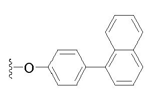 | 1 |
| **406** | H | 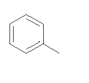 | H | H | 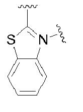 | O | Al | 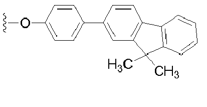 | 1 |
| **407** | H | 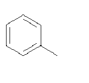 | H | H | 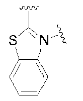 | O | Al | 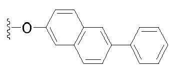 | 1 |
| **408** | H | 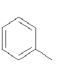 | H | H | 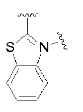 | O | Al | 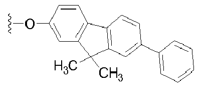 | 1 |

**Table 3**

| L¹L¹M | | | | | | | | | |
|---|---|---|---|---|---|---|---|---|---|
| L₁ = | | | | | | | | | |
| Compound No. | 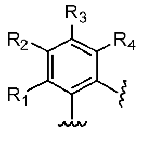 | | X | M | | 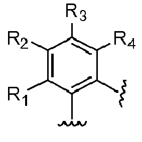 | | X | M |
| **409** | 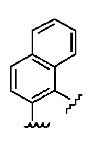 | 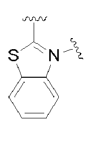 | O | Zn | **469** | 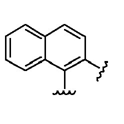 | 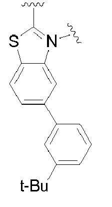 | S | Zn |
| **410** | 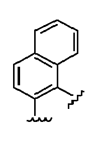 | 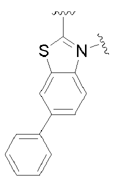 | O | Zn | **470** | 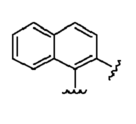 | 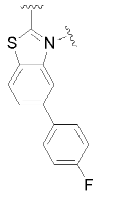 | S | Zn |
| **411** | 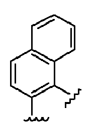 | 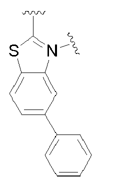 | O | Zn | **471** | 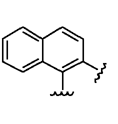 | 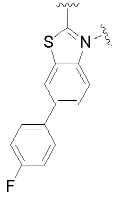 | S | Zn |
| **412** | 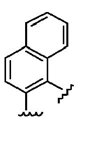 | 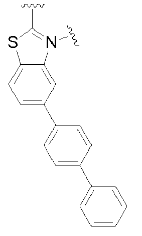 | O | Zn | **472** | 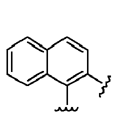 | 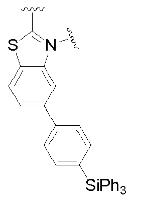 | S | Zn |
| **413** | 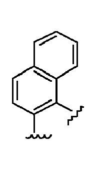 | 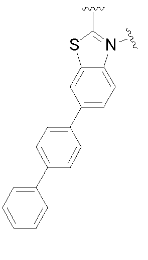 | O | Zn | **473** | 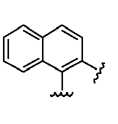 | 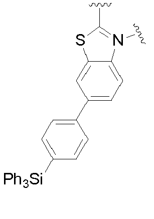 | S | Zn |
| **414** | 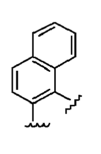 | 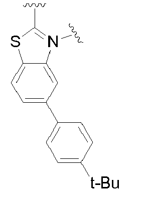 | O | Zn | **474** | 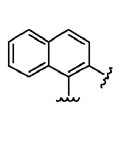 | 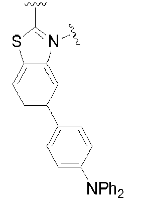 | S | Zn |
| **415** | 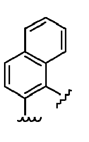 | 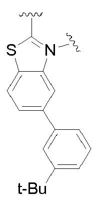 | O | Zn | **475** | 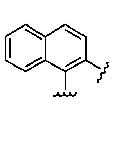 | 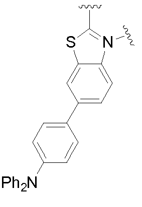 | S | Zn |
| **416** | 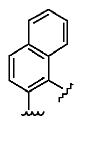 | 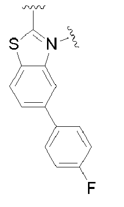 | O | Zn | **476** | 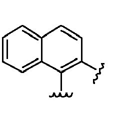 | 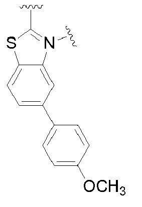 | S | Zn |
| **417** | 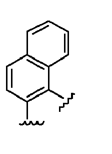 | 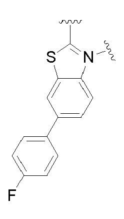 | O | Zn | **477** | 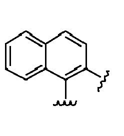 | 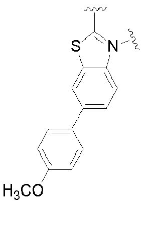 | S | Zn |
| **418** | 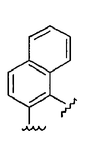 | 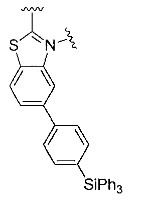 | O | Zn | **478** | 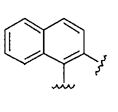 | 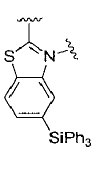 | S | Zn |
| **419** | 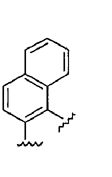 | 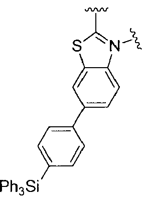 | O | Zn | **479** | 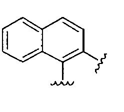 | 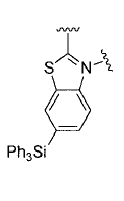 | S | Zn |
| **420** | 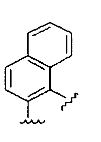 | 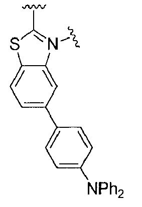 | O | Zn | **480** | 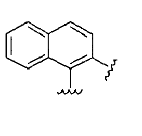 | 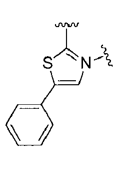 | S | Zn |
| **421** | 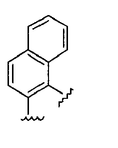 | 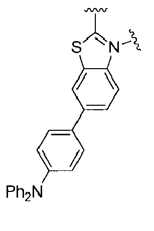 | O | Zn | **481** | 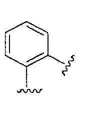 | 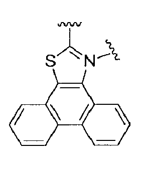 | O | Zn |
| **422** | 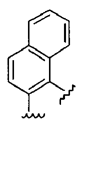 | 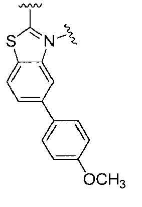 | O | Zn | **482** | 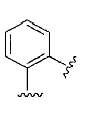 | 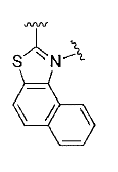 | O | Zn |
| **423** | 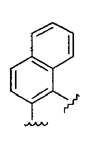 | 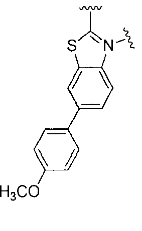 | O | Zn | **483** | 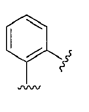 | 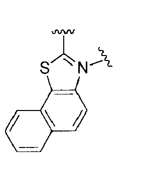 | O | Zn |
| **424** | 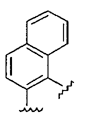 | 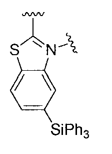 | O | Zn | **484** | 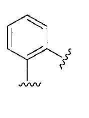 | 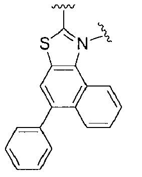 | O | Zn |
| **425** | 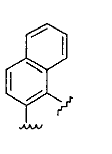 | 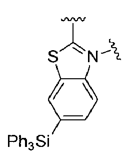 | O | Zn | **485** | 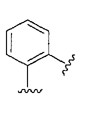 | 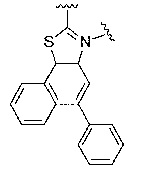 | O | Zn |
| **426** | 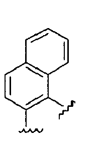 | 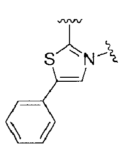 | O | Zn | **486** | 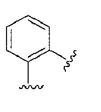 | 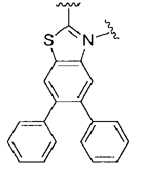 | O | Zn |
| **427** | 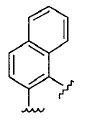 | 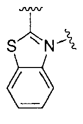 | S | Zn | **487** | 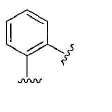 | 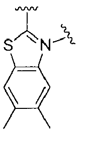 | O | Zn |
| **428** | 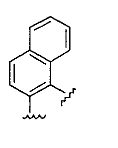 | 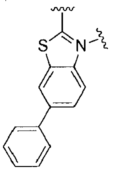 | S | Zn | **488** | 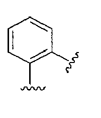 | 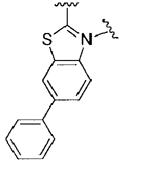 | O | Zn |
| **429** | 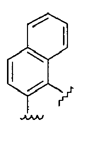 | 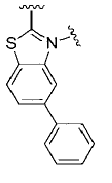 | S | Zn | **489** | 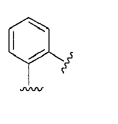 | 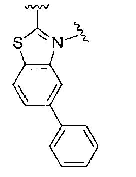 | O | Zn |
| **430** | 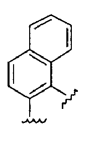 | 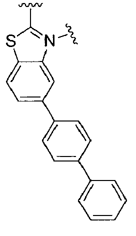 | S | Zn | **490** | 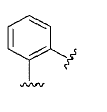 | 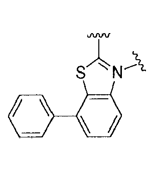 | O | Zn |
| **431** | 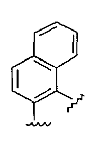 | 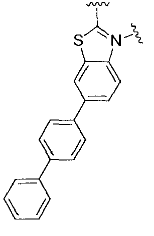 | S | Zn | **491** | 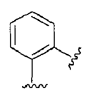 | 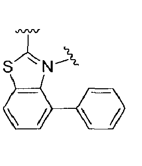 | O | Zn |
| **432** | 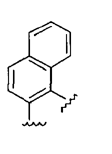 | 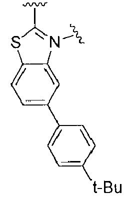 | S | Zn | **492** | 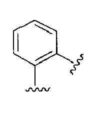 | 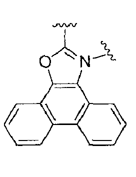 | O | Zn |
| **433** | 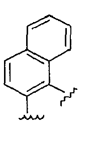 | 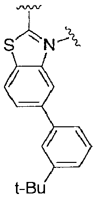 | S | Zn | **493** | 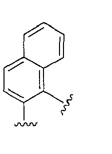 | 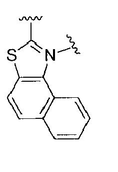 | O | Zn |
| **434** | 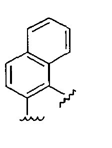 | 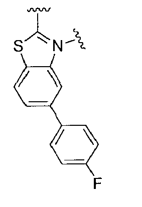 | S | Zn | **494** | 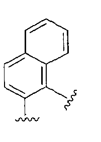 | 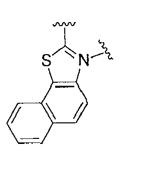 | O | Zn |
| **435** | 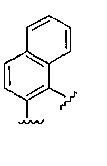 | 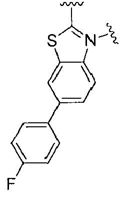 | S | Zn | **495** | 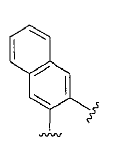 | 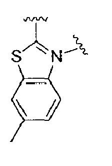 | O | Zn |
| **436** | 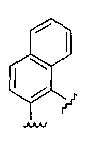 | 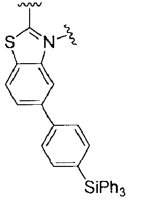 | S | Zn | **496** | 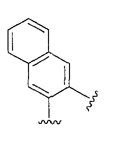 | 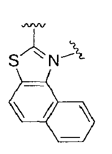 | O | Zn |
| **437** | 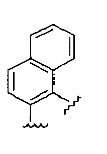 | 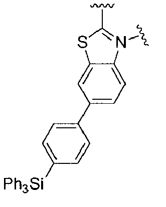 | S | Zn | **497** | 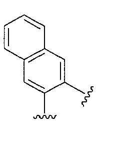 | 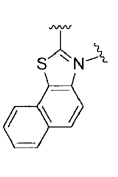 | O | Zn |
| **438** | 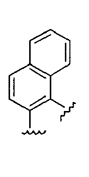 | 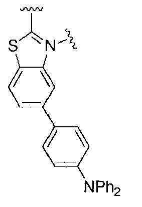 | S | Zn | **498** | 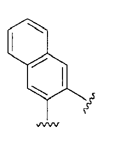 | 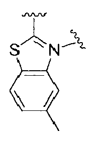 | O | Zn |
| **439** | 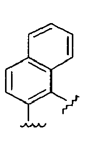 | 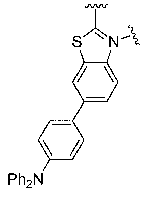 | S | Zn | **499** | 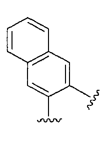 | 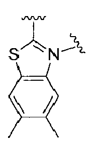 | O | Zn |
| **440** | 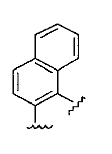 | 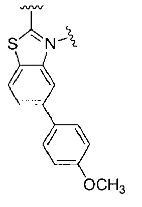 | S | Zn | **500** | 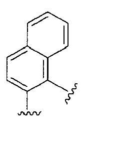 | 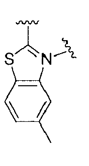 | O | Zn |
| **441** | 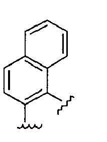 | 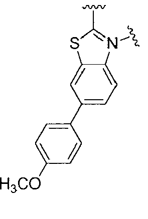 | S | Zn | **501** | 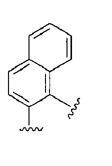 | 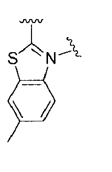 | O | Zn |
| **442** | 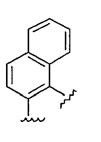 | 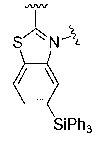 | S | Zn | **502** | 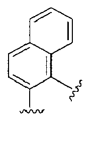 | 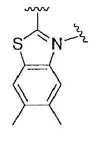 | O | Zn |
| **443** | 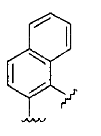 | 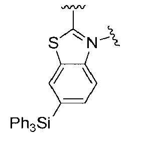 | S | Zn | **503** | 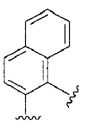 | 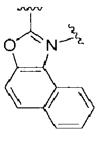 | O | Zn |
| **444** | 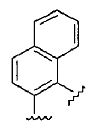 | 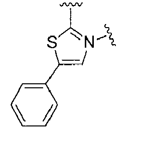 | S | Zn | 504 | 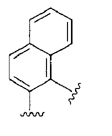 | 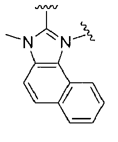 | O | Zn |
| **445** | 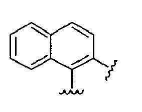 | 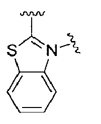 | O | Zn | **505** | 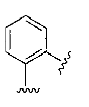 | 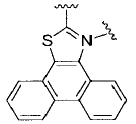 | O | Be |
| **446** | 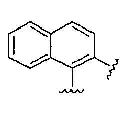 | 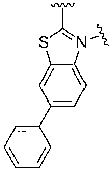 | O | Zn | **506** | 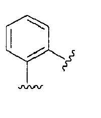 | 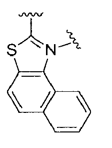 | O | Be |
| **447** | 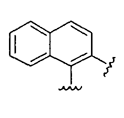 | 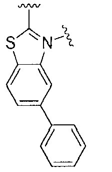 | O | Zn | **507** | 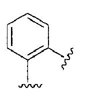 | 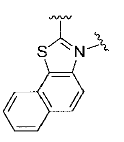 | O | Be |
| **448** | 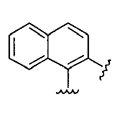 | 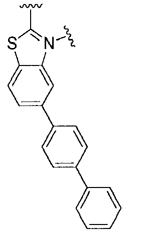 | O | Zn | **508** | 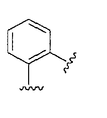 | 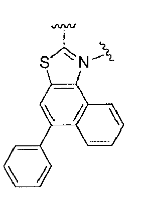 | O | Be |
| **449** | 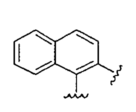 | 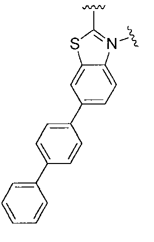 | O | Zn | **509** | 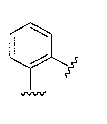 | 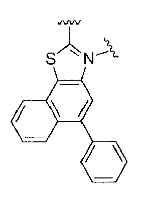 | O | Be |
| **450** | 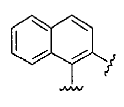 | 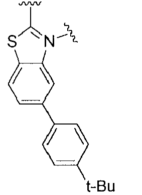 | O | Zn | **510** | 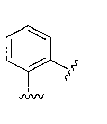 | 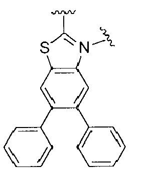 | O | Be |
| **451** | 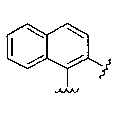 | 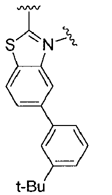 | O | Zn | **511** | 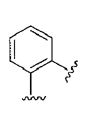 | 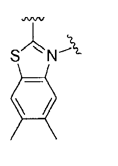 | O | Be |
| **452** | 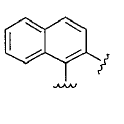 | 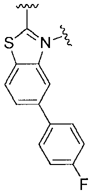 | O | Zn | **512** | 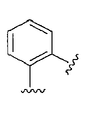 | 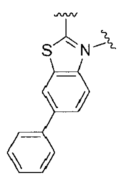 | O | Be |
| **453** | 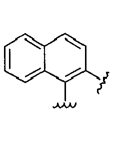 | 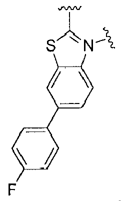 | O | Zn | **513** | 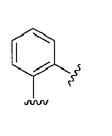 | 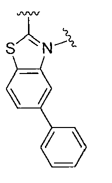 | O | Be |
| **454** | 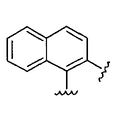 | 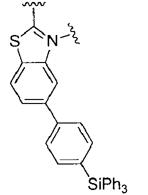 | O | Zn | **514** | 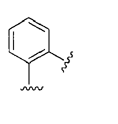 | 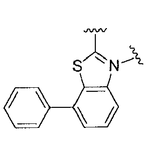 | O | Be |
| **455** | 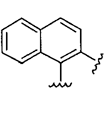 | 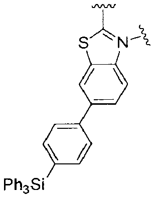 | O | Zn | **515** | 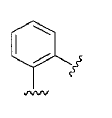 | 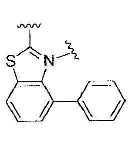 | O | Be |
| **456** | 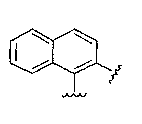 | 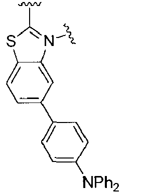 | O | Zn | **516** | 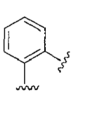 | 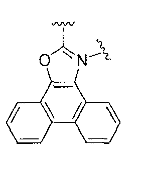 | O | Be |
| **457** | 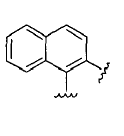 | 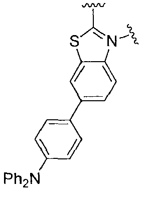 | O | Zn | **517** | 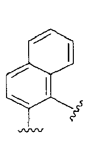 | 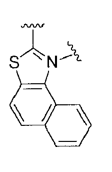 | O | Be |
| **458** | 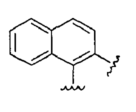 | 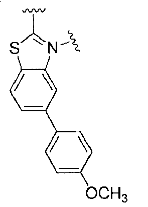 | O | Zn | **518** | 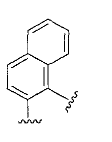 | 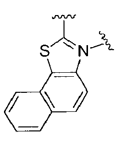 | O | Be |
| **459** | 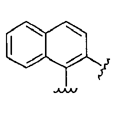 | 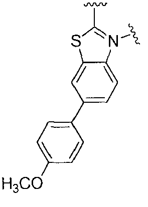 | O | Zn | **519** | 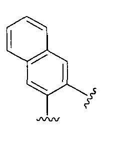 | 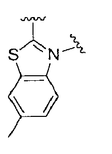 | O | Be |
| **460** | 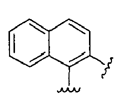 | 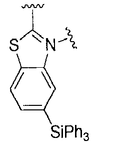 | | O Zn | **520** | 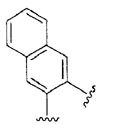 | 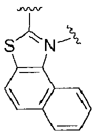 | O | Be |
| **461** | 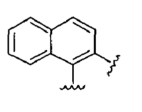 | 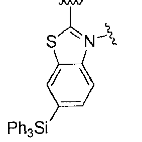 | O | Zn | **521** | 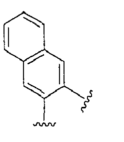 | 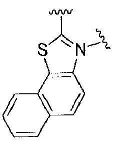 | O | Be |
| **462** | 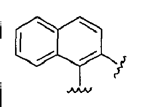 | 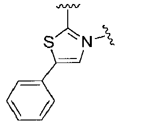 | O | Zn | **522** | 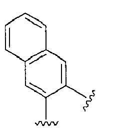 | 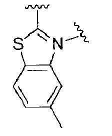 | O | Be |
| **463** | 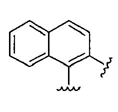 | 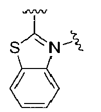 | S | Zn | **523** | 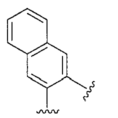 | 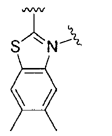 | O | Be |
| **464** | 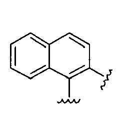 | 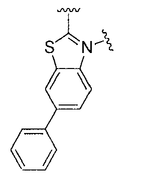 | S | Zn | **524** | 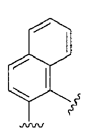 | 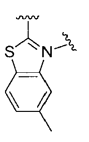 | O | Be |
| **465** | 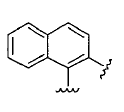 | 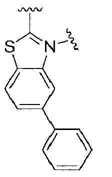 | S | Zn | **525** | 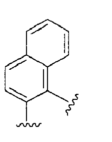 | 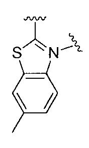 | O | Be |
| **466** | 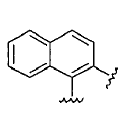 | 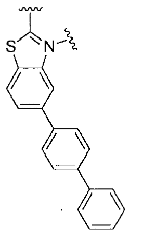 | S | Zn | **526** | 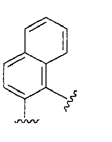 | 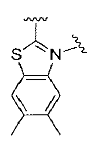 | O | Be |
| **467** | 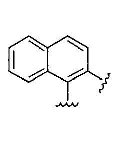 | 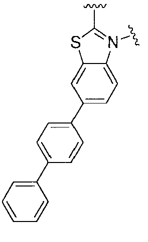 | S | Zn | **527** | 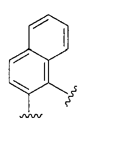 | 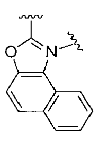 | O | Be |
| **468** | 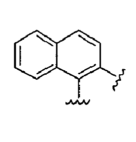 | 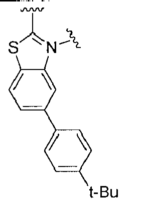 | S | Zn | **528** | 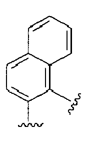 | 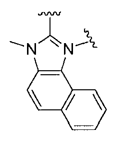 | O | Be |

Further, the present invention provides organic solar cells, which is characterized by comprising one or more electroluminescent compound(s) represented by Chemical Formula (1).

Furthermore, the present invention provides electroluminescent devices, which is comprised of a first electrode; a second electrode; and at least one organic layer(s) interposed between the first electrode and the second electrode; wherein the organic layer comprises one or more compound(s) represented by Chemical Formula (1).

The electroluminescent device according to the present invention is characterized that the organic layer comprises an electroluminescent layer, and the electroluminescent layer comprises one or more compound(s) represented by Chemical Formula (1) as the electroluminescent host in an amount of 2 to 30% by weight, and one or more electroluminescent dopant. The electroluminescent dopant applied to an electroluminescent device according to the present invention is not critically limited, but can be exemplified by the compounds represented by Chemical Formula (2):

Chemical Formula 2 M¹L²L³L⁴

wherein, M¹ is selected from a group consisting of metals of Group 7, 8, 9, 10, 11, 13, 14, 15 and 16 of the Periodic Table, and preferably selected from Ir, Pt, Pd, Rh, Re, Os, Tl, Pb, Bi, In, Sn, Sb, Te, Au and Ag; and
ligands L², L³ and L⁴ are independently selected from the following structures: 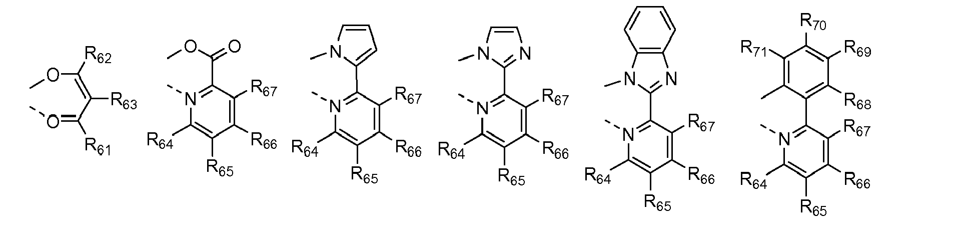 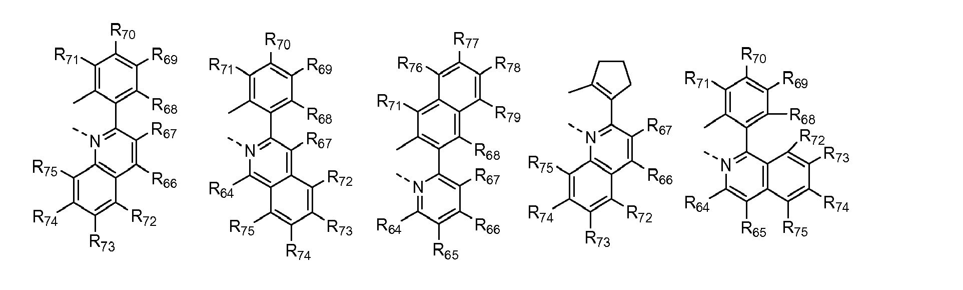 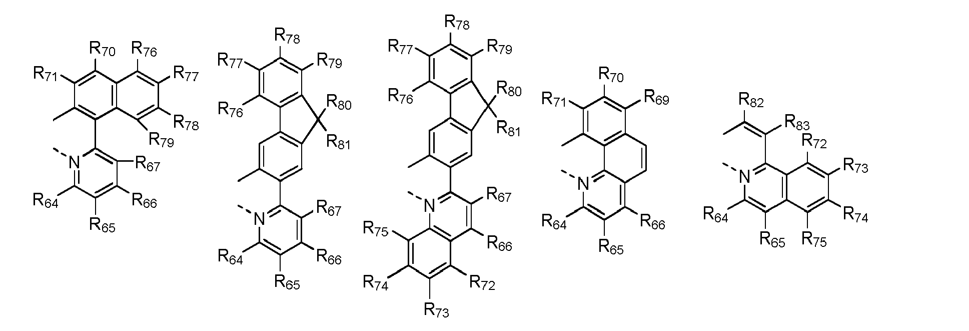 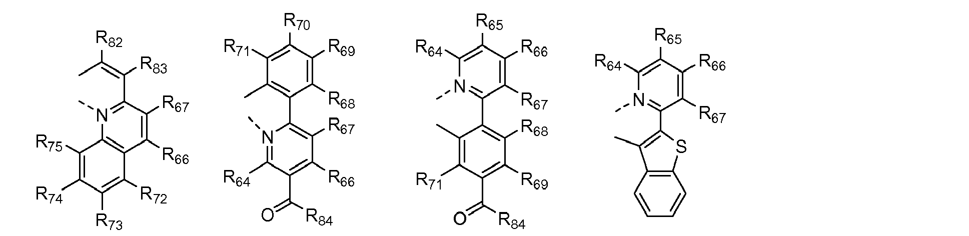
wherein, R₆₁ and R₆₂ independently represent hydrogen, (C1-C60)alkyl, phenyl or halogen;
R₆₃ through R₇₉ independently represent hydrogen, (C1-C60)alkyl, phenyl, tri(C1-C30)alkylsilyl or halogen;
R₈₀ through R₈₃ independently represent hydrogen, (C1-C60)alkyl or phenyl;
R₈₄ represents (C1-C60)alkyl, phenyl or halogen; and
the alkyl or phenyl of R₆₁ through R₈₄ may be further substituted by (C1-C60)alkyl or halogen.

The compounds represented by Chemical Formula (2) may be specifically exemplified by the compounds having one of the following structures, but they are not restricted thereto.

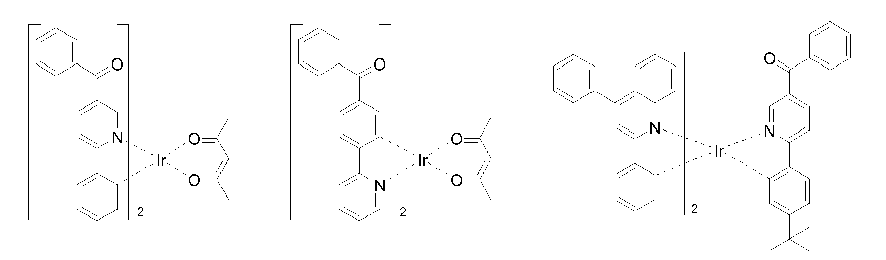

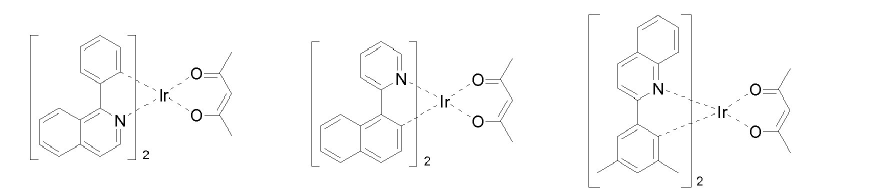

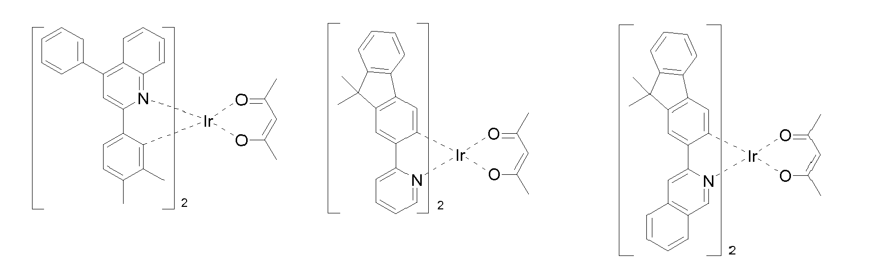

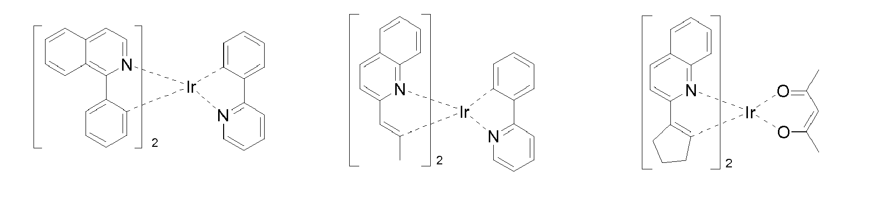

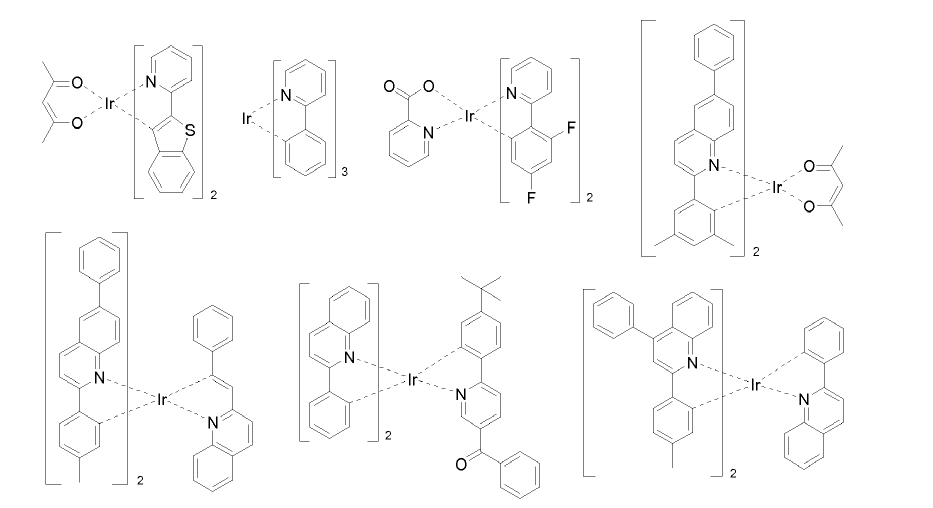

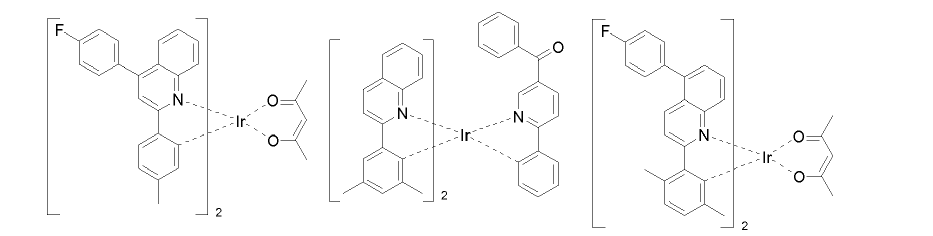

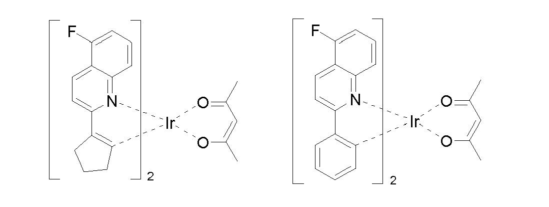

The electroluminescent layer means the layer where the luminescence occurs. The layer may be a single layer, or a multiple layers formed by stacking two or more layers. When a mixture of host-dopant is used according to the constitution of the present invention, noticeable improvement in luminous efficiency due to the electroluminescent host of the invention could be confirmed. This gives excellent conductivity of holes or electrons, and very good stability of material to cause improvement in life of device, as well as in luminous efficiency, as compared to other host materials.

An electroluminescent device according to the invention may comprise an organic electroluminescent compound represented by Chemical Formula (1), and one or more compound(s) selected from a group consisting of arylamine compounds or styrylarylamine compounds as well. Examples of arylamine compounds or styrylarylamine compounds include the compounds represented by Chemical Formula (3), but are not restricted thereto: 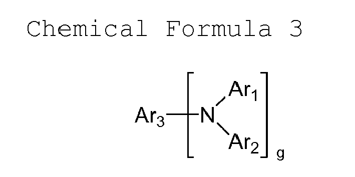
wherein, Ar₁ and Ar₂ independently represent (C1-C60)alkyl, (C6-C60)aryl, (C4-C60)heteroaryl, (C6-C60)arylamino, (C1-C60)alkylamino, morpholino, thiomorpholino, a 5- or 6-membered heterocycloalkyl containing one or more heteroatom(s) selected from N, O and S, or (C3-C60)cycloalkyl, or Ar₁ and Ar₂ may be linked via (C3-C60)alkylene or (C3-C60)alkenylene with or without a fused ring to form an alicyclic ring, or a monocyclic or polycyclic aromatic ring; and the aryl, heteroaryl, arylamino or heterocycloalkyl of Ar₁ and Ar₂ may be further substituted by one or more substituent(s) selected from halogen, (C1-C60)alkyl, (C2-C60)alkenyl, (C2-C60)alkynyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
Ar₃ represents (C6-C60)aryl, (C5-C60)heteroaryl or (C6-C60)arylamino; and the aryl, heteroaryl or arylamino of Ar₃ may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; and
g is an integer from 1 to 4.

More specifically, the arylamine compounds or styrylarylamine compounds may be exemplified by the following compounds, but are not restricted thereto.

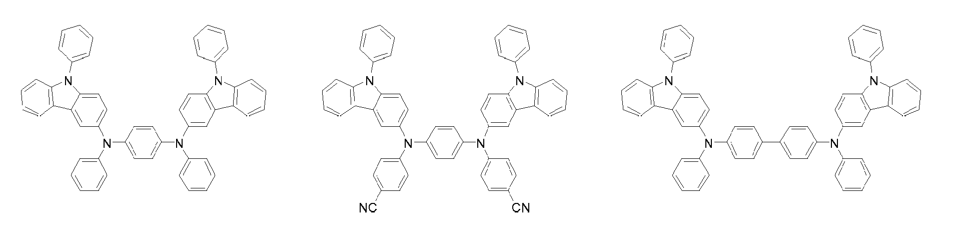

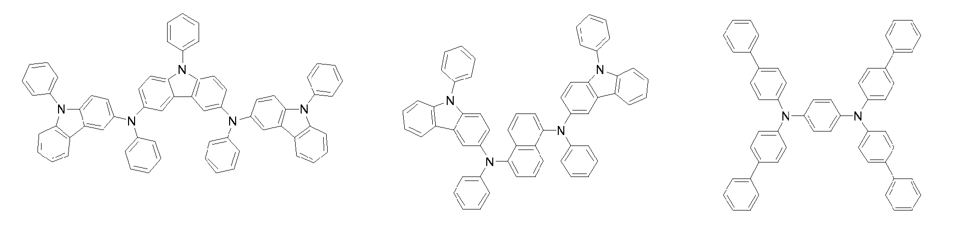

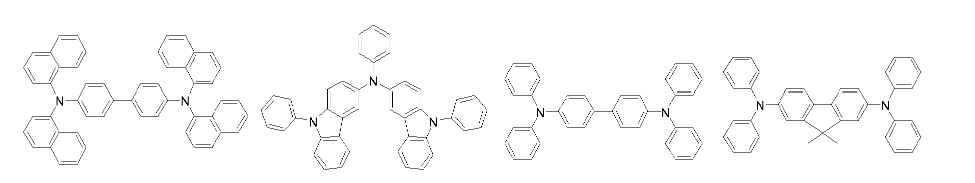

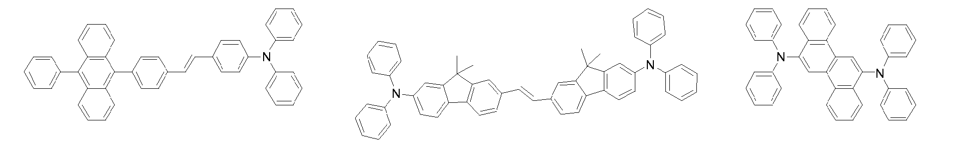

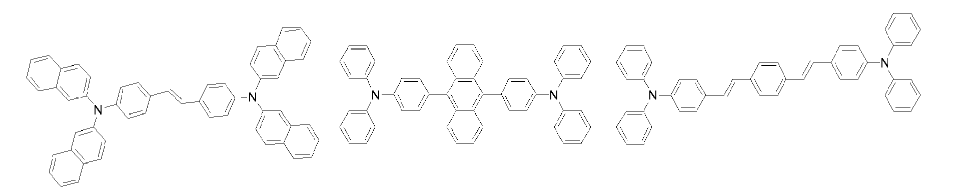

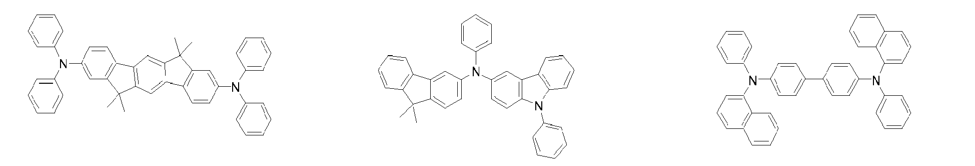

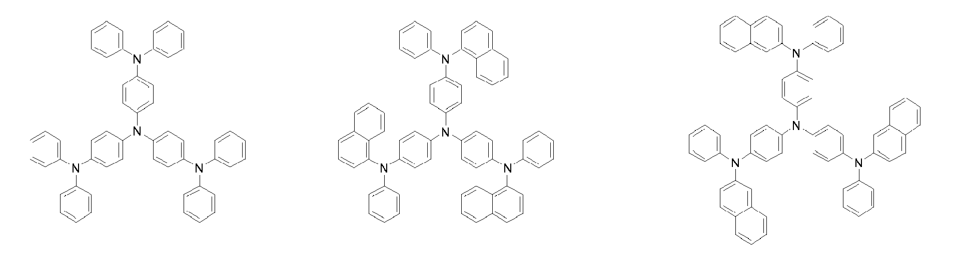

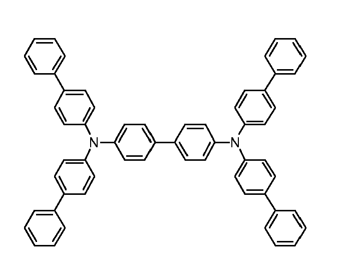

Further, in an electroluminescent device according to the present invention, the electroluminescent layer may further comprise one or more metal(s) selected from a group consisting of organic metals of Group 1, Group 2, 4^{th} period and 5^{th} period transition metals, lanthanide metals and d-transition elements, in addition to the organic electroluminescent compound represented by Chemical Formula (1). The organic layer may comprise a charge generating layer as well, in addition to the EL layer.

An electroluminescent device may be embodied, having a pixel structure of independent light-emitting mode wherein the organic electroluminescent device comprising the EL compound represented by Chemical Formula (1) as a sub-pixel and one or more sub-pixel(s) comprising one or more compound(s) selected from a group consisting of arylamine compounds and styrylarylamine compounds are patterned in parallel at the same time.

Besides, the electroluminescent layer may comprise an organic compound or an organometallic compound having an electroluminescent peak at a wavelength of not more than 560 nm at the same time. The compounds are exemplified by those represented by one of Chemical Formulas (4) to (9), but not restiricted thereto.

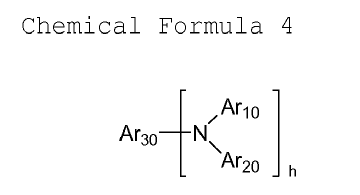

In Chemical Formula (4), Ar₁₀ and Ar₂₀ independently represent (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or Ar₁₀ and Ar₂₀ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of Ar₁₀ and Ar₂₀, or the fused ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
Ar₃₀ represents (C6-C60)arylamino, (C6-C60)arylene, (C4-C60)heteroarylene or an arylene with the following structure: 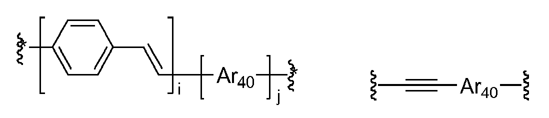 wherein, Ar₄₀ represents (C6-C60)arylene or (C4-C60)heteroarylene;
the arylene, heteroarylene and arylamino of Ar₃₀ and Ar₄₀ may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
h is an integer from 1 to 4;
i is an integer from 1 to 4; and
j is an integer of 0 or 1.

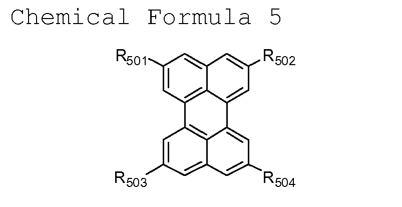

In Chemical Formula (5), R₅₀₁ through R₅₀₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or R₅₀₁ through R₅₀₄ may be linked to an adjacent substituent via (C3-C60)alkylene or (C3-C60)alkenylene with or without a fused ring to form an alicyclic ring, or a monocyclic or polycyclic aromatic ring; and
the alkyl, alkenyl, alkynyl, cycloalkyl, heterocycloalkyl, aryl, heteroaryl, arylsilyl, alkylsilyl, alkylamino or arylamino of R₅₀₁ through R₅₀₄, or the fused ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

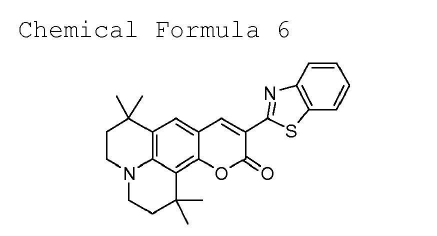

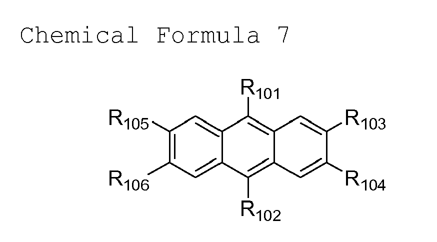

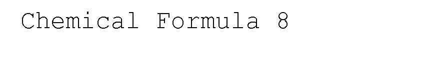

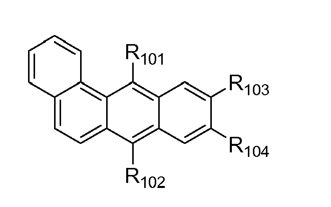

In Chemical Formulas (7) and (8), R₁₀₁ and R₁₀₂ independently represent (C6-C60)aryl, (C4-C60)heteroaryl, a 5- or 6-membered heterocycloalkyl containing one or more heteroatom(s) selected from N, O and S, or (C3-C60)cycloalkyl, and the aryl or heteroaryl of R₁₀₁ and R₁₀₂ may be further substituted by one or more substituent(s) selected from a group consisting of (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl; and R₁₀₃ through R₁₀₆ represent hydrogen, (C1-C60)alkyl, (C1-C60)alkoxy, halogen, (C4-C60)heteroaryl, (C5-C60)cycloalkyl or (C6-C60)aryl, and the heteroaryl, cycloalkyl or aryl of R₁₀₃ through R₁₀₆ may be further substituted by one or more substituent(s) selected from a group consisting of (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl.

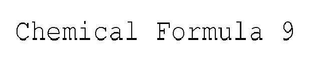

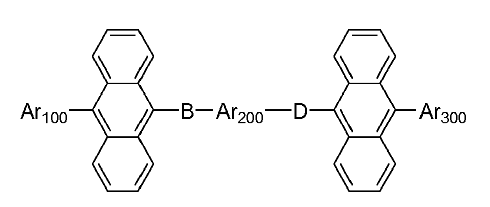

In Chemical Formula (9), B and D independently represent a chemical bond, or a (C6-C60)arylene with or without one or more substituent(s) selected from (C1-C60)alkyl, (C1-60)alkoxy, (C6-C60)aryl, (C5-C60)heteroaryl and halogen;
Ar₁₀₀ and Ar₃₀₀ independently represent an aryl selected from the following structures, or (C4-C60)heteroaryl, and the aryl or heteroaryl of Ar₁₀₀ and Ar₃₀₀ may be further substituted by one or more substituent(s) selected from (C1-C60)alkyl, (C1-C60)alkoxy, (C6-C60)aryl and (C4-C60)heteroaryl: 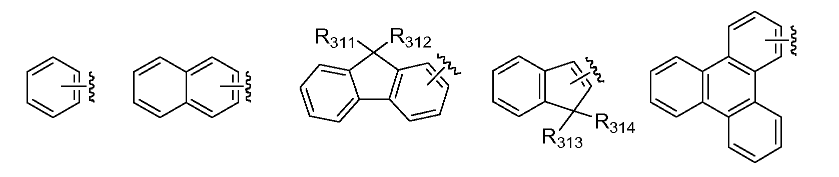 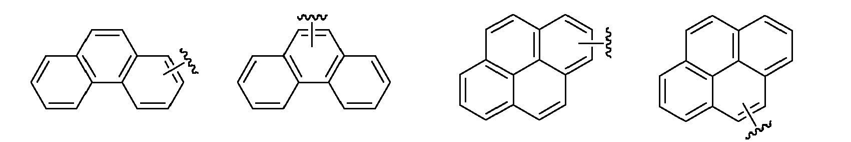 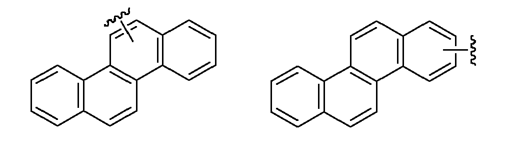 wherein R₃₁₁, R₃₁₂, R₃₁₃ and R₃₁₄ independently represent hydrogen, (C1-C60)alkyl or (C6-C60)aryl, or may be linked to an adjacent substituent via (C3-C60)alkylene or (C3-C60)alkenylene with or without a fused ring to form an alicyclic ring, or a monocyclic or polycyclic aromatic ring;
Ar₂₀₀ represents (C6-C60)arylene or (C4-C60)heteroarylene, preferably phenylene, naphthylene, anthrylene, fluorenylene, phenanthrylene, tetracenylene, naphthacenylene, chrysenylene, pentacenylene, pyrenylene, heteroarylene or a chemical group represented by the following structure, and the arylene or heteroarylene of Ar₂₀₀ may be further substituted by one or more substituent(s) selected from (C1-C60)alkyl, (C1-C60)alkoxy, (C6-C60)aryl, (C4-C60)heteroaryl and halogen; 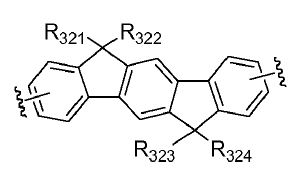 wherein, R₃₂₁, R₃₂₂, R₃₂₃ and R₃₂₄ independently represent hydrogen, (C1-C60)alkyl, (C1-C60)alkoxy, (C6-C60)aryl, (C4-C60)heteroaryl or halogen, or may be linked to an adjacent substituent via (C3-C60)alkylene or (C3-C60)alkenylene with or without a fused ring to form an alicyclic ring, or a monocyclic or polycyclic aromatic ring.

The organic compounds or organometallic compounds with EL peak having the wavelength of not more than 560 nm can be specifically exemplified by the following compounds, but are not restricted thereto.

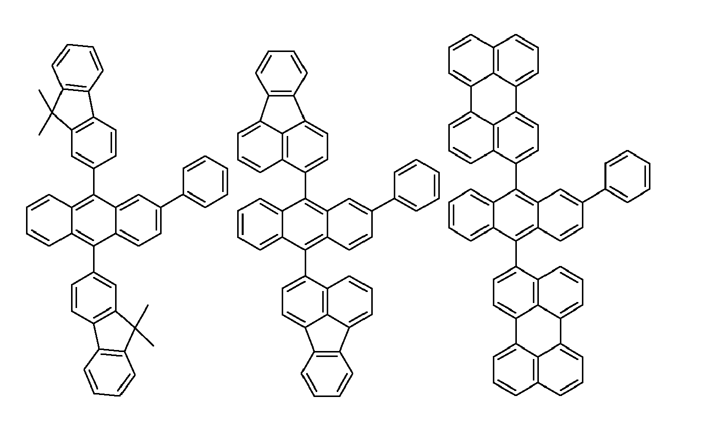

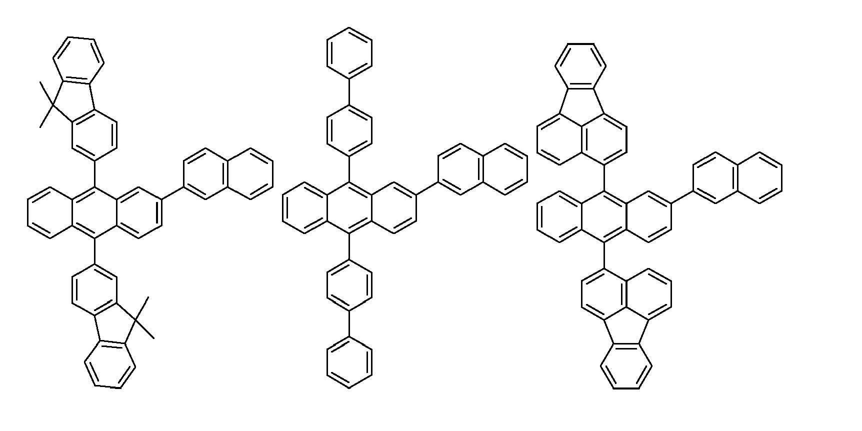

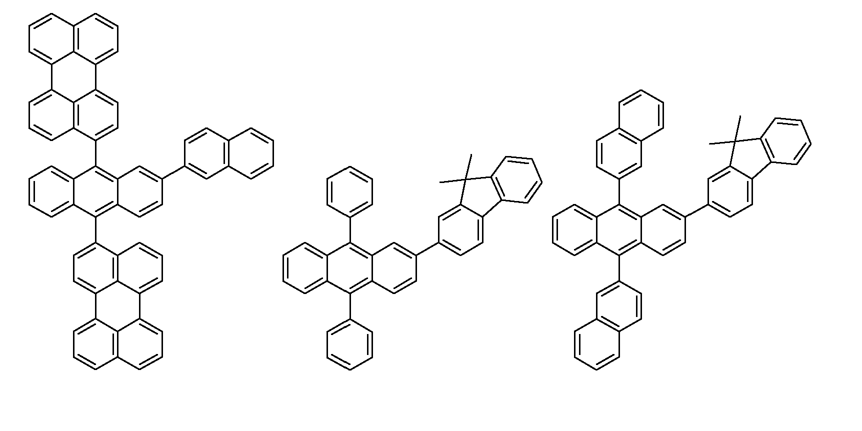

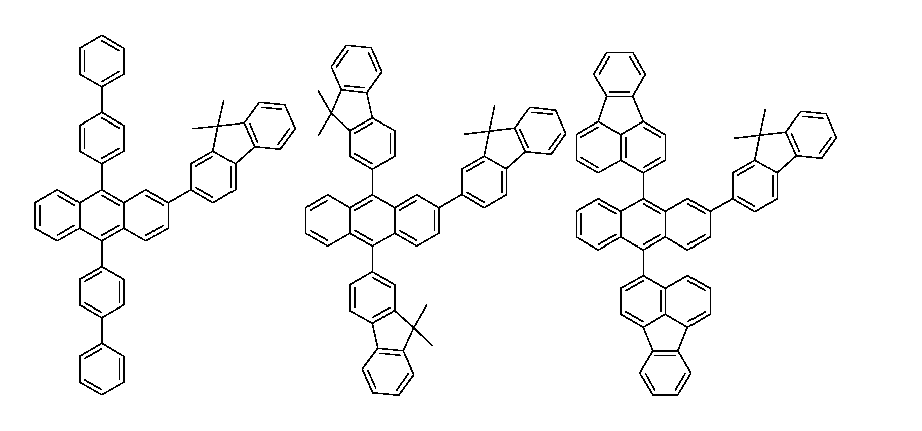

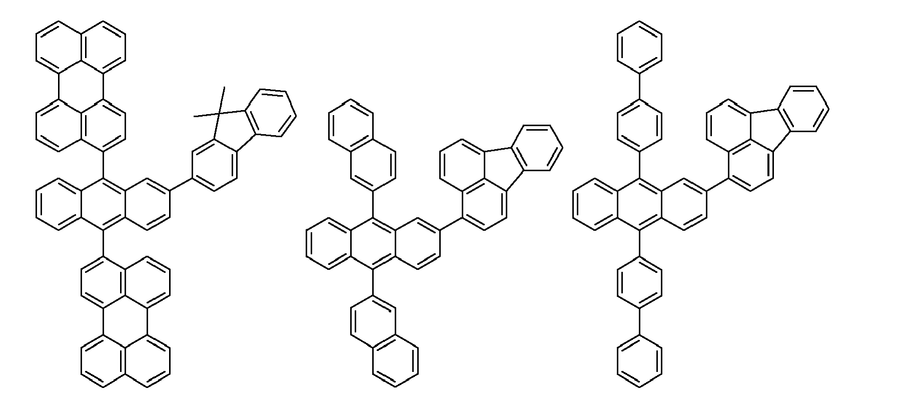

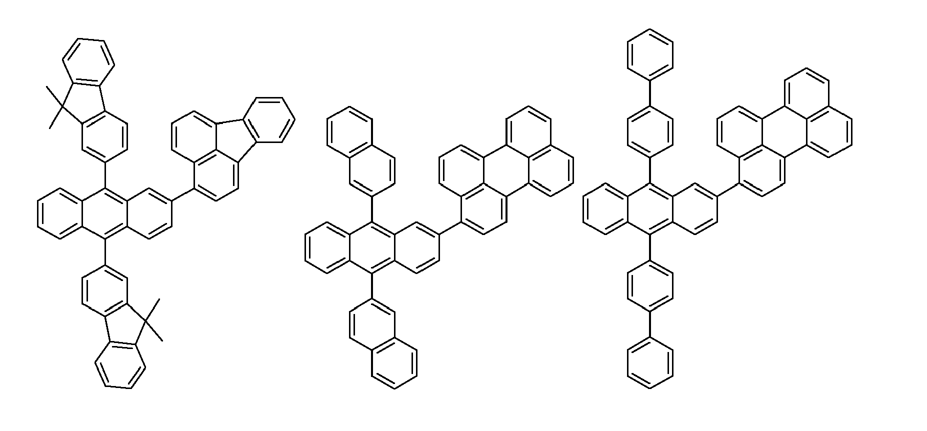

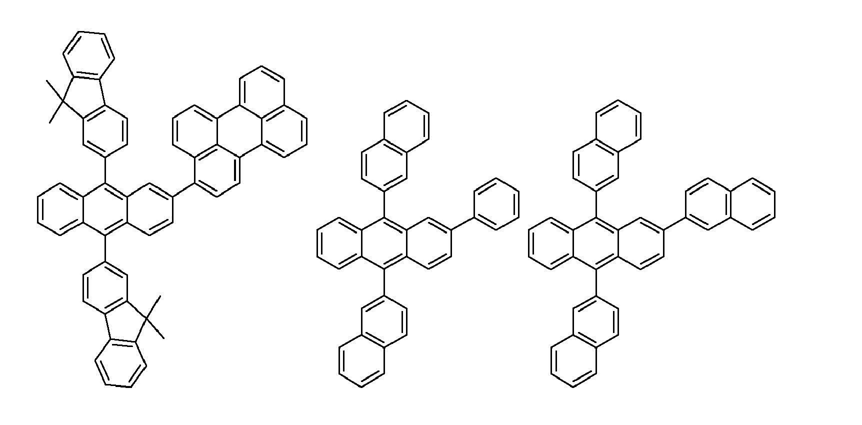

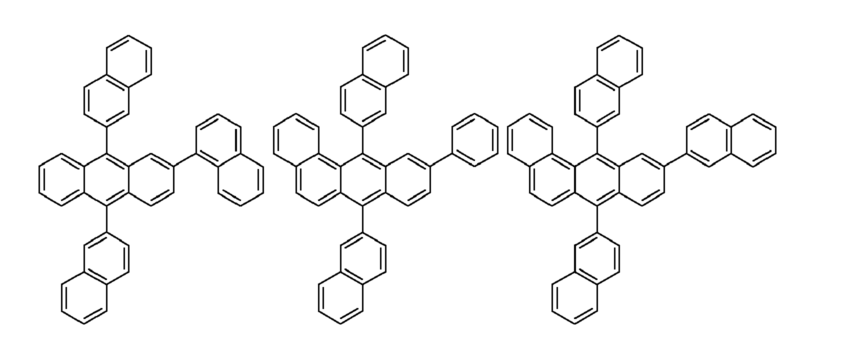

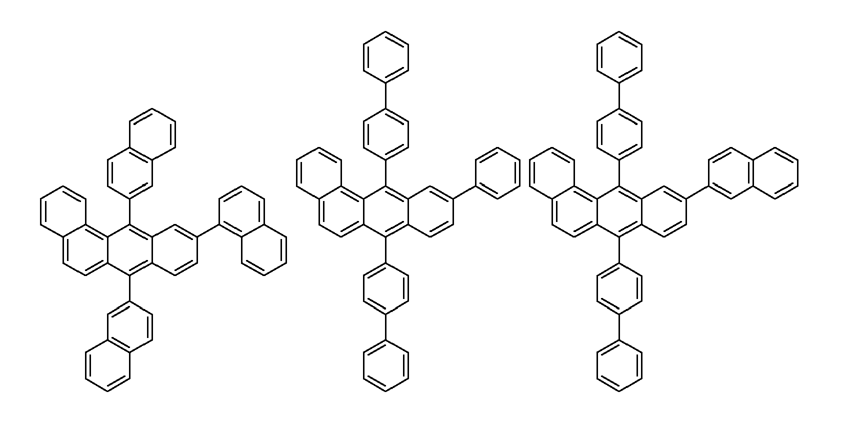

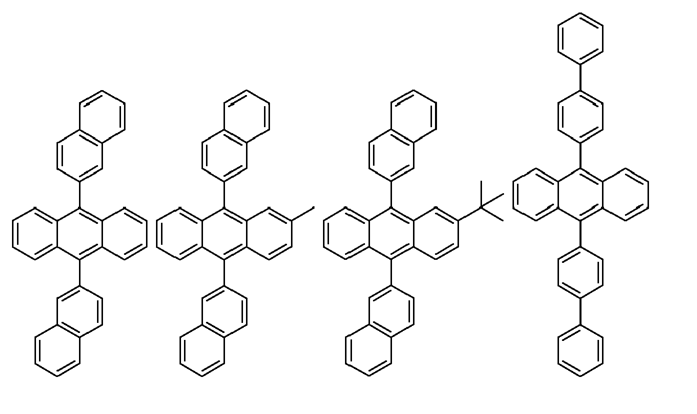

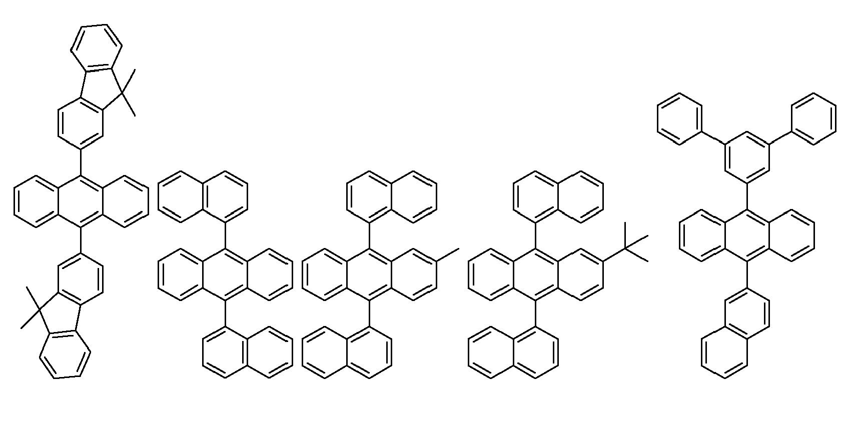

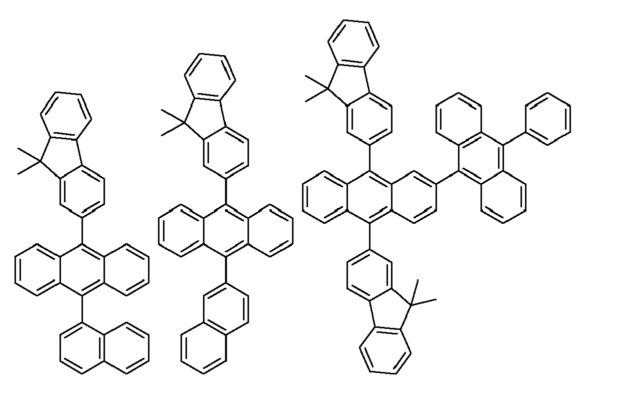

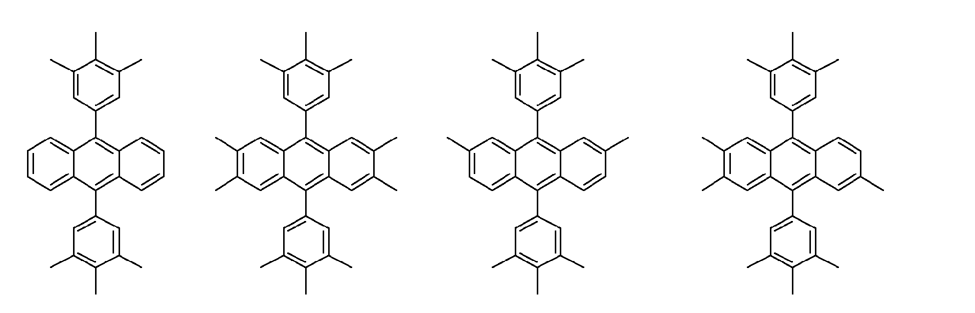

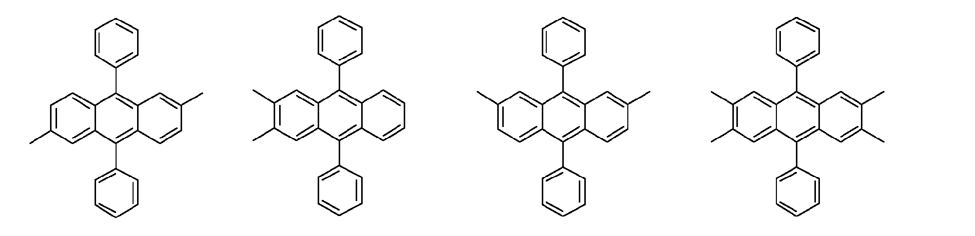

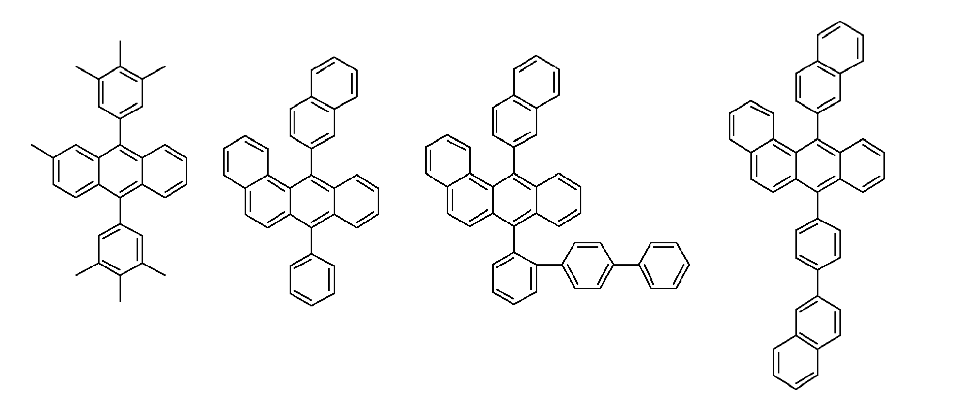

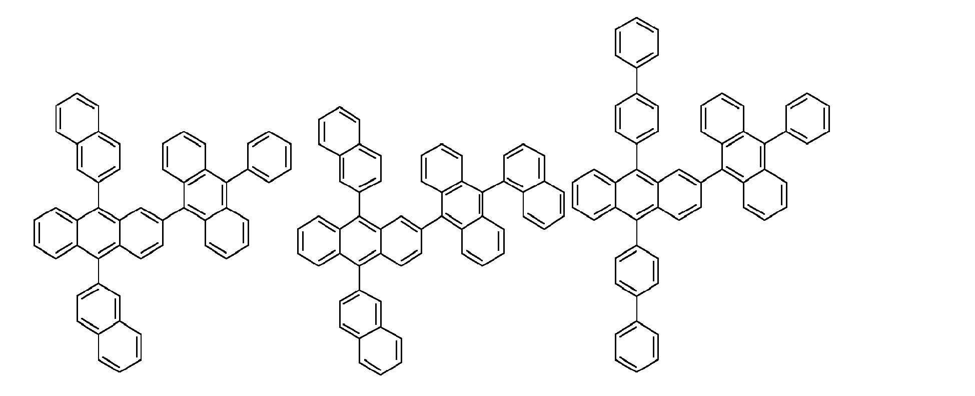

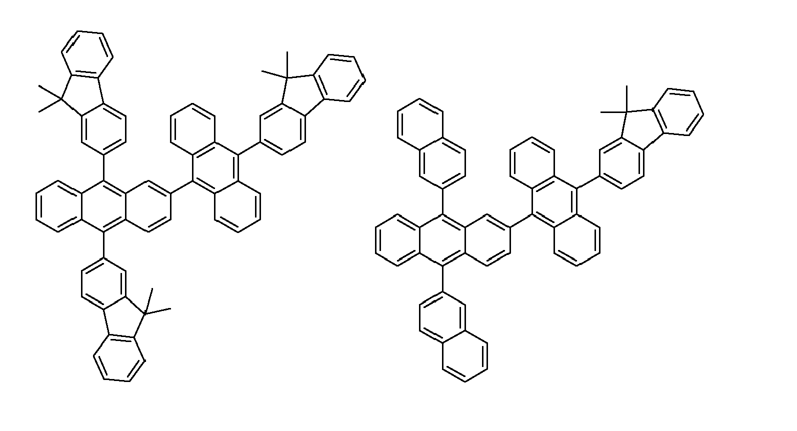

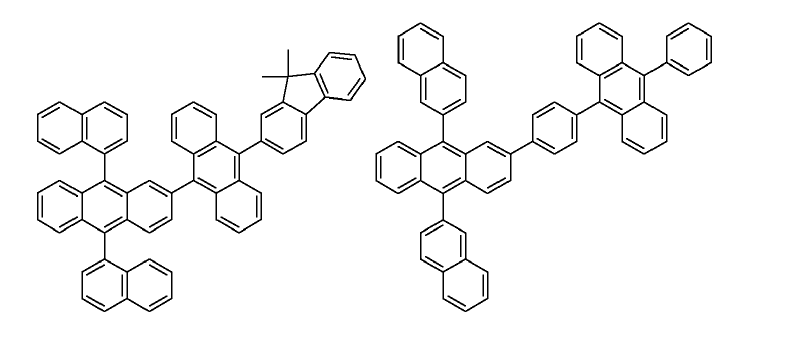

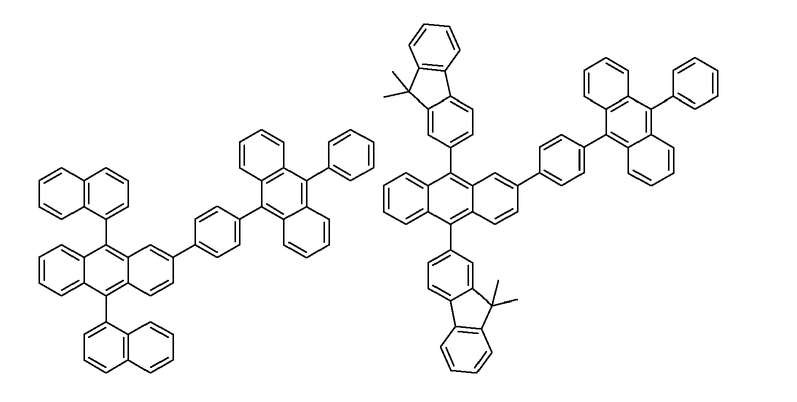

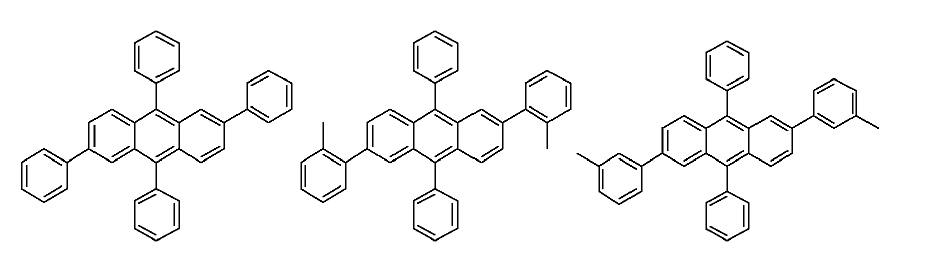

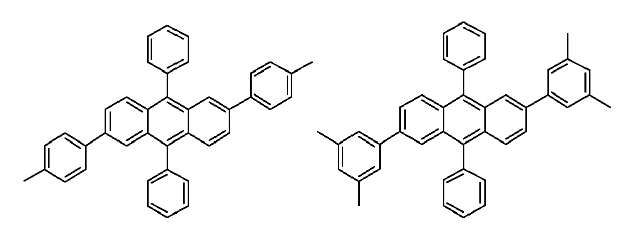

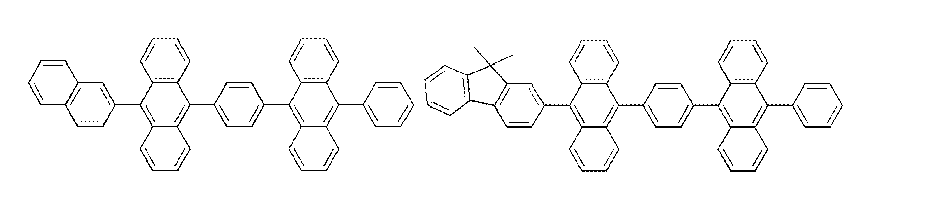

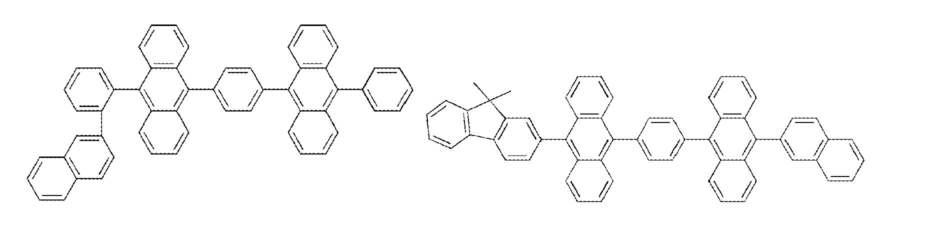

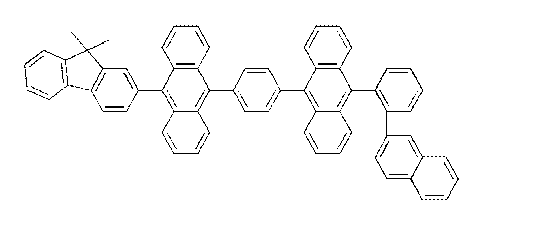

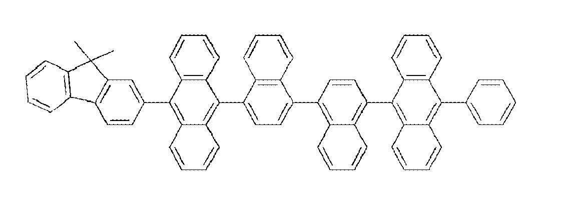

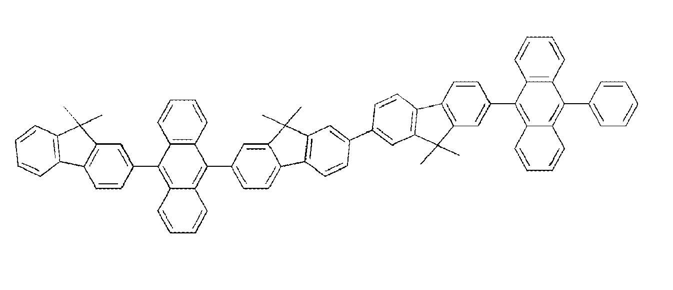

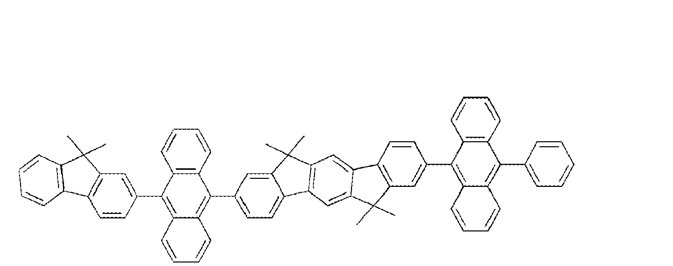

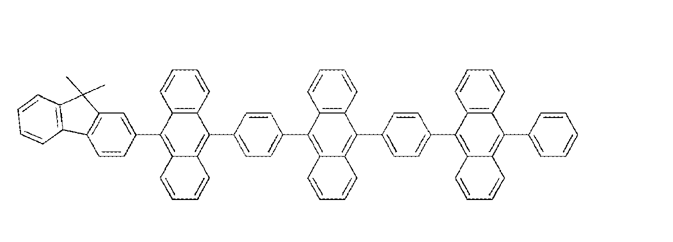

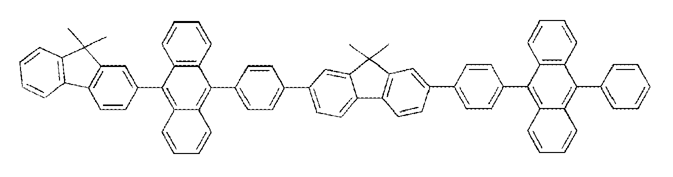

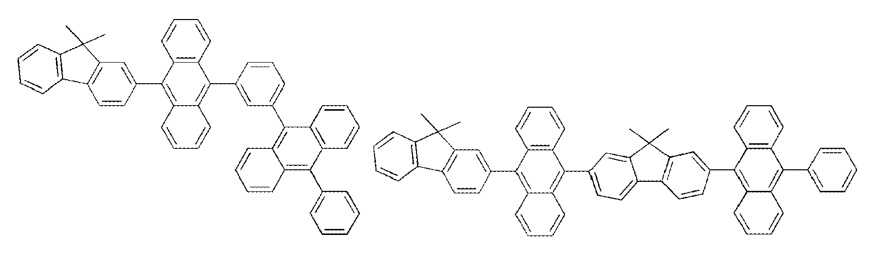

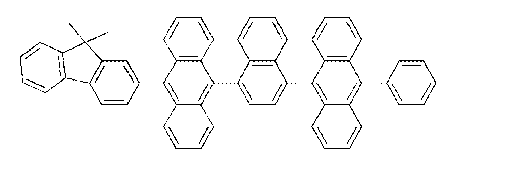

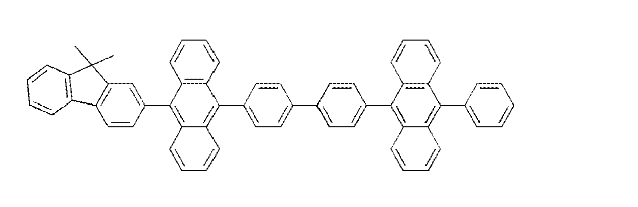

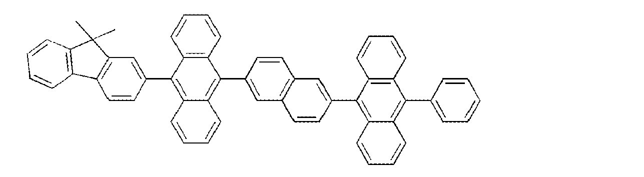

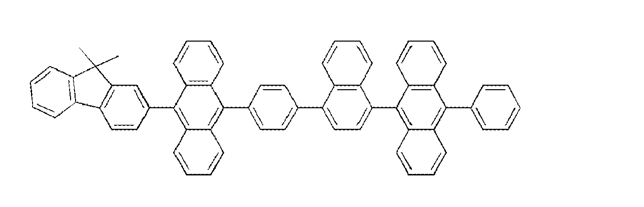

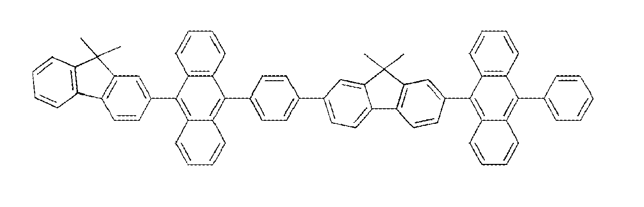

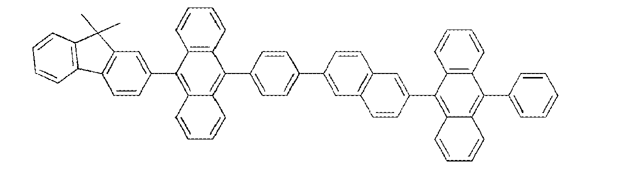

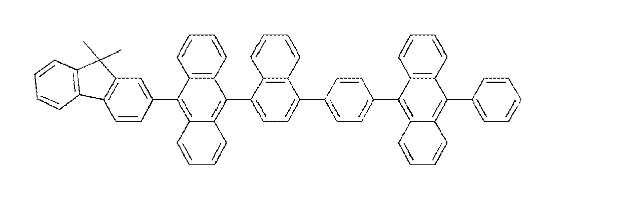

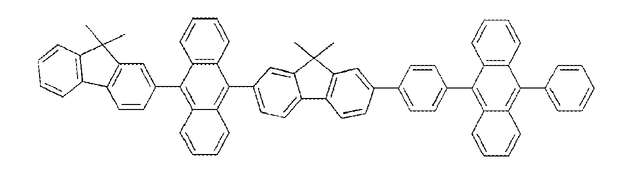

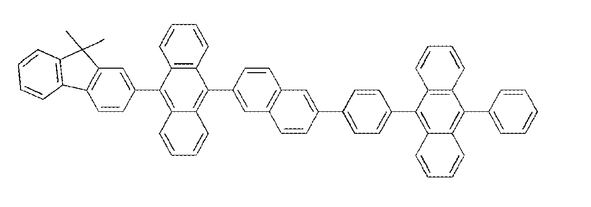

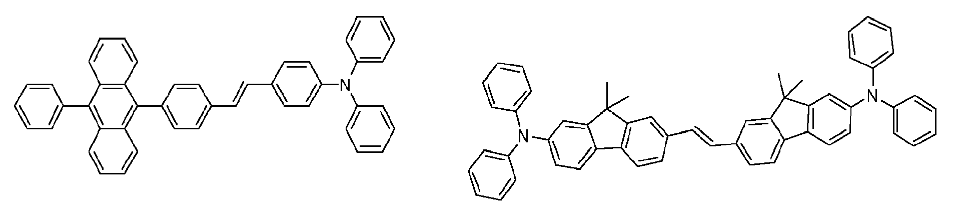

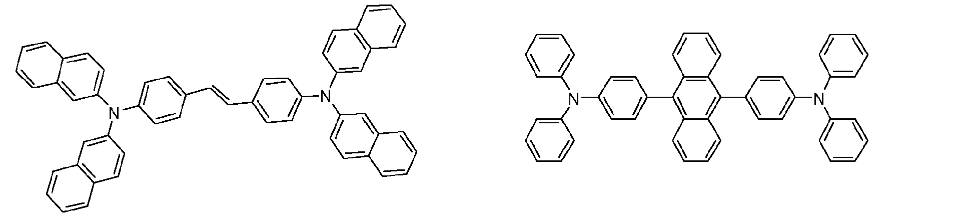

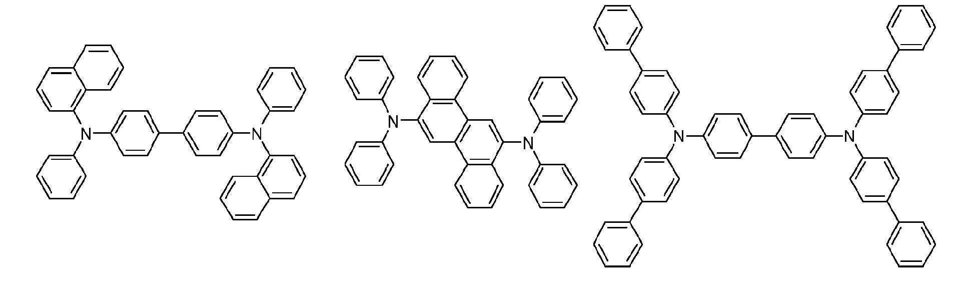

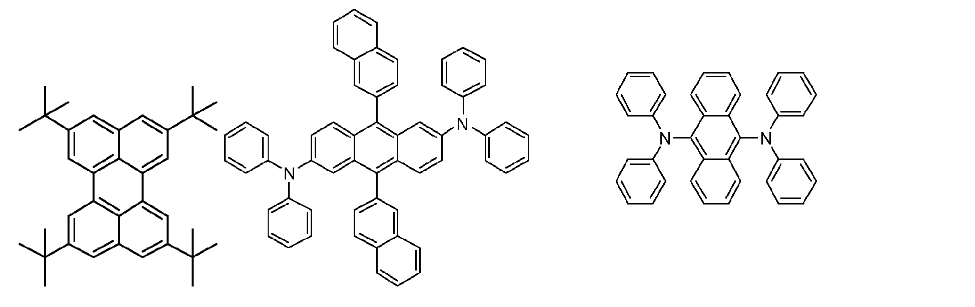

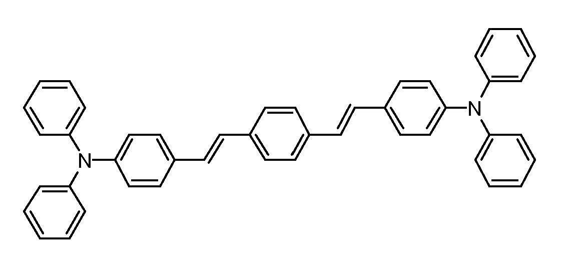

In an electroluminescent device according to the invention, it is preferable to displace one or more layer(s) (hereinafter, referred to as the "surface layer") selected from chalcogenide layers, halogenated metal layers and metal oxide layers, on the inner surface of at least one side of the pair of electrodes. Specifically, it is preferable to arrange a chalcogenide layer of silicon and aluminum metal (including oxides) on the anode surface of the EL medium layer, and a halogenated metal layer or metal oxide layer on the cathode surface of the EL medium layer. As the result, stability in operation can be obtained.

Examples of chalcogenides preferably include SiOₓ (1≤X≤2), AlOₓ (11≤X≤1.5), SiON, SiAlON, or the like. Examples of halogenated metals preferably include LiF, MgF₂, CaF₂, fluorinated lanthanides or the like. Examples of metal oxides preferably include Cs₂O, Li₂O, MgO, SrO, BaO, CaO, or the like.

In an organic electroluminescent device according to the present invention, it is also preferable to arrange on at least one surface of the pair of electrodes thus manufactured a mixed region of electron transport compound and a reductive dopant, or a mixed region of a hole transport compound with an oxidative dopant. Accordingly, the electron transport compound is reduced to an anion, so that injection and transport of electrons from the mixed region to an EL medium are facilitated. In addition, since the hole transport compound is oxidized to form a cation, injection and transport of holes from the mixed region to an EL medium are facilitated. Preferable oxidative dopant include various Lewis acids and acceptor compounds. Preferable reductive dopants include alkali metals, alkali metal compounds, alkaline earth metals, rare-earth metals, and mixtures thereof.

### Advantageous Effects

The electroluminescent compounds according to the invention, as being employed as host material of phosphorescent material in an OLED, can noticeably lower the operation voltage and increase current efficiency to provide considerable enhancement in power efficiency.

The present invention is further described with respect to novel electroluminescent compounds according to the invention, processes for preparing the same, and luminescent properties of devices employing the same, by referring to Examples and Preparation Examples, which are provided for illustration only but are not intended to limit the scope of the invention by any means.

### Preparation Example 1 - Preparation of Compound (1)

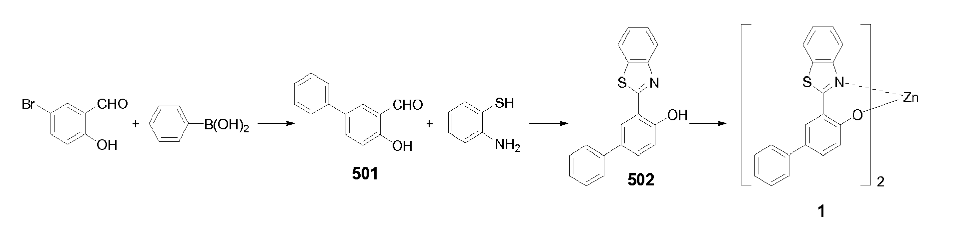

### Preparation of Compound (501)

In dimethylethylene glycol (200 mL) and ethanol (100 mL), dissolved were 5-bromo-2-hydroxybenzaldehyde (20.0 g, 99.5 mmol), phenylboronic acid (13.4 g, 109.5 mmol), tetrakispalladium (0) triphenylphosphine (Pd(PPh₃)₄) (5.8 g, 5.0 mmol). After adding aqueous 2M potassium carbonate solution (132 mL) thereto, the resultant mixture was stirred under reflux at 90 for 4 hours. When the reaction was completed, water (100 mL) was added to the reaction mixture to quench the reaction. The mixture was extracted with ethyl acetate (200 mL) and dried under reduced pressure. Purification via silica gel column chromatography (n-Hexane: MC = 1:5) gave Compound (501) (12.0 g, 61.0 mmol).

### Preparation of Compound (502)

In 1,4-dioxane (12 mL), dissolved were 2-aminobenzenethiol (3.8 g, 30.2 mmol) and Compound (501) (5.0 g, 25.2 mmol), and the solution was stirred under pressure at 100 for 12 hours. When the reaction was completed, the reaction mixture was cooled to room temperature, extracted with dichloromethane (100 mL) and water (100 mL), and dried under reduced pressure. Purification via silica gel column chromatography (n-Hexane: MC = 3:1) gave Compound (502) (4.5 g, 4.8 mmol).

### Preparation of Compound (1)

In ethanol (100 mL), dissolved were Compound (502) (4.5 g, 14.8 mmol) and sodium hydroxide (0.6 g, 14.8 mmol). After stirring the solution for 30 minutes, Zn(CH₃COO)_{2·}2H₂O (1.8 g, 8.2 mmol) was slowly added thereto. Then the mixture was stirred for 12 hours at room temperature. When the reaction was completed, the reaction mixture was washed with water (200 mL), ethanol (200 mL) and hexane (200 mL) sequentially, and dried under reduced pressure to obtain the title compound (1) (4.5 g, 6.7 mmol, 45%).

### Preparation Example 2 - Preparation of Compound (160)

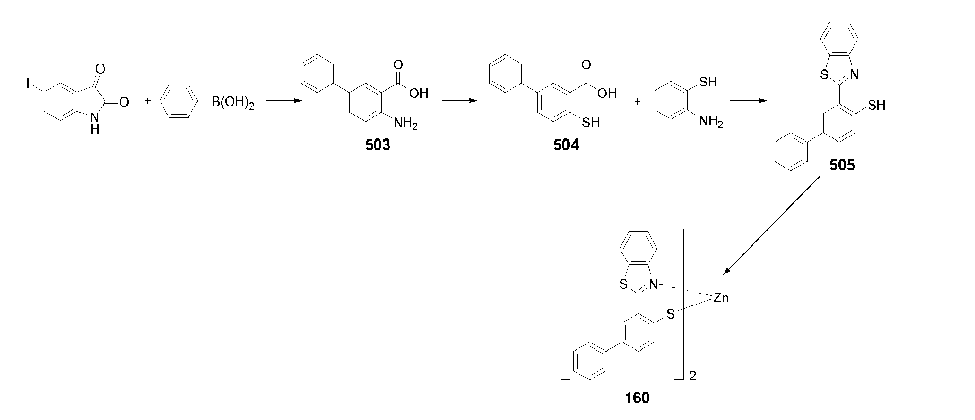

### Preparation of Compound (503)

In dimethylene glycol (600 mL) dissolved were 5-iodoindoline-2,3-dione (10.0 g, 36.6 mmol) and phenylboronic acid (5.4 g, 43.9 mmol), and tetrakis palladium (0) triphenylphosphine (Pd(PPh3)4) (2.1 g, 1.8 mmol) and aqueous 2M sodium hydrocarbonate solution (120 mL) were added thereto. The resultant mixture was stirred under reflux for 12 hours. When the reaction was completed, solvent was removed. To the residue, aqueous 5% sodium hydroxide solution (120 mL) was added, and the mixture was stirred at room temperature. The aqueous solution was extracted with dichloromethane. The aqueous portions were combined, and aqueous 30% hydrogen peroxide (120 mL) was added thereto. The resultant mixture was warmed to 50 , and stirred for 30 minutes. After cooling to room temperature, aqueous 1N hydrochloric acid solution was slowly added to the aqueous solution to adjust the pH 4. The solid generated was filtered and dried under reduced pressure to obtain Compound (503) (5.5 g, 26.0 mmol).

### Preparation of Compound (504)

Compound (503) (7.1 g, 33.3 mmol) was dissolved in water (18 mL) and concentrated hydrochloric acid (7 mL), and the solution was stirred at room temperature. After 10 minutes, the temperature was lowered to 0 , and sodium nitrate (NaNO3) (2.3 g, 33.3 mmol) dissolved in water (10 mL) was slowly added. Then the mixture was stirred while maintaining the temperature at 0. In another reaction vessel, sodium sulfide nonahydrate (Na₂S·9H₂O) (9.6 g, 39.9 mmol) and sulfur (1.3 g, 39.9 mmol) were dissolved in water (10 mL), and aqueous 10M sodium hydroxide solution (4 mL) was added to the solution. The mixture obtained was added to the reaction mixture at 0 , warmed to room temperature, and stirred until the gas was not generated any more. When the reaction was completed, concentration hydrochloric acid was added to generate solid, which was then collected by filtration under reduced pressure. The solid obtained was added to aqueous sodium hydrocarbonate (NaHC03) solution (85 mL), and the mixture was stirred under reflux for 20 minutes. After cooling to room temperature, the solid not dissolved (impurities) was removed, and concentrated hydrochloric acid was added to the aqueous solution to form solid again. The solid obtained from filtration under reduced pressure was then added to ethanol (30 mL), and the mixture was stirred under reflux for 20 minutes. The solid not dissolved (impurities) was removed, and the filtrate was concentrated. Zinc (2.2 g, 33.3 mmol) and glacial acetic acid (30 mL) were added, and the mixture was stirred under reflux for 48 hours. When the reaction was completed, the reaction mixture was cooled to room temperature, and the solid generated was collected and added to aqueous 5M sodium hydroxide solution (63 mL). After stirring the mixture under reflux for 30 minutes, the solid not dissolved (impurities) was removed, and concentrated hydrochloric acid was added by small portions to the aqueous solution to acidify the solution. The solid generated was then collected and added to ethanol (20 mL), and the mixture was stirred under reflux for 30 minutes. The solid not dissolved (impurities) was removed, and the filtrate was concentrated to give Compound (504) (1.8 g, 7.6 mmol).

### Preparation of Compound (505)

In a reaction vessel, Compound (504) (5.0 g, 21.7 mmol), 2-aminobenzenethiol (2.1 mL, 19.5 mmol) and polyphosphoric acid (20 g) were stirred under reflux at 140 for 24 hours. When the reaction was completed, the mixture was cooled to room temperature, and the pH was adjusted to be neutral by slowly adding saturated aqueous sodium hydroxide solution. The solid generated was filtered under reduced pressure to obtain solid. The solid thus obtained was washed with ethanol and filtered to obtain Compound (505) (5.4 g, 17.1 mmol).

### Preparation of Compound (160)

In ethanol (100 mL), dissolved were Compound (505) (5.0 g, 15.6 mmol) and sodium hydroxide (0.6 g, 15.6 mmol), and the solution was stirred for 30 minutes. To the solution, Zn(CH3COO)2·2H2O (1.9 g, 8.7 mmol) was slowly added, and the mixture was stirred for 12 hours. The reaction mixture was then washed with water (200 mL), ethanol (200 mL) and hexane (200 mL) sequentially, and dried under reduced pressure to obtain the title compound (160) (7.1 g, 10.1 mmol, 65%).

### Preparation Example 3 - Preparation of Compound (319)

Compound (502) (4.5 g, 14.8 mmol) and aluminum isopropoxide (3.0 g, 14.8 mmol) were dissolved in chloroform (50 mL)/isopropylalcohol (150 mL), and the solution was stirred at 60 for 3 hours. When the solution became clear, 4-phenylphenol (3.0 g, 17.8 mmol) was added thereto, and the mixture was stirred under reflux at 80 for 3 hours. Compound (502) (4.5 g, 14.8 mmol) was further added thereto, and the resultant mixture was stirred under reflux for 12 hours. When the reaction was completed, the reaction mixture was cooled to temperature, and the solid generated was filtered under reduced pressure. The solid was then washed with isopropyl alcohol (500 mL), methanol (300 mL) and ethyl ether (250 mL), sequentially to obtain the title compound (319) (3.8 g, 7.6 mmol, 51%).

According to the same procedure as Preparation Examples 1 to 3, Compounds (1) to (408) were prepared, of which ¹H NMR and MS/FAB data are shown in Table 4.

**Table 4**

| Compound No. | ¹H NMR (CDCl₃, 200 MHz) | MS/FAB | |
|---|---|---|---|
| | | found | calculated |
| **1** | δ = 6.85(d, 2H), 7.22-7.32(m, 8H), 7.48-7.55(m, 10H), 8.12-8.23(dd, 4H) | 668.1 | 670.1 |
| **3** | δ = 6.85(m, 2H), 7.27-7.38(m, 8H), 7.54-7.67(m, 14H), 8.13-8.25(m, 4H) | 668.1 | 670.1 |
| **5** | δ = 6.85(m, 2H), 7.27-7.32(m, 8H), 7.48-7.55(m, 18H), 8.12-8.23(m, 4H) | 704.0 | 706.1 |
| **7** | δ = 7.03-7.10(m, 8H), 7.37(m, 2H), 7.46-7.55(m, 8H), 8.12-8.25(m, 4H) | 704.0 | 706.1 |
| **9** | δ = 6.85(m, 2H), 7.27-7.32(m, 8H), 7.48-7.55(m, 18H), 8.12-8.23(m, 4H) | 820.1 | 822.3 |
| **11** | δ = 7.05(m, 2H), 7.10(m, 2H), 7.22(m, 2H), 7.32-7.37(m, 6H), 7.46-7.56(m, 16H), 8.12(d, 2H), 8.23(d, 2H) | 820.1 | 822.3 |
| **14** | δ = 1.34(s, 18H), 6.85(m, 2H), 7.27(m, 2H), 7.35-7.40(m, 8H), 7.53-7.56(m, 6H), 8.12-8.23(dd, 4H) | 780.2 | 782.3 |
| **15** | δ = 1.34(s, 18H), 7.01-7.10(m, 4H), 7.35-7.40(m, 10H), 7.55(m, 4H), 8.14-8.25(m, 4H) | 780.2 | 782.3 |
| **18** | δ = 6.64(m, 2H), 6.85(m, 2H), 6.96(m, 4H), 7.27(m, 2H), 7.53-7.55(m, 6H), 8.24-8.25(m, 4H) | 740.0 | 742.1 |
| **21** | δ = 6.74-6.85(m, 6H), 7.27(m, 2H), 7.44(m, 2H), 7.53-7.55(m, 6H), 8.12-8.23(m, 4H) | 740.0 | 742.1 |
| **26** | δ = 6.51(m, 4H), 6.85(m, 2H), 7.27(m, 2H), 7.52-7.54(m, 6H), 8.12(m, 2H), 8.24(m, 2H) | 776.0 | 778.1 |
| **81** | δ = 6.46-6.52(m, 12H), 6.62(m, 4H), 7.01(m, 12H), 7.23(m, 4H), 7.37(m, 2H), 7.55(m, 4H), 8.12(m, 2H), 8.23(m, 2H) | 1002.2 | 1004.5 |
| **82** | δ = 6.46-6.52(m, 12H), 6.62(m, 4H), 6.85(m, 2H), 7.01(m, 8H), 7.23-7.27(m, 6H), 7.53-7.55(m, 6H), 8.23-8.25(m, 4H) | 1002.2 | 1004.5 |
| **85** | δ = 6.85(m, 2H), 7.27-7.32(m, 6H), 7.52-7.56(m, 8H), 7.67-7.73(m, 6H), 7.89(m, 2H), 8.12-8.23(m, 4H) | 768.1 | 770.2 |
| **91** | δ = 6.85(m, 2H), 7.27-7.38(m, 8H), 7.54-7.67(m, 14H), 8.13-8.25(m, 4H) | 768.1 | 770.2 |
| **93** | δ = 1.67(s, 12H), 7.27-7.28(m, 4H), 7.38(m, 2H), 7.55-7.60(m, 10H), 7.77(m, 2H), 7.84-7.90(m, 4H), 8.13-8.25(m, 4H) | 900.2 | 902.4 |
| **106** | δ = 6.85(m, 2H), 7.27(m, 2H), 7.36(m, 18H), 7.53-7.60(m, 26H), 8.15-8.25(m, 4H) | 1184.2 | 1186.9 |
| **107** | δ = 7.01(s, 2H), 7.10(m, 2H), 7.36-7.37(m, 20H), 7.54-7.60(m, 24H), 8.12(d, 2H), 8.24(d, 2H) | 1184.2 | 1186.9 |
| **143** | δ = 6.79-6.88(m, 4H), 7.05(m, 2H), 7.22-7.32(m, 8H), 7.48(m, 4H), 7.77(m, 2H), 8.29-8.34(m, 4H) | 668.1 | 670.1 |
| **144** | δ = 6.79-6.88(m, 4H), 7.05(m, 2H), 7.22-7.32(m, 8H), 7.48(m, 4H), 7.77(m, 2H), 8.18(m, 2H), 8.45(m, 2H) | 668.1 | 670.1 |
| **145** | δ = 7.79(m, 2H), 6.88(m, 2H), 7.05(m, 2H), 7.31-7.32(m, 8H), 7.48-7.54(m, 12H), 7.77(m, 2H), 8.18(m, 2H), 8.43(m, 2H) | 820.1 | 822.3 |
| **146** | δ = 6.78-6.80(m, 4H), 7.04(m, 2H), 7.22(m, 2H), 7.31-7.32(m, 6H), 7.48-7.54(m, 12H), 7.77(m, 2H), 8.30-8.33(m, 4H) | 820.1 | 822.3 |
| **147** | δ = 1.36(s, 18H), 6.78-6.89(m, 4H), 7.05(m, 2H), 7.31-7.40(m, 10H), 7.78(m, 2H), 8.20(m, 2H), 8.50(m, 2H) | 780.2 | 782.3 |
| **148** | δ = 1.34(s, 18H), 6.70(m, 2H), 6.88(m, 2H), 7.07(m, 2H), 7.31-7.40(m, 10H), 7.77(m, 2H), 8.28-8.32(m, 4H) | 780.2 | 782.3 |
| **149** | δ = 6.80-6.90(m, 4H), 7.03-7.05(m, 6H), 7.31(m, 2H), 7.46(m, 4H), 7.77(m, 2H), 8.18(m, 2H), 8.45(m, 2H) | 704.0 | 706.1 |
| **150** | δ = 6.80-6.90(m, 4H), 7.03-7.08(m, 6H), 7.31(m, 2H), 7.46(m, 4H), 7.77(m, 2H), 8.29-8.34(m, 4H) | 704.0 | 706.1 |
| **151** | δ = 6.79(m, 2H), 6.88(m, 2H), 7.05(m, 2H), 7.31-7.36(m, 20H), 7.54-7.60(m, 20H), 7.77(m, 2H), 8.18(m, 2H), 8.46(m, 2H) | 1184.2 | 1186.9 |
| **152** | δ = 6.79(m, 2H), 6.88(m, 2H), 7.05(m, 2H), 7.31-7.36(m, 20H), 7.54-7.60(m, 20H), 7.77(m, 2H), 8.30-8.34(m, 4H) | 1184.2 | 1186.9 |
| **153** | δ = 6.46-6.52(m, 12H), 6.62(m, 4H), 6.79(m, 2H), 6.88(m, 2H), 7.01-7.05(m, 10H), 7.23-7.31(m, 6H), 7.77(m, 2H), 8.18(m, 2H), 8.46(m, 2H) | 1002.2 | 1004.5 |
| **154** | δ = 6.46-6.52(m, 12H), 6.62(m, 4H), 6.79-6.88(m, 4H), 7.01-7.05(m, 10H), 7.23(m, 4H), 7.31(m, 2H), 7.77(m, 2H), 8.30-8.34(m, 4H) | 1002.2 | 1004.5 |
| **160** | δ = 8.23 (d, 2H), 8.13(d, 2H), 7.55-7.20(m, 20H) | 700.1 | 700.0 |
| **173** | δ =1.34(s, 18H), 7.28-7.30(m, 4H), 7.35-7.40(m, 4H), 7.54(m, 6H), 8.12(m, 2H), 8.23(m, 2H) | 814.1 | 812.1 |
| **176** | δ =6.64(m, 2H), 6.96(m, 4H), 7.32-7.38(m, 4H), 7.55(m, 4H), 8.12(m, 2H), 8.23(m, 2H) | 773.9 | 771.9 |
| **205** | δ =2.35(s, 12H), 6.82(d, 2H), 7.09(s, 4H), 7.28-7.30(m, 4H), 7.55(m, 6H), 8.15-8.24(m, 4H) | 758.0 | 756.1 |
| **241** | δ =6.46-6.52(m, 12H), 6.62(m, 4H), 7.02(m, 8H), 7.24-7.30(m, 8H), 7.56(m, 6H), 8.13(t, 2H), 8.23(t, 2H) | 1035.1 | 1034.2 |
| **265** | δ =7.30-7.36(m, 22H), 7.54-7.60(m, 26H), 8.12(m, 2H), 8.24(m, 2H) | 1219.2 | 1216.3 |
| **269** | δ =2.34(s, 6H), 6.86(m, 2H), 7.12(d, 4H), 7.57(m, 4H), 8.13-8.25(m, 4H) | 577.9 | 575.9 |
| **273** | δ =2.36(s, 12H), 6.70(s, 2H), 6.85(s, 2H), 7.55(m, 4H), 8.14-8.25(m, 4H) | 606.0 | 604.5 |
| **293** | δ =2.36(s, 6H), 7.08(s, 4H), 7.22(m, 2H), 7.32(m, 4H), 7.48(m, 8H), 8.20(m, 4H) | 730.0 | 728.4 |
| **302** | δ =7.06-7.10(m, 4H), 7.24-7.32(m, 10H), 7.48(m, 4H), 7.77(m, 2H), 8.29-8.34(m, 4H) | 702.1 | 700.1 |
| **318** | δ =7.06-7.12(m, 4H), 7.22-7.34(m, 10H), 7.48(m, 4H), 8.00(s, 2H) | 601.9 | 599.9 |
| **319** | δ =6.79-6.85(m, 4H), 7.27-7.32(m, 18H), 7.48-7.56(m, 12H), 8.12-8.25(m, 4H) | 801.2 | 800.2 |
| **323** | δ =6.79-6.85(m, 4H), 7.03(m, 4H), 7.22-7.32(m, 7H), 7.46-7.56(m, 12H), 8.14-8.25(m, 4H) | 837.2 | 836.2 |
| **332** | δ =1.37(s, 18H), 6.79-6.90(m, 4H), 7.22-7.40(m, 15H), 7.48-7.55(m, 8H), 8.14-8.25(m, 4H) | 913.3 | 912.3 |
| **341** | δ =2.37(s, 6H), 6.79(d, 2H), 6.94-7.02(m, 4H), 7.20-7.32(m, 15H), 7.48-7.55(m, 6H), 8.15-8.23(m, 4H) | 829.2 | 828.2 |
| **344** | δ =2.38(s, 12H), 6.79-6.84(m, 6H), 7.09(s, 4H), 7.19-7.34(m, 7H), 7.48-7.54(m, 8H), 8.13-8.26(m, 4H) | 857.2 | 856.2 |
| **347** | δ =2.24(s, 6H), 6.85(m, 4H), 7.12(m, 4H), 7.28-7.32(m, 11H), 7.49-7.55(m, 8H), 8.21(m, 4H) | 829.2 | 828.2 |
| **380** | δ =6.46-6.52(m, 12H), 6.62(m, 4H), 6.80(m, 4H), 7.01(m, 8H), 7.20-7.33(m, 11H), 7.50-7.54(m, 8H), 8.10-8.20(m, 4H) | 1135.3 | 1134.3 |
| **383** | δ =6.79(m, 4H), 6.88(m, 2H), 7.05(m, 2H), 7.20-7.35(m, 13H), 7.48(m, 6H), 7.77(m, 2H), 8.29-8.34(m, 4H) | 800.9 | 800.1 |
| **398** | δ =6.79(m, 4H), 6.88(m, 2H), 7.05(m, 2H), 7.22(m, 1H), 7.31-7.36(m, 11H), 7.48-7.54(m, 14H), 7.83(m, 2H), 8.33(dd, 2H), 8.46(m, 2H) | 1165.5 | 1164.2 |
| **399** | δ =6.79(m, 4H), 6.88(m, 2H), 7.05(m, 2H), 7.22-7.32(m, 13H), 7.48(m, 6H), 8.01(s, 2H) | 700.8 | 700.1 |
| **404** | δ =6.79-6.85(m, 4H), 7.21-7.33(m, 12H), 7.50-7.55(m, 11H), 7.67-7.73(m, 3H), 7.89(s, 1H), 8.12-8.23(m, 4H) | 851.1 | 850.1 |
| **405** | δ =6.79-7.85(m, 4H), 7.25-7.38(m, 13H), 7.49-7.67(m, 14H), 8.13-8.21(m, 4H) | 851.1 | 850.1 |
| **406** | δ =1.67(s, 6H), 6.79-6.85(m, 4H), 7.22-7.38(m, 12H), 7.49-7.56(m, 12H), 7.77(d, 1H), 7.84-7.90(m, 2H), 8.12(m, 2H), 8.23(m, 2H) | 917.0 | 916.2 |
| **407** | δ =6.85(m, 2H), 6.97-6.98(m, 2H), 7.23-7.32(m, 11H), 7.48-7.62(m, 15H), 7.85(d, 1H), 8.13-8.25(m, 4H) | 850.9 | 850.1 |
| **408** | δ =1.68(s, 6H), 6.85(t, 3H), 7.02(d, 1H), 7.22-7.32(m, 11H), 7.48-7.67(m, 14H), 7.77(d, 1H), 7.90(d, 1H), 8.13-8.26(m, 4H) | 917.0 | 916.2 |

Examples 1-23 - Manufacture of OLEDs using the EL compounds according to the invention.

OLED devices were manufactured by using the EL compounds according to the invention as host material. The cross-sectional view of the OLED is shown in Fig. 1.

First, a transparent electrode ITO thin film (15 Ω/□) (2) obtained from a glass for OLED (produced by Samsung Corning) was subjected to ultrasonic washing with trichloroethylene, acetone, ethanol and distilled water, sequentially, and stored in isopronanol before use.

Then, an ITO substrate was equipped in a substrate folder of a vacuum vapor-deposit device, and 4,4',4"-tris(N,N-(2-naphthyl)-phenylamino)triphenylamine (2-TNATA) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injection layer (3) having 60 nm of thickness on the ITO substrate.

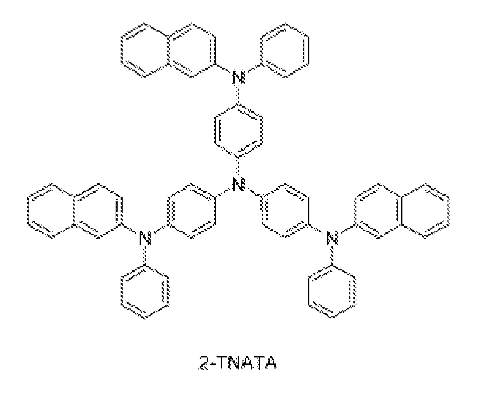

Then, to another cell of the vacuum vapor-deposit device, charged was N,N'-bis(α-naphthyl)-N,N'-diphenyl-4,4'-diamine (NPB), and electric current was applied to the cell to evaporate NPB, thereby providing vapor-deposit of a hole transport layer (4) of 20 nm of thickness on the hole injection layer.

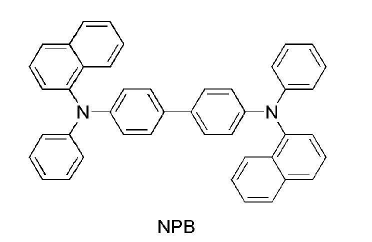

In one cell of the vacuum vapor-deposit device, charged was a compound according to the present invention which had been purified by vacuum sublimation under 10⁻⁶ torr (for example, Compound 1), as host material, and an EL dopant (for example, (pip)₂Ir(acac)) was charged to another cell. The two materials were evaporated at different rates to carry out doping at a concentration of 4 to 10 mol% and vapor-deposit an electroluminescent layer (5), with 30 nm of thickness on the hole transport layer.

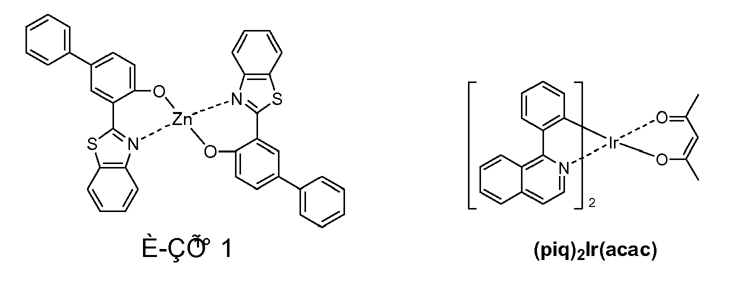

Then, tris(8-hydroxyquinoline)aluminum (III) (Alq) was vapor-deposited as an electron transportation layer (6) in a thickness of 20 nm, and then lithium quinolate (Liq) was vapor-deposited as an electron injection layer (7) in a thickness of 1 to 2 nm. Thereafter, an Al cathode (8) was vapor-deposited in a thickness of 150 nm by using another vacuum vapor-deposit device to manufacture an OLED.

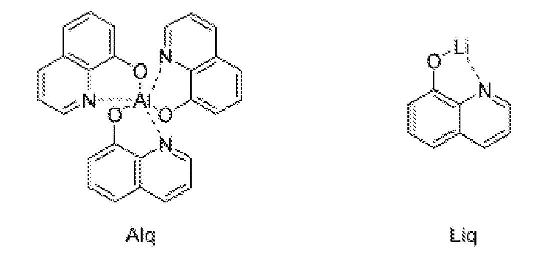

### Comparative Example 1

Comparative Example 1 - Manufacture of OLED device using conventional EL material.

An OLED device was manufactured according to the same procedure as Example 1 but Bis(2-methyl-8-quinolinato)(p-phenylphenolato)aluminum (III) (BAlq) was charged to another cell of the vacuum vapor-deposit device employed, as EL host material, instead of the EL compound according to the present invention.

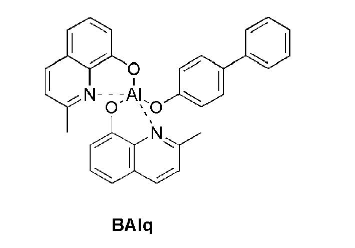

Experimental Example 1 - Evaluation of properties of OLED devices manufactured.

Operation voltage and power efficiency of the OLEDs of Examples 1 to 23 comprising the EL compounds according to the present invention and those of the OLEDs manufactured in Comparative Example 1 comprising a conventional EL compound were measured at 1,000 cd/m², and the results are shown in Table 5.

From Table 5 below, demonstrating electroluminescent properties of the EL compounds developed by the present invention, it is confirmed that the EL compounds developed by the present invention exhibit more excellent properties than conventional EL materials in terms of performances.

**Table 5**

| | Host material | EL material | Operation voltage (V) @1,000 cd/m² | Power efficiency(lm/W) @1,000 cd/m² | EL color |
|---|---|---|---|---|---|
| Ex. 1 | **1** | (piq)₂Ir(acac) | 5.6 | 4.4 | red |
| Ex. 2 | **3** | (piq)₂Ir(acac) | 5.2 | 4.7 | red |
| Ex. 3 | **41** | (piq)₂Ir(acac) | 5.1 | 4.8 | red |
| Ex. 4 | **47** | (piq)₂Ir(acac) | 5.1 | 4.4 | red |
| Ex. 5 | **87** | (piq)₂Ir(acac) | 5.4 | 4.0 | red |
| Ex. 6 | **109** | (piq)₂Ir(acac) | 4.9 | 4.4 | red |
| Ex. 7 | **110** | (piq)₂Ir(acac) | 5.2 | 4.3 | red |
| Ex. 8 | **115** | (piq)₂Ir(acac) | 6.1 | 4.3 | red |
| Ex. 9 | **144** | (piq)₂Ir(acac) | 6.2 | 4.7 | red |
| Ex. 10 | **160** | (piq)₂Ir(acac) | 6.2 | 4.2 | red |
| Ex. 11 | **162** | (piq)₂Ir(acac) | 5.2 | 3.9 | red |
| Ex. 12 | **165** | (piq)₂Ir(acac) | 5.1 | 4.5 | red |
| Ex. 13 | **224** | (piq)₂Ir(acac) | 5.3 | 4.2 | red |
| Ex. 14 | **252** | (piq)₂Ir(acac) | 5.3 | 4.3 | red |
| Ex. 15 | **254** | (piq)₂Ir(acac) | 5.7 | 4.0 | red |
| Ex. 16 | **269** | (piq)₂Ir(acac) | 5.3 | 4.2 | red |
| Ex. 17 | **315** | (piq)₂Ir(acac) | 5.8 | 4.3 | red |
| Ex. 18 | **318** | (piq)₂Ir(acac) | 5.4 | 4.1 | red |
| Ex. 19 | **335** | (piq)₂Ir(acac) | 7.0 | 3.4 | red |
| Ex. 20 | **336** | (piq)₂Ir(acac) | 6.8 | 3.8 | red |
| Ex. 21 | **377** | (piq)₂Ir(acac) | 6.6 | 3.5 | red |
| Ex. 22 | **379** | (piq)₂Ir(acac) | 6.3 | 3.5 | red |
| Ex. 23 | **408** | (piq)₂Ir(acac) | 5.1 | 4.7 | red |
| Comp. Ex. 1 | BAlq | (piq)₂Ir(acac) | 7.5 | 2.6 | red |

From Table 5, it is confirmed that the electroluminescent properties of the complexes developed by the present invention are better than those of conventional material.

In particular, incorporating one or more substituent(s) such as methyl, phenyl and naphthyl to ligand L¹ provided OLEDs having excellent current property and lowered operation voltage by at least 1 V as compared to that of Comparative Example 1 employing conventional EL material. Due to their excellent EL properties, the compounds according to the invention also provided the device with higher power efficiency by at least 1.6 times as compared to the device of Comparative Example 1. Not only in the case of X=O, but also in the case of X=S, the device according to the invention was operated at a lower voltage by at least 1 V as compared to the device using conventional material, and showed higher power efficiency by at least 1.3 lm/W.

Particularly, in Example 6, the device was operated at a lower voltage by 2.6 V as compared to the device according to Comparative Example 1; and in Example 3, the device exhibited 5.1 V of operation voltage and 4.8 lm/W of power efficiency at 1000 cd/m².

Thus, the devices employing the electroluminescent compounds according to the present invention as host material exhibit excellent electroluminescent properties, and reduced operation voltage, to induce increase of power efficiency by 0.8∼2.2 lm/W, thereby improving the power consumption.

### Description of symbols of significant parts of the drawings

1: Glass
2: Transparent electrode
3: Hole injection layer
4: Hole transport layer
5: Electroluminescent layer
6: Electron transport layer
7: Electron injection layer
8: Al cathode

## Claims

1. An electroluminescent compound represented by Chemical Formula (1):
Chemical Formula 1 L¹L¹M(Q)ₘ
wherein, ligand L¹ has the structure shown below: 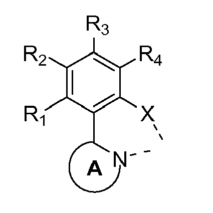
M represents a bivalent or trivalent metal;
m is 0 when M is a bivalent metal, while m is 1 when M is a trivalent metal;
Q represents (C6-C60)aryloxy or tri(C6-C30)arylsilyl, and the aryloxy or triarylsilyl of Q may be further substituted by a linear or branched (C1-C60)alkyl or (C6-C60)aryl;
when X represents O, ring A is selected from the following structures: 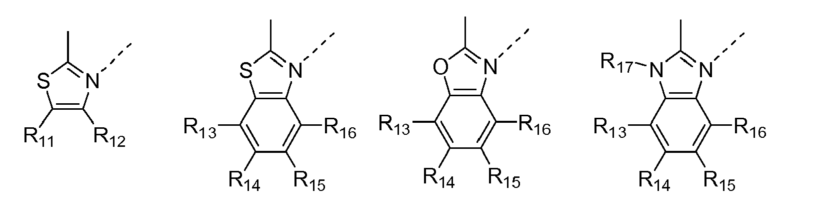
when X represents S, ring A is selected from the following structures: 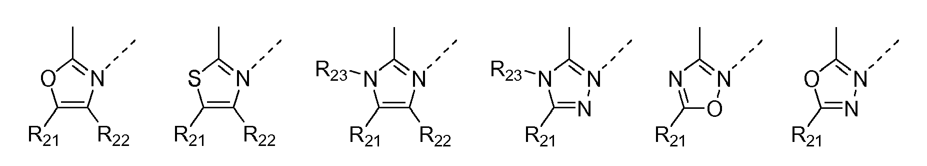 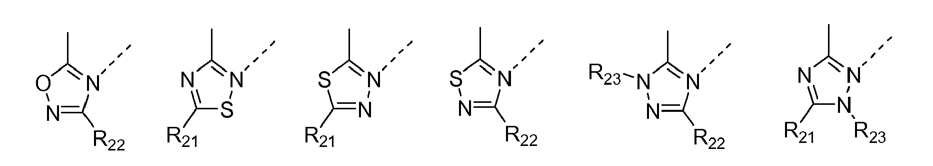 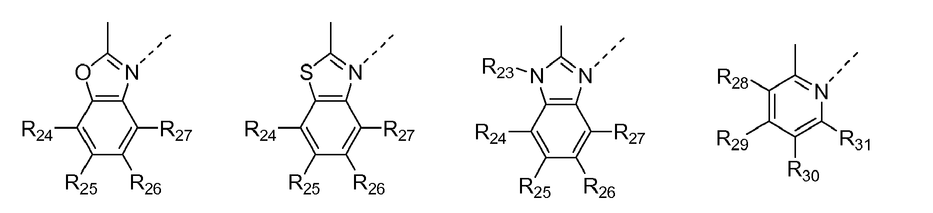 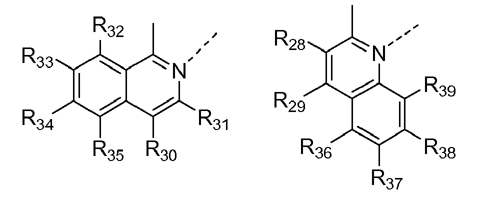
R₁ through R₄ independently represent hydrogen, (C1-C60)alkyl, halogen, cyano, (C3-C60)cycloalkyl, (C6-C60)aryl, (C4-C60)heteroaryl, mono or di(C1-C30)alkylamino, mono or di(C6-C30)arylamino, tri(C1-C30)alkylsilyl, di(C1-C30)alkyl(C6-C30)arylsilyl or tri(C6-C30)arylsilyl, or may be linked to an adjacent substituent via (C3-C12)alkylene or (C3-C12)alkenylene to form a fused ring;
R₁₁ through R₁₇ independently represent hydrogen, (C1-C60)alkyl, (C6-C60)aryl, (C4-C60)heteroaryl, tri(C1-C30)alkylsilyl, di(C1-C30)alkyl(C6-C30)arylsilyl, tri(C6-C30)arylsilyl, mono or di(C1-C30)alkylamino, mono or di(C6-C30)arylamino, cyano or halogen, or R₁₃ through R₁₆ may be linked to an adjacent substituent via (C3-C12)alkylene or (C3-C12)alkenylene to form a fused ring;
R₂₁ through R₃₉ independently represent hydrogen, (C1-C60)alkyl, (C6-C60)aryl, (C4-C60)heteroaryl, tri(C1-C30)alkylsilyl, di(C1-C30)alkyl(C6-C30)arylsilyl, tri(C6-C30)arylsilyl, mono or di(C1-C30)alkylamino, mono or di(C6-C30)arylamino, cyano or halogen;
the alkyl, aryl or heteroaryl of R₁ through R₄, or the fused ring formed therefrom by linkage to an adjacent substituent via (C3-C12)alkylene or (C3-C12)alkenylene may be further substituted by one or more substituent(s) selected from (C1-C60)alkyl, (C1-C60)alkyl substituted by halogen, (C6-C60)aryl, tri(C1-C30)alkylsilyl, di(C1-C30)alkyl(C6-C30)arylsilyl, tri(C6-C30)arylsilyl, mono or di(C1-C30)alkylamino, mono or di(C6-C30)arylamino, cyano and halogen;
the alkyl, aryl or heteroaryl of R₁₁ through R₁₇ and R₂₁ through R₃₉ may be further substituted by one or more substituent(s) selected from (C1-C60)alkyl, (C1-C60)alkyl substituted by halogen, halogen, (C6-C60)aryl, mono or di(C1-C30)alkylamino, mono or di(C6-C30)arylamino, tri(C1-C30)alkylsilyl, di(C1-C30)alkyl(C6-C30)arylsilyl, tri(C6-C30)arylsilyl and cyano.

2. An electroluminescent compound according to claim 1 wherein ligand L¹ is selected from the following structures: 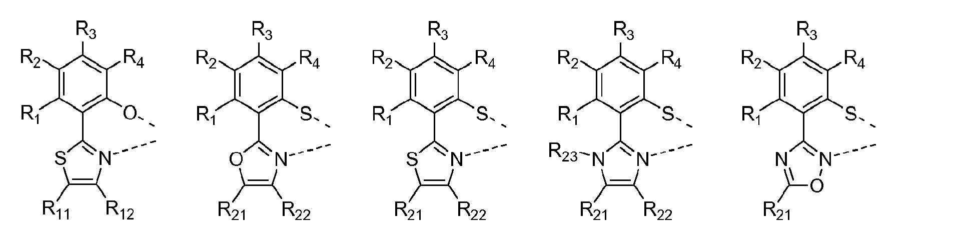 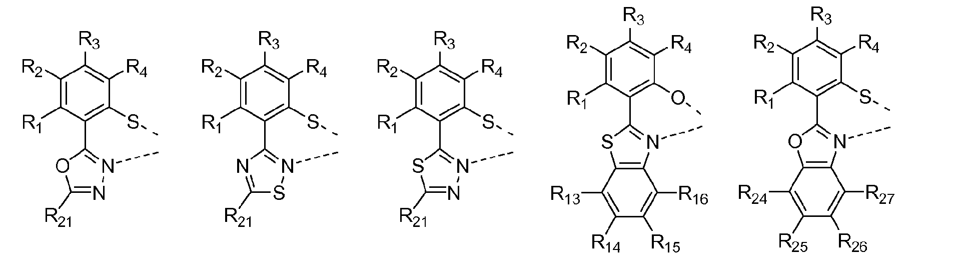 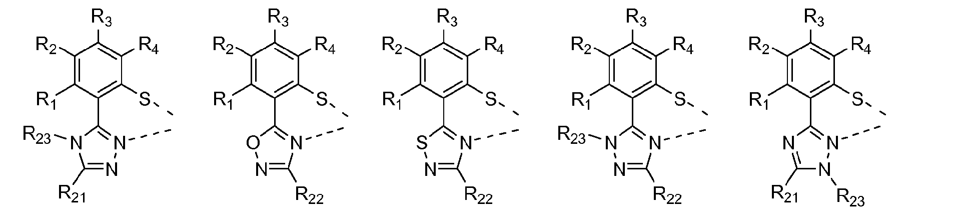 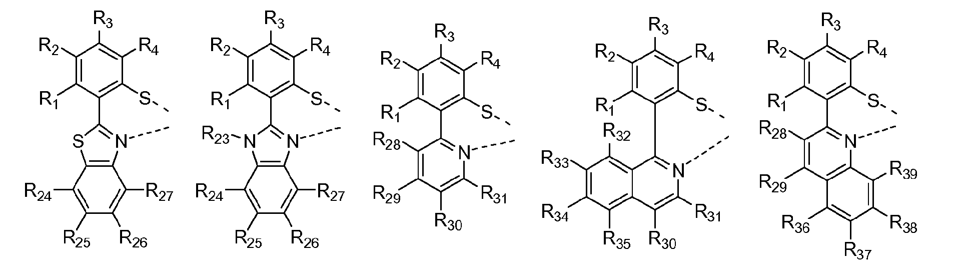 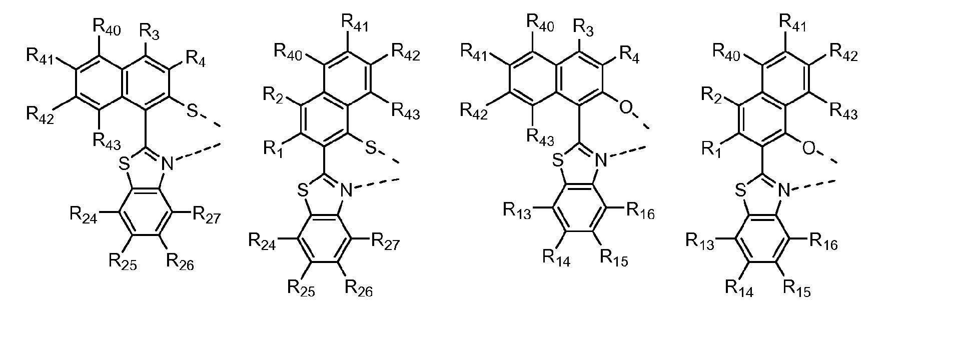 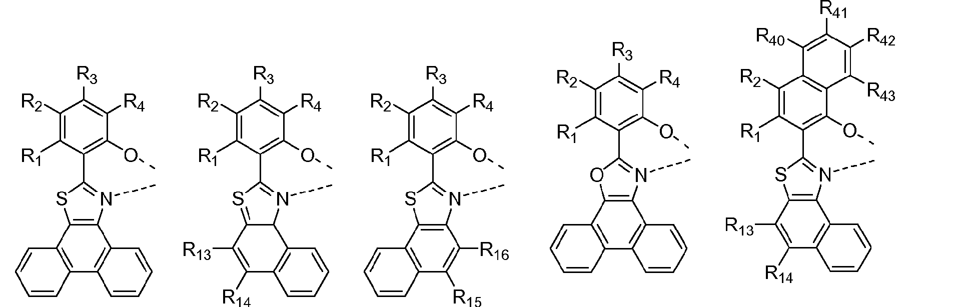 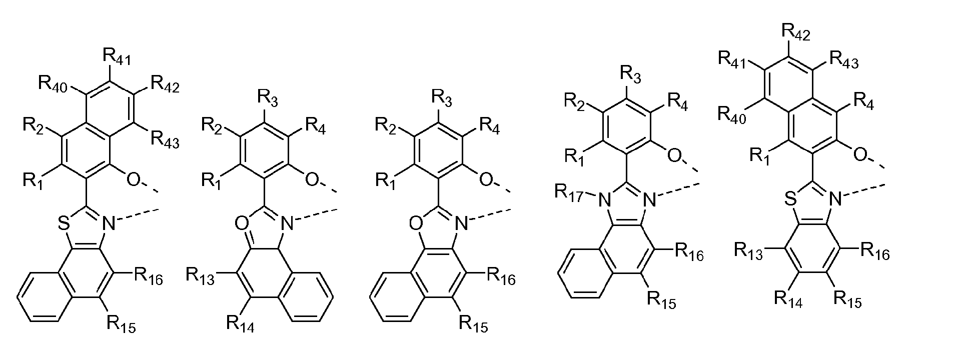 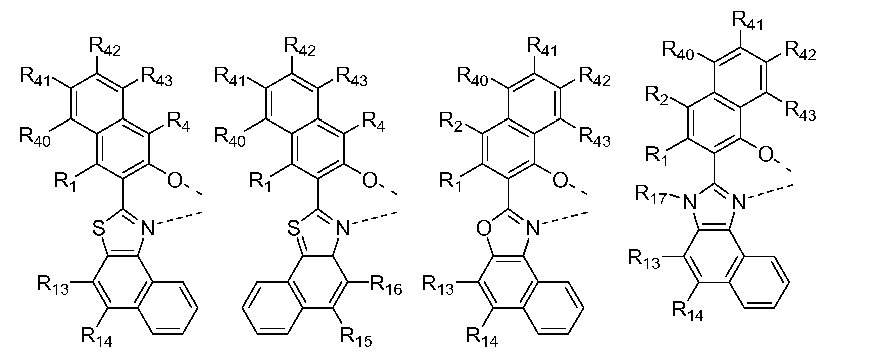
wherein R₁, R₂, R₃ and R₄ are defined as in Chemical Formula 1;
R₁₁ through R₁₆ independently represents hydrogen, (C1-C60)alkyl, halogen, (C1-C60)alkyl substituted by halogen, phenyl, naphthyl, biphenyl, fluorenyl, tri(C1-C30)alkylsilyl, di(C1-C30)alkyl(C6-C30)arylsilyl, tri(C6-C30)arylsilyl, di(C1-C30)alkylamino, di(C6-C30)arylamino, thiophenyl or furanyl;
R₁₇ represents (C1-C60)alkyl, phenyl or naphthyl;
R₂₁ and R₂₂ independently represent hydrogen, (C1-C60)alkyl, halogen, (C1-C60)alkyl substituted by halogen, phenyl, naphthyl, biphenyl, fluorenyl, tri(C1-C30)alkylsilyl, di(C1-C30)alkyl(C6-C30)arylsilyl, tri(C6-C30)arylsilyl, di(C1-C30)alkylamino, di(C6-C30)arylamino, thiophenyl or furanyl;
R₂₃ represents (C1-C60)alkyl, phenyl or naphthyl;
R₂₄ through R₃₉ independently represent hydrogen, (C1-C60)alkyl, halogen, (C1-C60)alkyl substituted by halogen, phenyl, naphthyl, biphenyl, fluorenyl, tri(C1-C30)alkylsilyl, di(C1-C30)alkyl(C6-C30)arylsilyl, tri(C6-C30)arylsilyl, di(C1-C30)alkylamino, di(C6-C30)arylamino, thiophenyl or furanyl;
R₄₀ through R₄₃ independently represent hydrogen, (C1-C60)alkyl, (C1-C60)alkyl substituted by halogen, phenyl, naphthyl, biphenyl, fluorenyl, tri(C1-C30)alkylsilyl, di(C1-C30)alkyl(C6-C30)arylsilyl, tri(C6-C30)arylsilyl, di(C1-C30)alkylamino, di(C6-C30)arylamino or halogen; and
the phenyl, naphthyl, biphenyl, fluorenyl, thiophenyl or furanyl of R₁₁ through R₁₇, R₂₁ through R₃₉ and R₄₀ through R₄₃ may be further substituted by one or more substituent(s) selected from (C1-C60)alkyl, halogen, phenyl, naphthyl, fluorenyl, tri(C1-C30)alkylsilyl, di(C1-C30)alkyl(C6-C30)arylsilyl, tri(C6-C30)arylsilyl, di(C1-C30)alkylamino or di(C6-C30)arylamino.

3. An electroluminescent compound according to claim 2, wherein ligand L¹ is selected from the following structures: 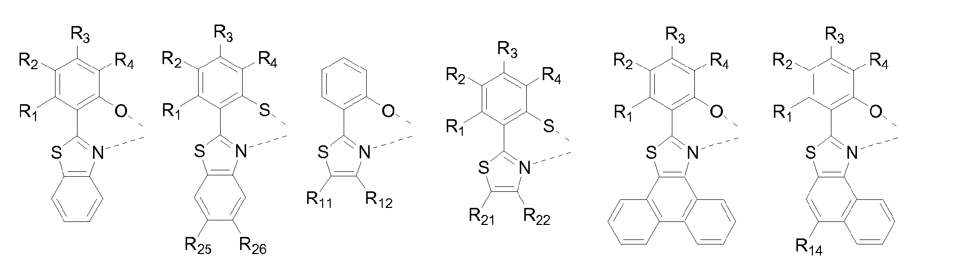 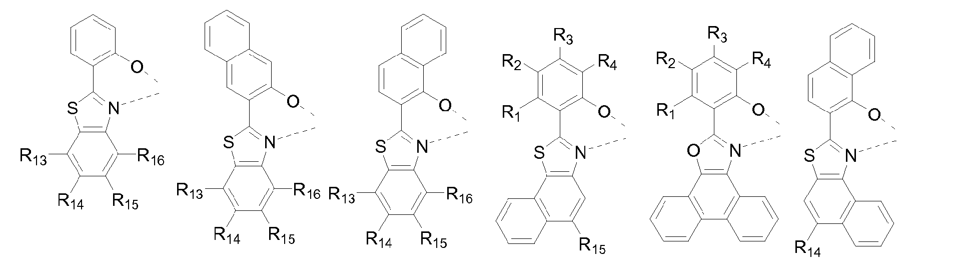 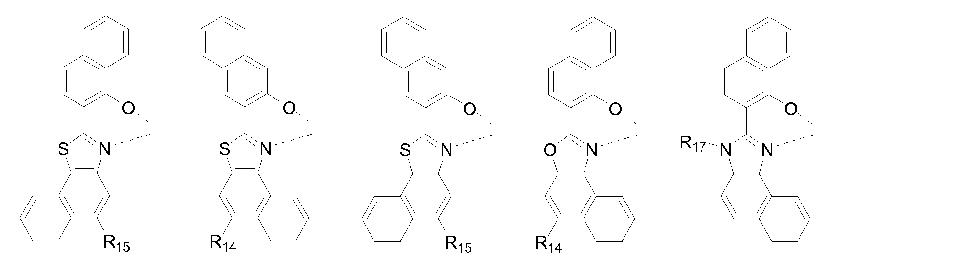
wherein, R₁ through R₄ independently represent hydrogen, methyl, ethyl, n-propyl, i-propyl, n-butyl, i-butyl, t-butyl, chloro, fluoro, phenyl, biphenyl, naphthyl, fluorenyl, thiophenyl, trimethylsilyl, triphenylsilyl, t-butyldimethylsilyl, dimethylamino, diethylamino or diphenylamino, excluding the case wherein R₁, R₂, R₃ and R₄ represent hydrogen all at the same time;
R₁₁ and R₁₂ independently represent methyl, ethyl, n-propyl, i-propyl, n-butyl, i-butyl, t-butyl, trimethylsilyl, triphenylsilyl, phenyl, biphenyl, naphthyl or fluorenyl;
R₁₃ through R₁₆ independently represent methyl, ethyl, n-propyl, i-propyl, n-butyl, i-butyl, t-butyl, trimethylsilyl, triphenylsilyl, phenyl, biphenyl, naphthyl or fluorenyl;
R₁₇ represents methyl, ethyl, n-propyl, i-propyl, n-butyl, i-butyl, t-butyl, phenyl or naphthyl;
R₂₁ and R₂₂ independently represent hydrogen, methyl, ethyl, n-propyl, i-propyl, n-butyl, i-butyl, t-butyl, fluoro, trifluoromethyl, phenyl, naphthyl, biphenyl, trimethylsilyl, triphenylsilyl, dimethylamino, diphenylamino, thiophenyl or furanyl;
R₂₅ and R₂₆ independently represent hydrogen, methyl, ethyl, n-propyl, i-propyl, n-butyl, i-butyl, t-butyl, fluoro, trifluoromethyl, phenyl, naphthyl, biphenyl, trimethylsilyl, triphenylsilyl, dimethylamino, diphenylamino, thiophenyl or furanyl; and
the phenyl, biphenyl, naphthyl, fluorenyl and thiophenyl of R₁, R₂, R₃, R₄, R₁₁, R₁₂, R₁₃, R₁₄, R₁₅, R₁₆, R₁₇, R₂₁, R₂₂, R₂₅ and R₂₆ may be further substituted by one or more substituent(s) selected from fluoro, methyl, ethyl, n-propyl, i-propyl, n-butyl, i-butyl, t-butyl, trimethylsilyl, triphenylsilyl, t-butyldimethylsilyl, phenyl, naphthyl, fluorenyl, dimethylamino, diethylamino and diphenylamino.

4. An electroluminescent compound according to claim 1, wherein M is a bivalent metal selected from a group consisting of Be, Zn, Mg, Cu and Ni, or a trivalent metal selected from a group consisting of Al, Ga, In and B.

5. An electroluminescent compound according to claim 1, wherein Q is selected from the following structures.

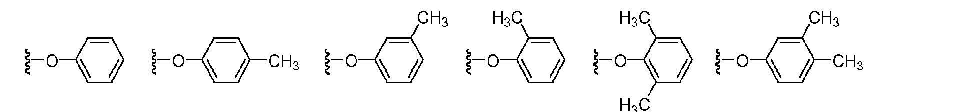

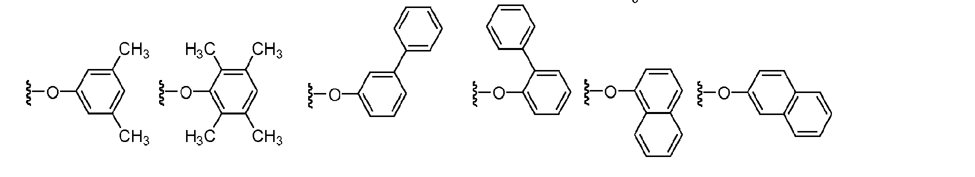

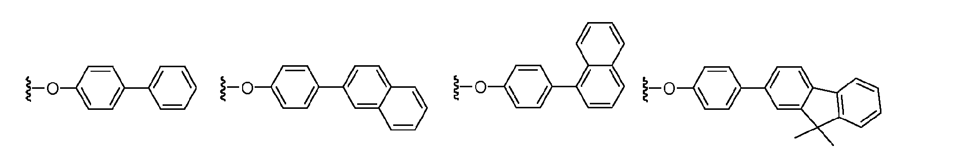

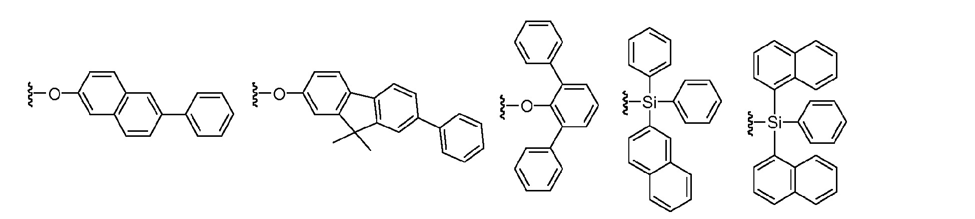

6. An electroluminescent compound according to claim 1, which is selected from the following compounds.

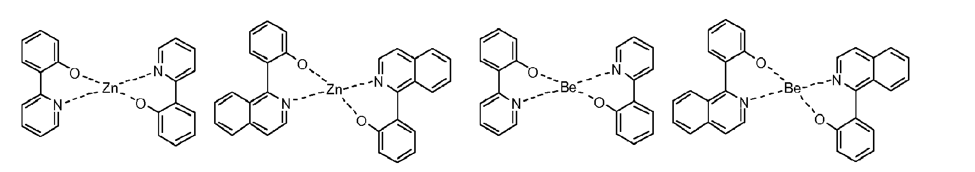

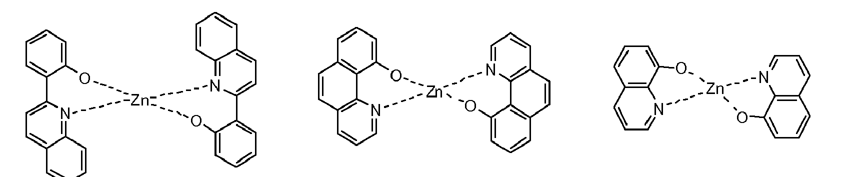

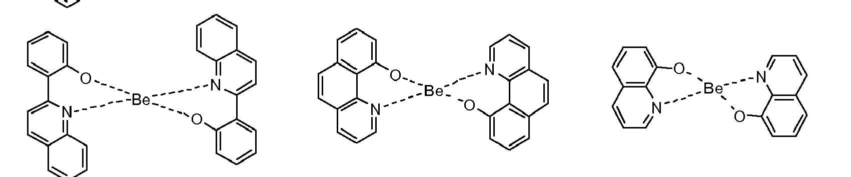

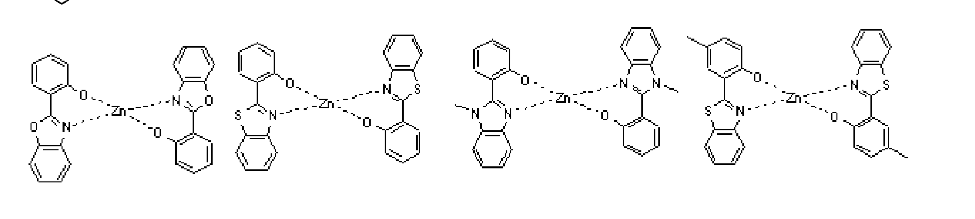

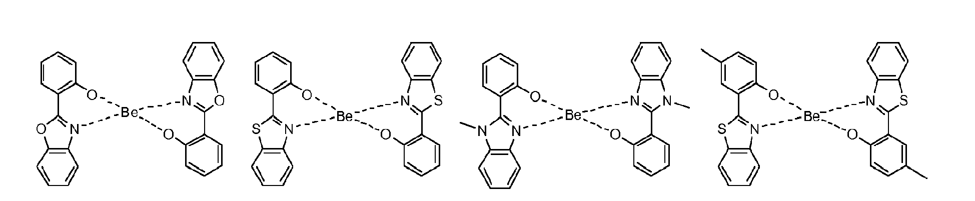

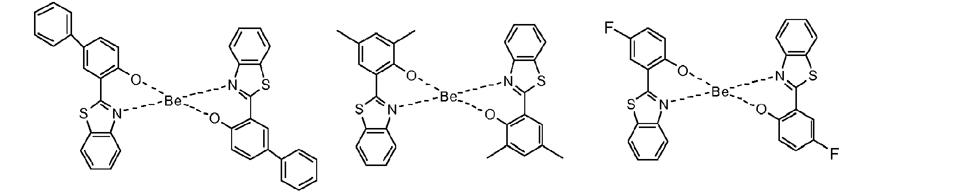

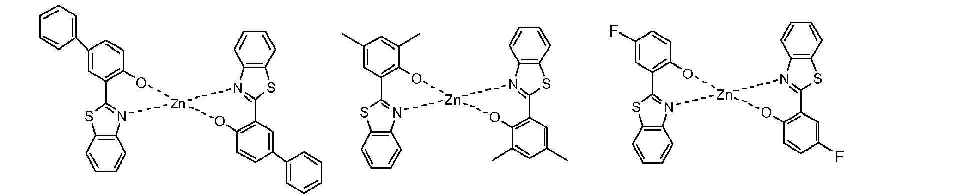

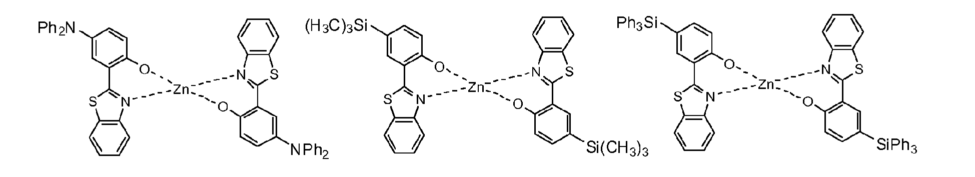

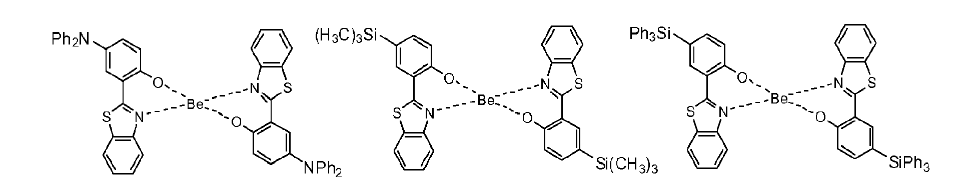

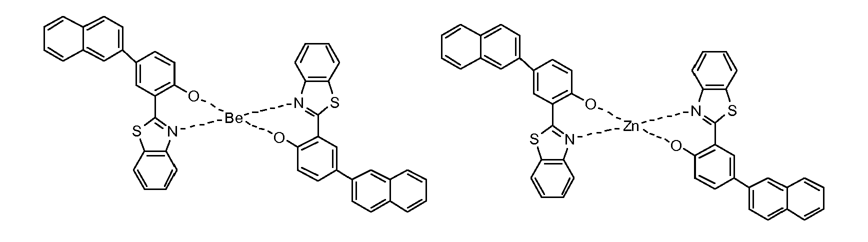

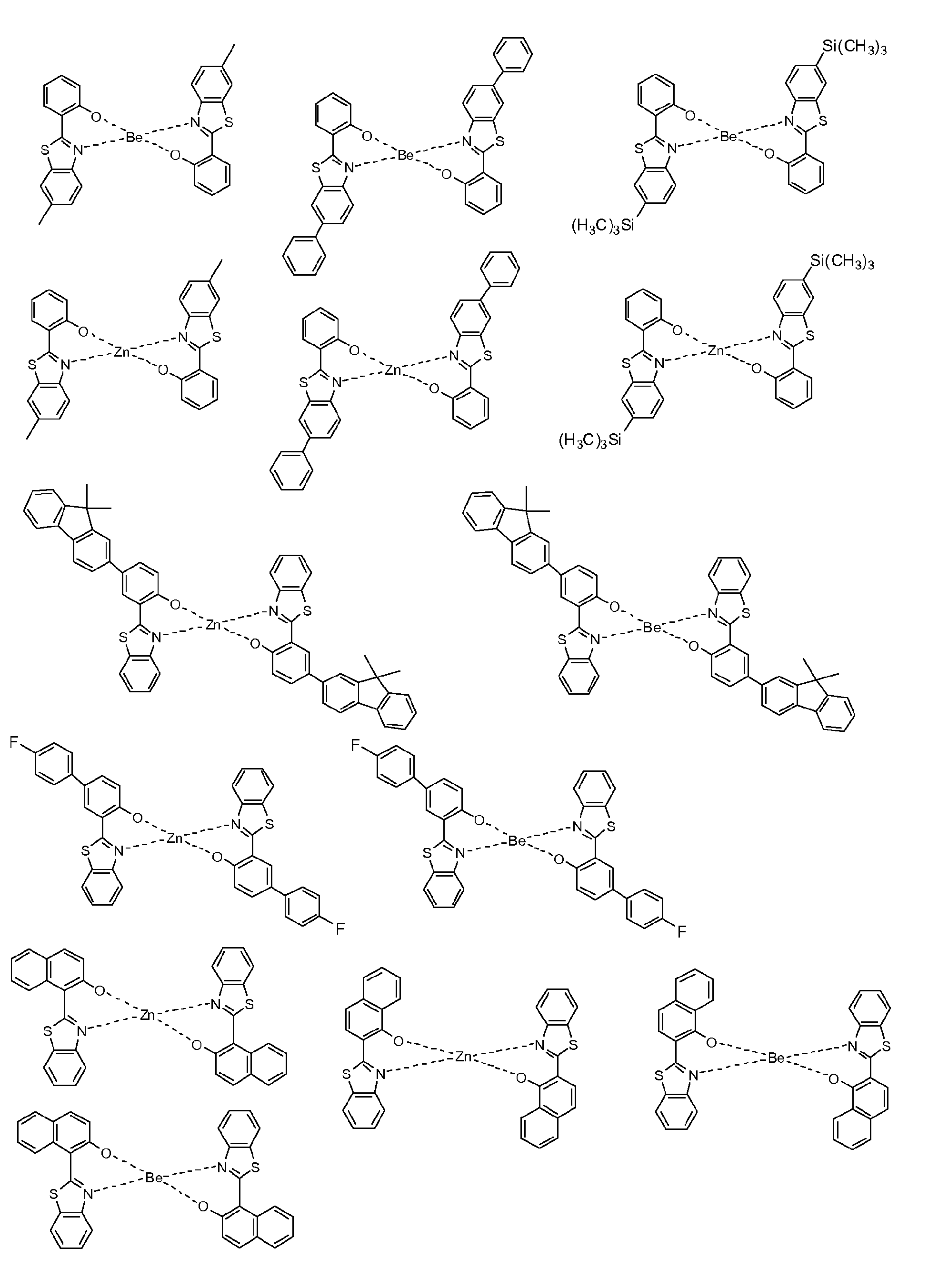

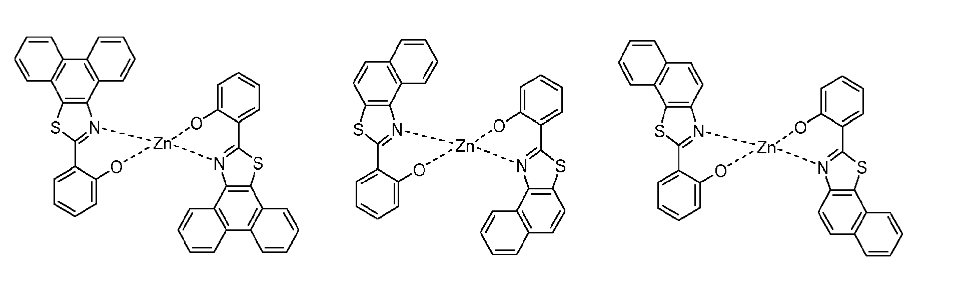

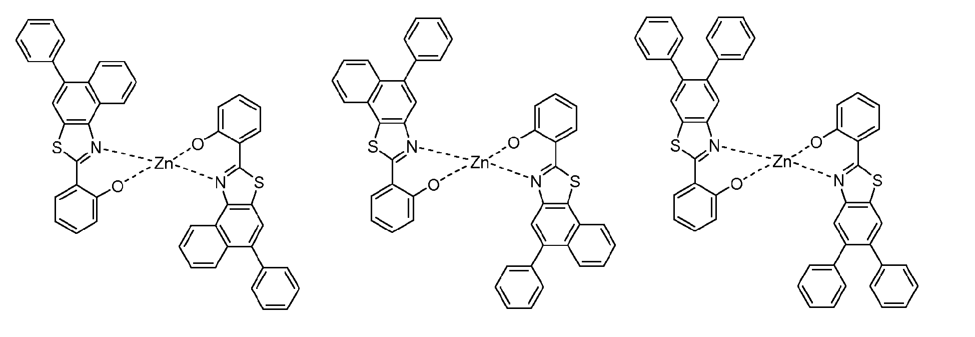

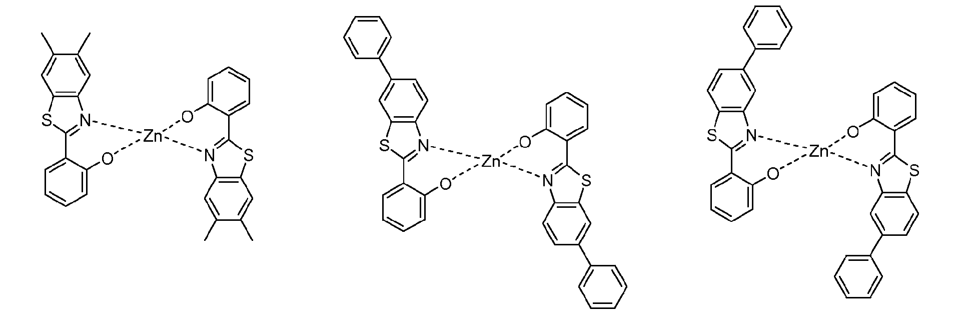

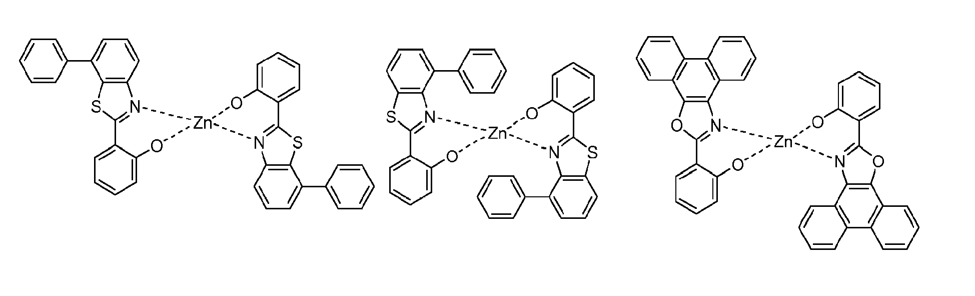

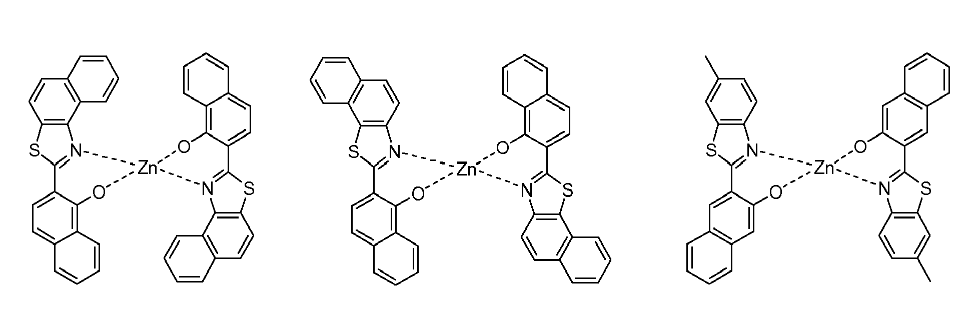

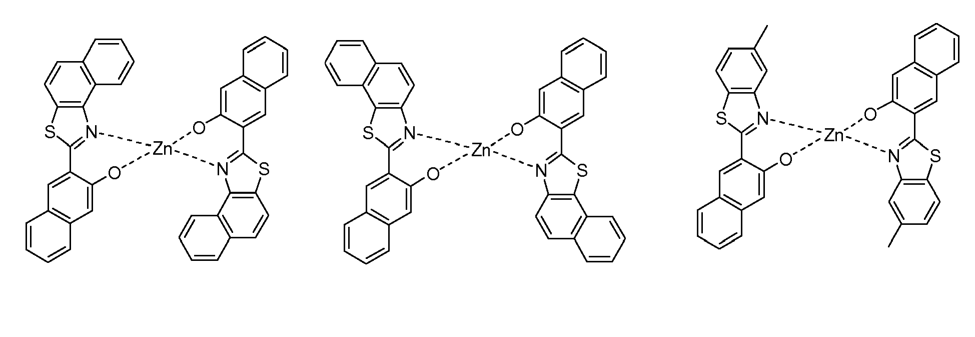

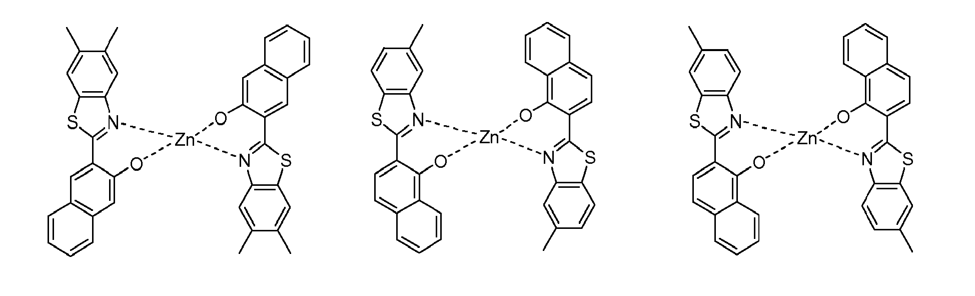

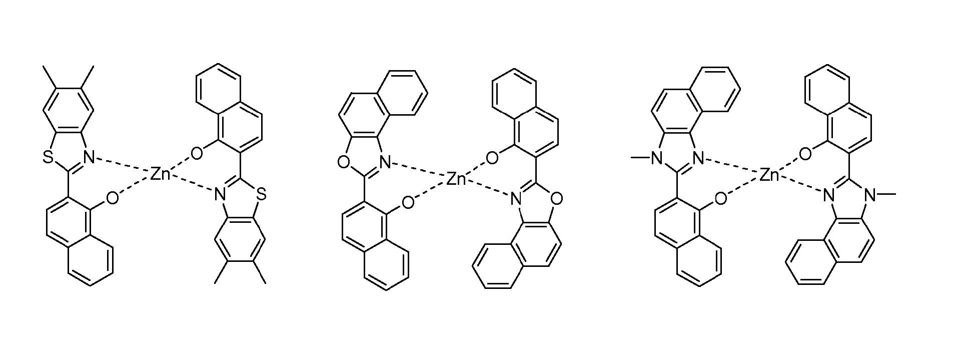

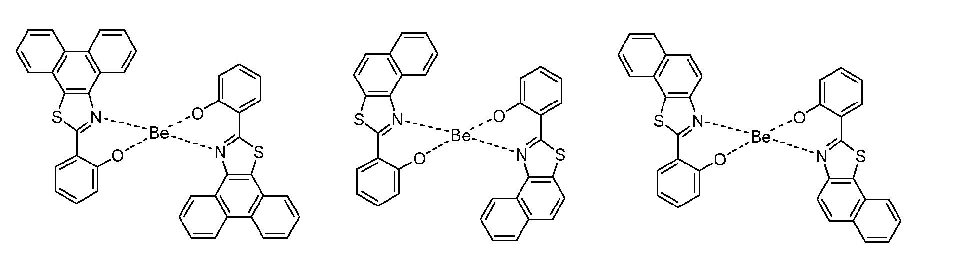

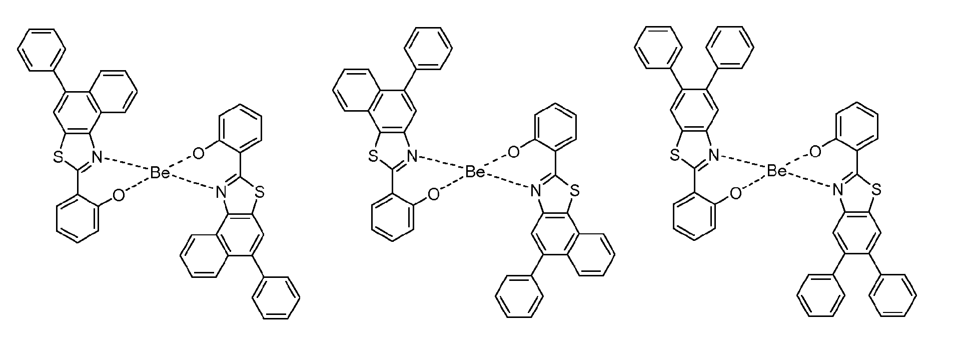

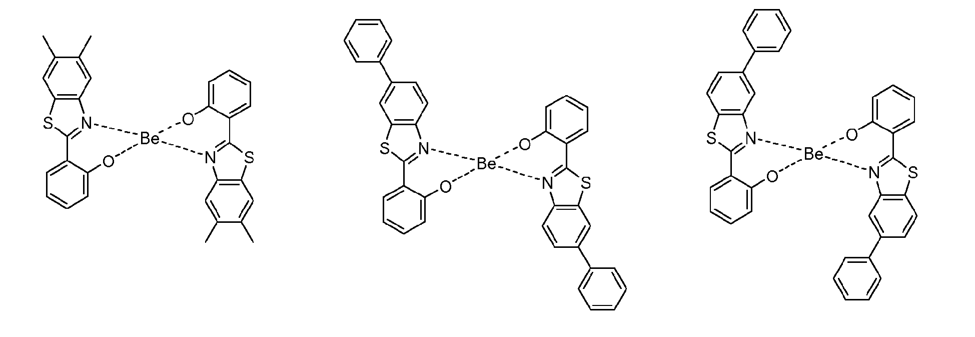

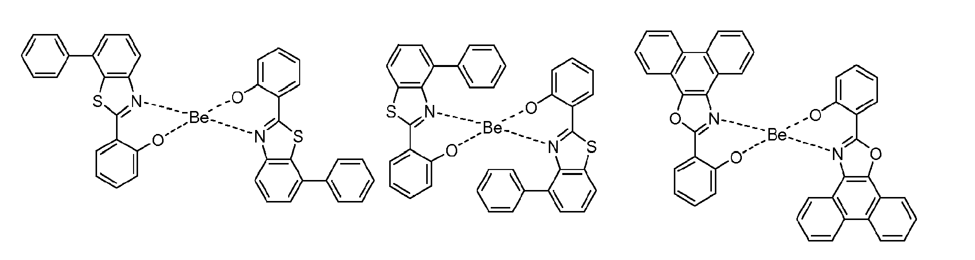

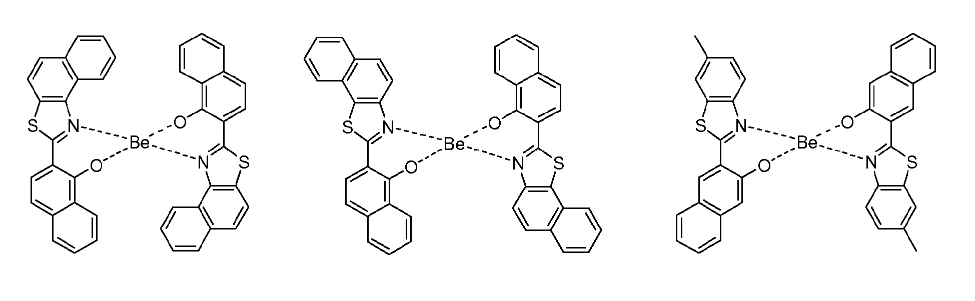

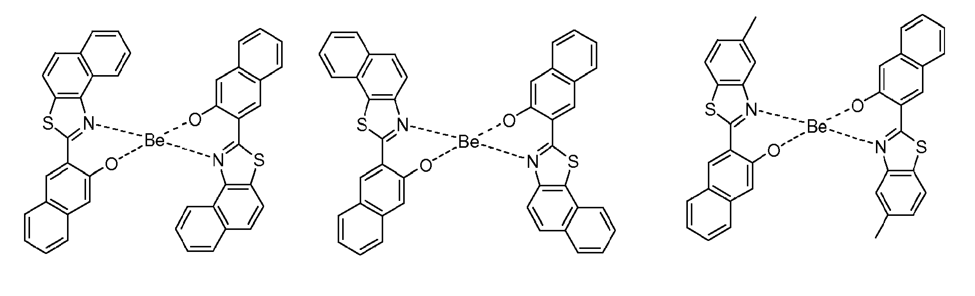

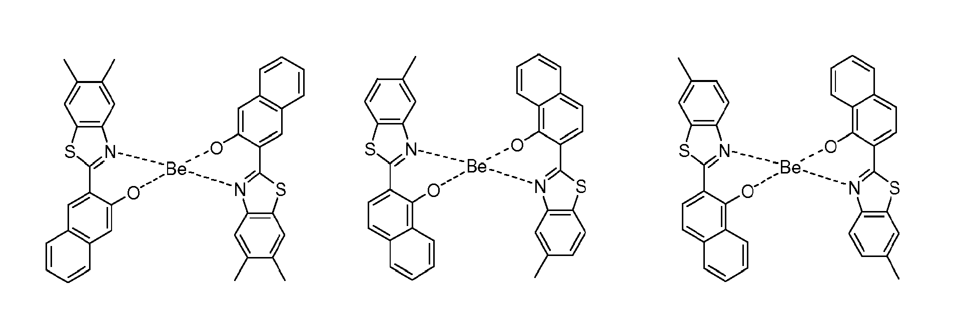

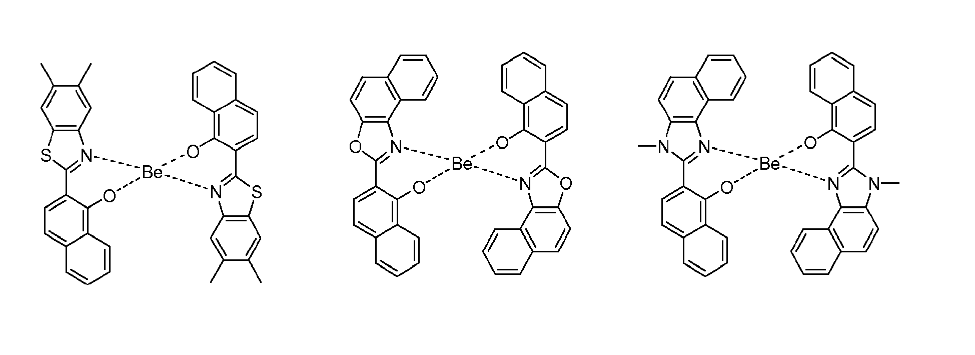

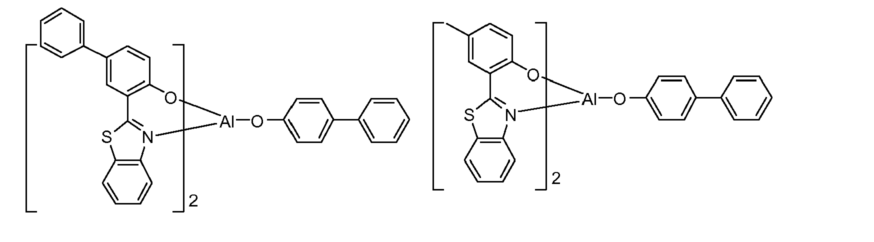

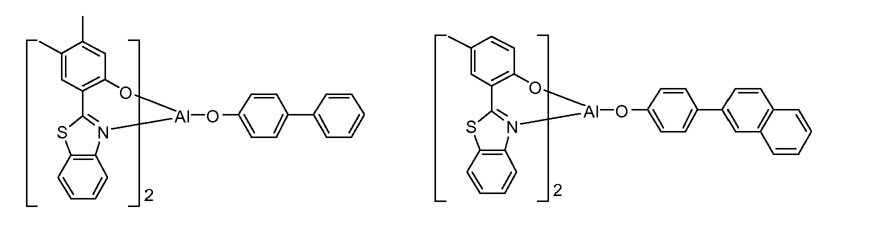

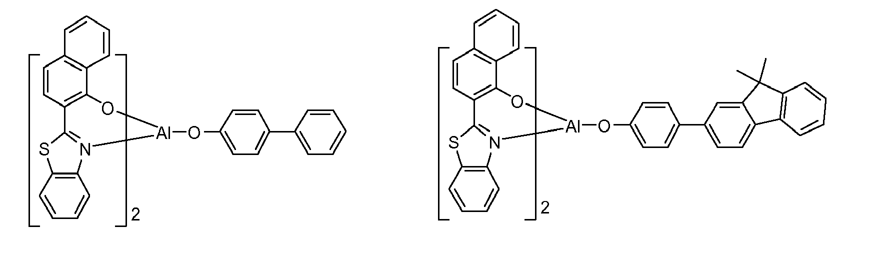

7. An electroluminescent device which comprises an electroluminescent compound according to any one of claims 1 to 6.

8. An electroluminescent device according to claim 7, wherein the electroluminescent compound is employed as a host material for an electroluminescent layer.

9. An electroluminescent device, which is comprised of
a first electrode;
a second electrode; and
at least one organic layer(s) interposed between the first electrode and the second electrode;
wherein the organic layer comprises one or more electroluminescent compound(s) according any one of claims 1 to 6.

10. An electroluminescent device according to claim 9, wherein the organic layer comprises an electroluminescent region, and the electroluminescent region comprises one or more electroluminescent compound(s) according to claims 1 to 6 and one or more electroluminescent dopant(s).

11. An electroluminescent device according to claim 10, wherein the electroluminescent dopant is a compound represented by Chemical Formula (2):
Chemical Formula 2 M¹L²L³L⁴
wherein, M¹ is selected from a group consisting of metals of Group 7, 8, 9, 10, 11, 13, 14, 15 and 16 of the Periodic Table, and ligands L², L³ and L⁴ are independently selected from the following structures: 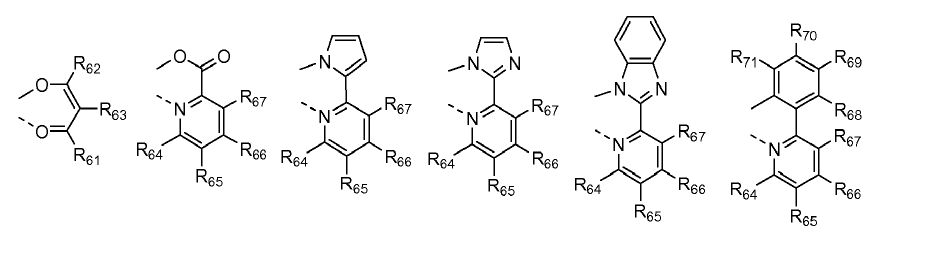 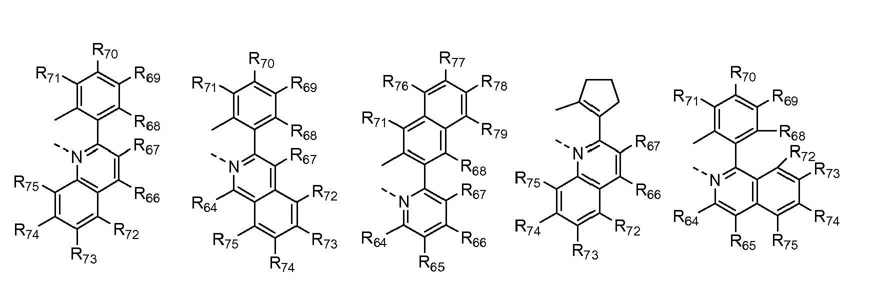 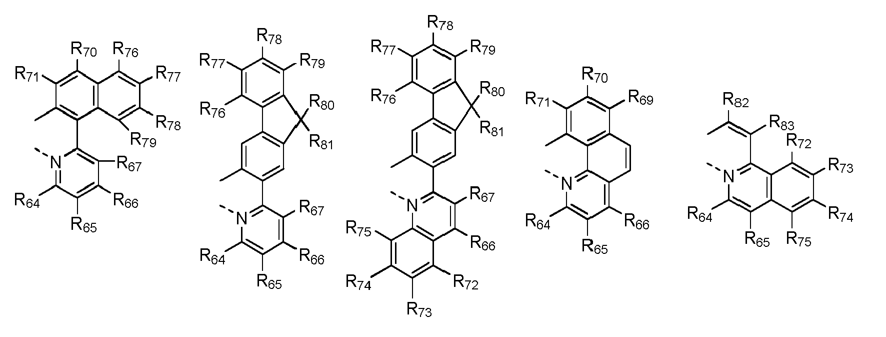 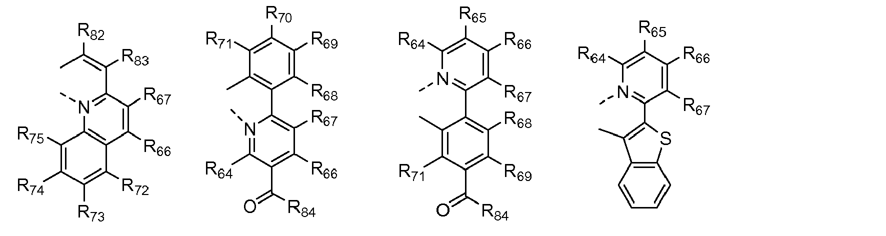
wherein, R₆₁ and R₆₂ independently represent hydrogen, (C1-C60)alkyl, phenyl or halogen;
R₆₃ through R₇₉ independently represent hydrogen, (C1-C60)alkyl, phenyl, tri(C1-C30)alkylsilyl or halogen;
R₈₀ through R₈₃ independently represent hydrogen, (C1-C60)alkyl or phenyl;
R₈₄ represents (C1-C60)alkyl, phenyl or halogen; and
the alkyl or phenyl of R₆₁ through R₈₄ may be further substituted by (C1-C60)alkyl or halogen.

12. An electroluminescent device according to claim 11, wherein the electroluminescent dopant is selected from the following compounds.

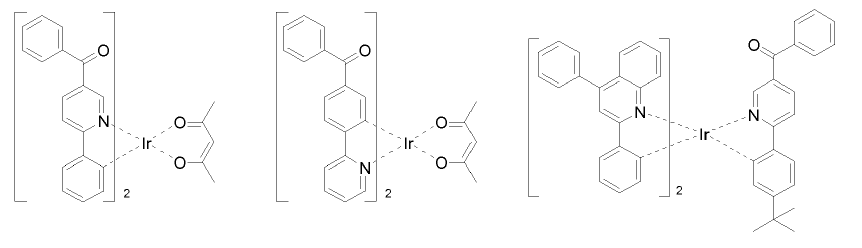

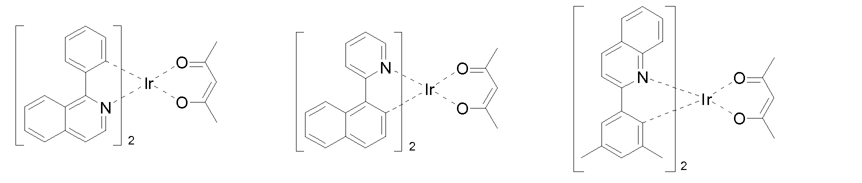

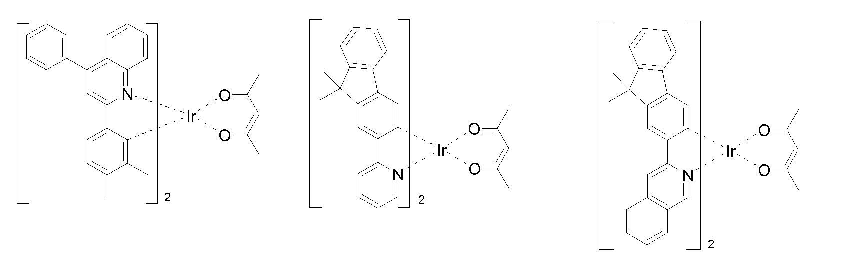

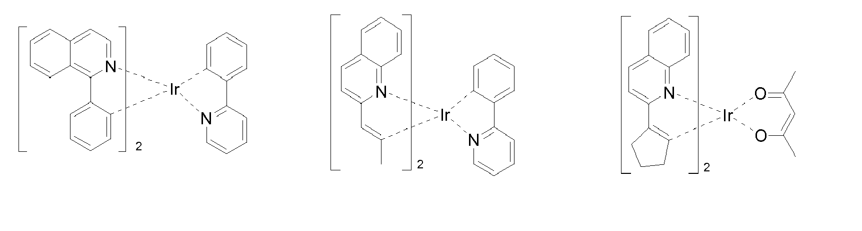

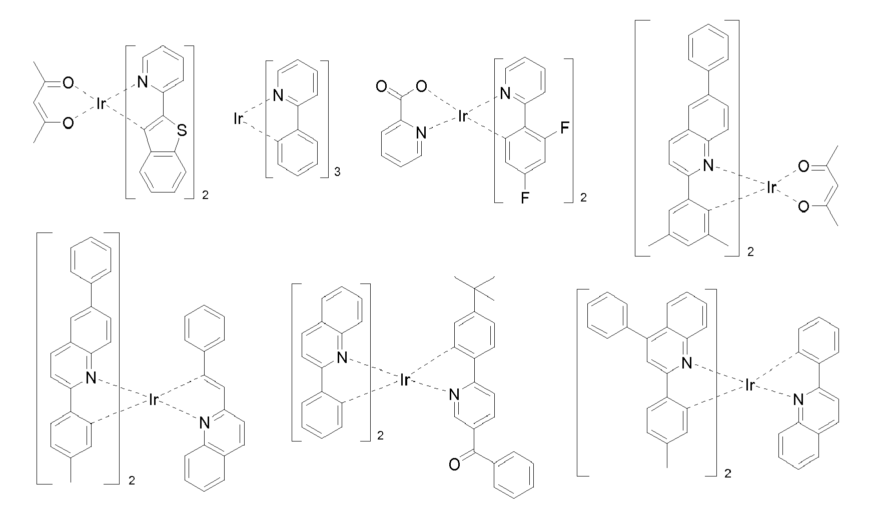

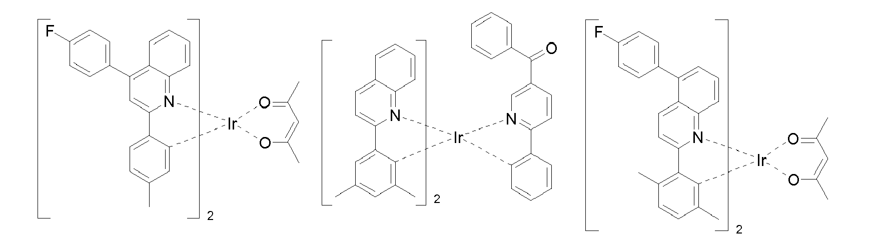

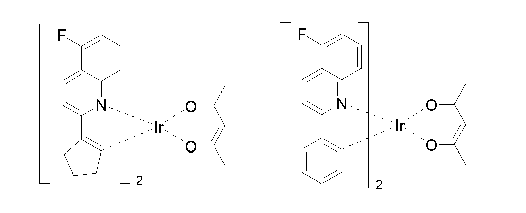

13. An electroluminescent device according to claim 9, wherein the organic layer comprises one or more compound(s) selected from a group consisting of arylamine compounds and styrylarylamine compounds.

14. An electroluminescent device according to claim 9, wherein the organic layer comprises one or more metal(s) selected from a group consisting of organic metals of Group 1, Group 2, 4^{th} period and 5^{th} period transition metals, lanthanide metals and d-transition elements.

15. An electroluminescent device according to claim 9, which has a pixel structure of independent light-emitting mode wherein an electroluminescent device comprising the electroluminescent layer as a sub-pixel and one or more sub-pixel(s) comprising one or more metal compound(s) selected from a group consisting of arylamine compounds and styrylarylamine compounds are patterned in parallel at the same time.

16. An electroluminescent device according to claim 9, which comprises in the electroluminescent layer an organic compound or an organometallic compound having an electroluminescent peak at a wavelength of not more than 560 nm at the same time.

17. An electroluminescent device according to claim 9, wherein the organic layer also comprises a charge generating layer in addition to the electroluminescent layer.

18. An electroluminescent device according to claim 9, wherein one or more layer(s) selected from chalcogenide layer, halogenated metal layer and metal oxide layer is (are) placed on the inner surface of one or both electrode(s) among the pair of electrodes.

19. An electroluminescent device according to claim 9, wherein a mixed region of reductive dopant and organic substance, or a mixed region of oxidative dopant and organic substance is placed on the inner surface of one or both electrode(s) among the pair of electrodes.

20. An organic solar cell which comprises an organic electroluminescent compound according to any one of claims 1 to 6.
